(19) Europäisches Patentamt
European Patent Office
Office européen des brevets

(11) EP 4 650 874 A1

(12) **EUROPEAN PATENT APPLICATION**

(43) Date of publication:
**19.11.2025 Bulletin 2025/47**

(21) Application number: **25174637.6**

(22) Date of filing: **06.05.2025**

(51) International Patent Classification (IPC):
*G03F 7/037* (2006.01) *G03F 7/038* (2006.01)

(52) Cooperative Patent Classification (CPC):
**G03F 7/0388; G03F 7/027; G03F 7/037**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **15.05.2024 JP 2024079226**

(71) Applicant: **SHIN-ETSU CHEMICAL CO., LTD.**
**Tokyo 1000005 (JP)**

(72) Inventors:
- **TAKEMURA, Katsuya**
  **Niigata (JP)**
- **IIO, Masashi**
  **Niigata (JP)**
- **URANO, Hiroyuki**
  **Niigata (JP)**
- **WATANABE, Osamu**
  **Niigata (JP)**

(74) Representative: **Röthinger, Rainer**
**Wuesthoff & Wuesthoff**
**Patentanwälte und Rechtsanwalt PartG mbB**
**Schweigerstrasse 2**
**81541 München (DE)**

(54) **NEGATIVE-TYPE PHOTOSENSITIVE RESIN COMPOSITION, PATTERNING PROCESS, METHOD FOR FORMING CURED COATING, INTERLAYER INSULATING FILM, SURFACE PROTECTING FILM, AND ELECTRONIC COMPONENT**

(57) A negative-type photosensitive resin composition, including: (A) a polymer compound including a polyimide precursor structure; (C) a photopolymerization initiator; (D) an organic compound represented by the following general formula (1); and (E) a solvent. This can provide: a photosensitive resin composition that allows an imide ring-closing reaction at low temperature, that has excellent stability of the composition, that uses a polyimide precursor that enables fine patterning, and that can impart resistance against chemicals after curing. In addition, an object of the present invention is to provide: a patterning process using the above photosensitive resin composition; an interlayer insulating film including a cured coating formed by curing the photosensitive resin composition; and a semiconductor device.

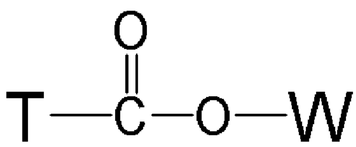

(1)

EP 4 650 874 A1

## Description

TECHNICAL FIELD

The present invention relates to a negative-type photosensitive resin composition, a patterning process that uses this negative-type photosensitive resin composition and that enables development with an organic solvent, a method for forming a cured coating, an interlayer insulating film, a surface protecting film, and an electronic component.

BACKGROUND ART

With reducing a size and increasing performance of various electronic devices such as personal computers, digital cameras, and cellular phones, semiconductor devices have been drastically required to have further reducing a size, reducing a thickness, and increasing a density. Thus, there has been a demand for development of a photosensitive insulating material that can cope with an increase in a substrate area in productivity improvement, and that is fine and has a high aspect ratio on the substrate in a high-density mounting technology such as chip-size package, chip-scale package (CSP), or a three-dimensional stacking.

In the high-density mounting technology such as three-dimensional stacking, as for the photosensitive insulating material that can form a pattern on a substrate, a polyimide film has been conventionally utilized as a protective coating or an interlayer insulating film. Its insulation, mechanical strength, adhesiveness to the substrate, etc. have continuously attracted attention, and the development is still progressing today.

Since a polyimide, etc. to form the polyimide film has low solubility in a solvent, the polyimide is used as a precursor state before an imide ring-closing reaction. The polyimide is applied or laminated onto the substrate, and then heated for cyclizing the polyimide precursor and forming a cured film to be used as the protective coating, the interlayer insulating film, etc.

Conventionally proposed is a material in which a photosensitive group is introduced into a material being the precursor of the patternable polyimide, for example, a carboxyl group of a polyamic acid, with an ester bond (Patent Document 1 and Patent Document 2). In these proposals, however, an imidization treatment at a high temperature of higher than 300°C is essential after formation of the patterned coating in order to obtain a target polyimide coating. To resist this high temperature, there are problems of limitation of the base substrate, oxidation of copper in wiring, a risk of thermal damage, etc. of an electronic component, etc.

Patent Document 3 discloses a polyimide precursor composition containing: a polyimide precursor; a thermal base generator to generate a base with heat; and a solvent, wherein the polyimide precursor is a polyamic acid, and the thermal base generator is a natural compound that causes pyrolysis by heating at a temperature of 200°C or lower to generate a secondary amine. Patent Document 3 describes that the treatment can be performed at 200°C or lower because the secondary amine generated by pyrolysis enhances the imide ring-closing reaction.

However, a cured film using the composition described in Patent Document 3 may cause poor corrosion resistance and chemical resistance, which are required properties for the protective coating, the interlayer insulating film, etc. In addition, the composition is associated with a problem of storage stability of proceeding of the cyclization reaction of the polyimide precursor resin during storage of the composition to gel, etc.

Meanwhile, Patent Document 4 and Patent Document 5 disclose a composition in which imidazoles are added as an imidization catalyst to enhance the imide ring-closing reaction with the polyimide precursor. However, the photosensitive resin composition that forms a pattern on a substrate, which is required in the high-density mounting technology, is not disclosed, and imidization at low temperature is also not disclosed. Further, the imidazoles of the imidization catalyst described in Patent Document 4 and Patent Document 5, except for N-tert-butoxycarbonylimidazole (N-Boc-imidazole), have a problem of storage stability of gelation during storage of the composition.

Furthermore, an addition amount of the imidazoles of the imidization catalyst described in Patent Document 4 and Patent Document 5 is unsuitable for use for the protective coating, the interlayer insulating film, etc. because pattern deformation due to heat (thermal flow) in a curing reaction after patterning occurs to fail to desire a fine pattern having a high aspect ratio and because the obtained cured film has a lowered glass transition temperature (Tg.).

Meanwhile, Patent Document 6 describes use of an activated esterifying agent as a compound that can facilitate the imidization at lower temperature, which differs from the thermal base generator to generate a base with heat. However, bis(pentafluorophenyl) carbonate, bis(4-nitrophenyl) carbonate, di(N-succinimidyl) carbonate, and 4-nitrophenyl trifluoroacetate, which are carbonate compounds and ester compounds of the activated esterifying agent described in Patent Document 6, have a relatively high decomposition temperature, and it is desired that the imide ring-closing reaction in the heating step to yield the cured coating be further effectively enhanced.

Pentafluorophenol and 1-hydroxy-7-azabenzotriazole, which are the activated esterifying agents described in Patent Document 6, have a hydroxy group, and is consequently associated with the problem of deterioration of storage stability of the photosensitive resin composition containing the polyimide precursor resin.

Further meanwhile, described in Patent Document 7 is adding an imide compound as a compound that can enhance the imidization reaction. The imide compound descried in Patent Document 7, however, has a hydroxy group and an amino group, and consequently it cannot be denied that the imide compound is associated with the problem of deterioration of storage stability of the photosensitive resin composition containing the polyimide precursor resin.

As above, desired in future for the photosensitive resin composition using the polyimide precursor is accelerated development of a photosensitive resin composition having completely all the features of: ability to fine patterning; ability to yield the cured film by heating at low temperature; the cured protective coating and interlayer insulating film having heat resistance in various steps and resistance against variously used chemicals; and good storage stability of the composition.

## CITATION LIST

### PATENT LITERATURE

Patent Document 1: JP S49-115541 A
Patent Document 2: JP S55-45746 A
Patent Document 3: JP 2007-056196 A
Patent Document 4: JP 7436606 B
Patent Document 5: JP 2022-159241 A
Patent Document 6: JP 2024-19341 A
Patent Document 7: JP 7252020 B

## SUMMARY OF INVENTION

### TECHNICAL PROBLEM

The present invention has been made in view of the above circumstances. An object of the present invention is to provide a photosensitive resin composition that allows the imide ring-closing reaction at low temperature, that has excellent stability of the composition, that uses a polyimide precursor that enables fine patterning, and that can impart resistance against chemicals after curing. In addition, an object of the present invention is to provide: a patterning process using the above photosensitive resin composition; an interlayer insulating film and a surface protecting film including a cured coating formed by curing the photosensitive resin composition; and an electronic component.

### SOLUTION TO PROBLEM

Specifically, to solve the above problem, the present invention provides a negative-type photosensitive resin composition including:

(A) a polymer compound including a polyimide precursor structure;
(C) a photopolymerization initiator;
(D) an organic compound represented by the following general formula (1); and
(E) a solvent,

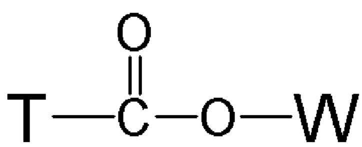

(1)

wherein T represents any one structure of the following general formulae (2) to (4), and W represents an alkyl group or an aryl group that are optionally substituted with an alkoxy group having 4 to 15 carbon atoms,

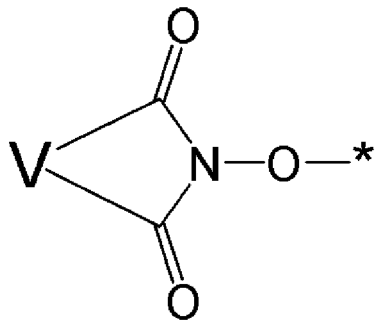

(2)

wherein V represents a divalent organic group, and "*" represents a bond,

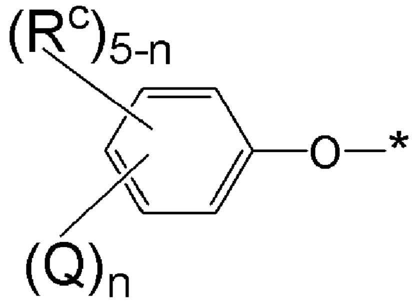

(3)

wherein Q represents a halogen atom or a nitro group, $R^C$ represents a hydrogen atom, a linear, branched, or cyclic alkyl group having 1 to 15 carbon atoms, or an aryl group having 6 to 15 carbon atoms, "n" represents an integer of 3 to 5 when Q represents the halogen atom or represents 1 when Q represents the nitro group, and "*" represents a bond,

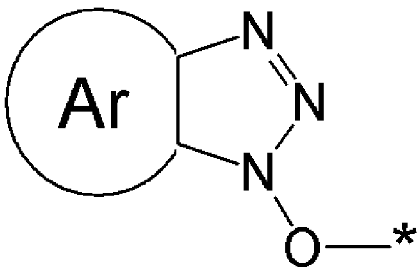

(4)

wherein Ar represents a substituted or unsubstituted aromatic cyclic structure or a heterocyclic structure having a heteroatom, and "*" represents a bond.

Adding the organic compound represented by the general formula (1) into the negative-type photosensitive resin composition having the polyimide precursor structure enables a temperature of a curing reaction to yield the cured film, namely the imide ring-closing reaction, to be 200°C or lower.

The organic compound represented by the general formula (1) has a protective group of the -(C=O)-O-W group, and can consequently inhibit aggregation between the polymer compound having the polyimide precursor structure and the organic compound, namely gelation, to inhibit deterioration of storage stability of the photosensitive resin composition.

In this case, the component (A) is preferably a polymer compound including a polyimide precursor structure represented by the following general formula (5),

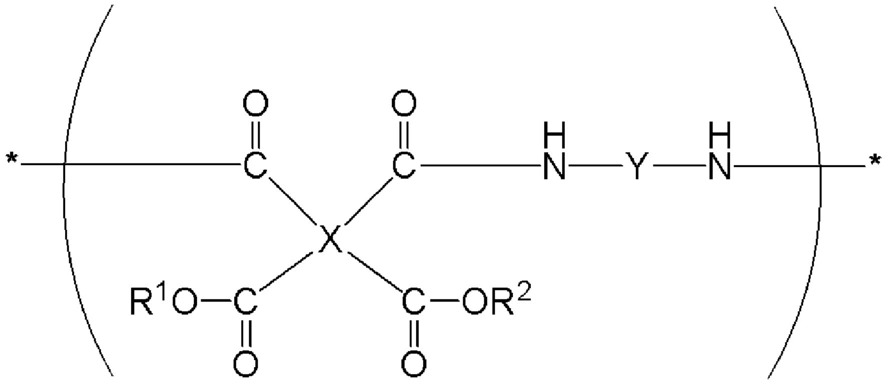

(5)

wherein X represents a tetravalent organic group, Y represents a divalent organic group, $R^1$ and $R^2$ each independently represent a hydrogen atom or a monovalent organic group, and at least one of $R^1$ and $R^2$ represents a group represented by the following general formula (6),

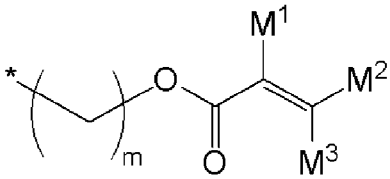

(6)

wherein $M^1$, $M^2$, and $M^3$ each independently represents a hydrogen atom or an organic group having 1 to 3 carbon atoms, "m" represents an integer of 2 to 10, and "*" represents a bond.

The polymer compound having the structural unit of the polyimide precursor as above is preferable from the viewpoint of film strength of the obtained cured film.

Further, the composition preferably contains (B) a polymerizable compound having two or more ethylenically unsaturated groups.

Containing the crosslinking agent having two or more photopolymerizable unsaturated bonds in one molecule as above can enhance crosslinking of the component (A) in the exposed portion with photopolymerization to increase contrast between the exposed portion and unexposed portion.

In this case, W in the general formula (1) of the component (D) preferably represents a tert-butyl group.

When W represents a tert-butyl group, the organic compound represented by the general formula (1) is a compound in which the oxygen atom of the structure T is protected with a tert-butoxycarbonyl group (a Boc group). The tert-butoxycarbonyl group (the Boc group) is deprotected in the heating step of the curing reaction within a range of 100°C to 150°C to generate an organic compound that can enhance the imide ring-closing reaction, which consequently enables the imidization at 200°C or lower.

Further, in this case, W in the general formula (1) of the component (D) preferably represents a benzyl group.

When W represents a benzyl group, the organic compound represented by the general formula (1) is a compound in which the oxygen atom of the structure T is protected with a benzyloxycarbonyl protective group (a Z group). The benzyloxycarbonyl protective group (the Z group) is deprotected in the heating step of the curing reaction within a range of 120°C to 190°C to generate an organic compound that can enhance the imide ring-closing reaction, which consequently enables the imidization at 200°C or lower.

Preferable is the negative-type photosensitive resin composition in which the general formula (2) represents a structure represented by the following general formula (2-1),

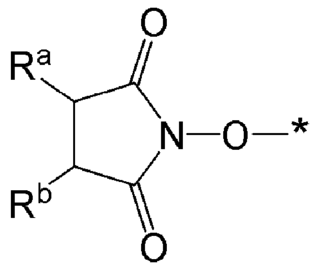

(2-1)

wherein $R^a$ and $R^b$ represent a hydrogen atom, a linear, branched, or cyclic alkyl group having 1 to 15 carbon atoms, or an aryl group having 6 to 15 carbon atoms, $R^a$ and $R^b$ are optionally bonded to each other to form a ring together with a carbon atom to which $R^a$ and $R^b$ are bonded, and "*" represents a bond.

When the general formula (2) represents the structure represented by the general formula (2-1), the hydroxyl group of the N-hydroxy-imide compound, which enhances the imidization reaction, is protected with the aforementioned tert-butoxycarbonyl group (Boc group) or benzyloxycarbonyl protective group (Z group), which yields better storage stability of the photosensitive resin composition containing the polyimide precursor resin.

Preferable is the negative-type photosensitive resin composition in which the general formula (3) represents a structure represented by the following general formula (3-1) or (3-2),

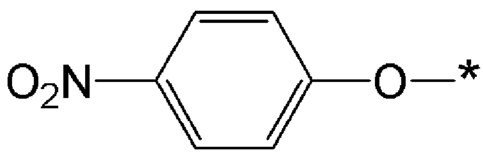

(3－1)

wherein "*" represents a bond,

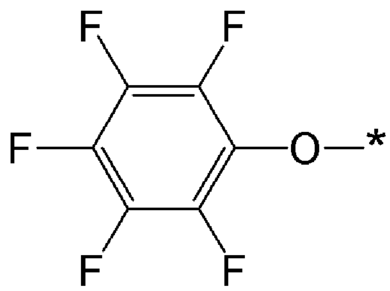

(3－2)

wherein "*" represents a bond.

When the general formula (3) represents the structure represented by the general formula (3-1) or (3-2), the hydroxyl group of 4-nitrophenol or pentafluorophenol, which are the activated esterifying agents to enhance the imidization reaction, is protected with the aforementioned tert-butoxycarbonyl group (Boc group) or benzyloxycarbonyl protective group (Z group), which yields better storage stability of the photosensitive resin composition containing the polyimide precursor resin.

The general formula (3) that represents the organic compound having the structure represented by the general formula (3-1) or (3-2) can be mentioned as a further preferable example due to easy availability of the raw materials, safety of the compound, low toxicity, etc.

Preferable is the negative-type photosensitive resin composition in which the general formula (4) represents a structure represented by the following general formula (4-1),

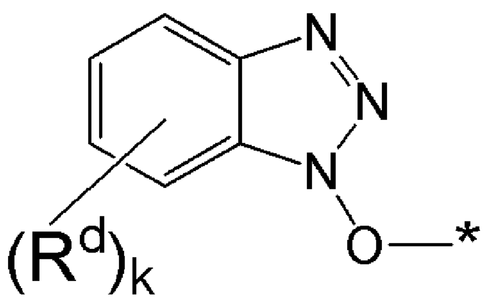

(4－1)

wherein $R^d$ represents a linear, branched, or cyclic alkyl group having 1 to 15 carbon atoms and optionally having a halogen atom, or an aryl group having 6 to 15 carbon atoms, "k" represents an integer of 0 to 4, and "*" represents a bond.

When the general formula (4) represents the structure represented by the following general formula (4-1), the hydroxyl group of 1-hydroxy-benzotriazole, which is the activated esterifying agent to enhance the imidization reaction, is protected with the aforementioned tert-butoxycarbonyl group (Boc group) or benzyloxycarbonyl protective group (Z group), which yields better storage stability of the photosensitive resin composition containing the polyimide precursor resin.

The composition preferably contains the component (D) at 1 to 10 parts by mass relative to 100 parts by mass of the component (A).

When the organic compound of the component (D) is at 10 parts by mass or less, the added organic compound does not act as a plasticizer, and does not cause deformation of the formed pattern due to heat, namely thermal flow, leading to prevention of impairing patterning. After the curing, the glass transition temperature (Tg.) of the obtained cured film is not lowered. The obtained cured film is required to have a high glass transition temperature (Tg.) because of requirement of resistance against heat in a step of producing an electronic component formed by using an interlayer insulating film or a surface protecting film using the obtained cured film.

In the present invention, the composition preferably further contains, as (F) a thermal crosslinking agent, one or two or more crosslinking agents selected from: an amino condensate modified with formaldehyde or with formaldehyde and an alcohol; a phenol compound having two or more methylol groups or alkoxymethylol groups in average in one molecule; a compound in which hydrogen atoms of hydroxy groups in a polyhydric phenol are substituted with glycidyl groups; a compound in which hydrogen atoms of hydroxy groups in a polyhydric phenol or of hydroxy groups in a polyhydric alcohol are substituted with a substituent represented by the following formula (F-1); and a compound having two or more nitrogen atoms having a glycidyl group, represented by the following formula (F-2),

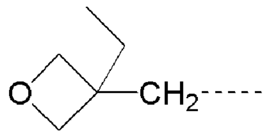

(F-1)

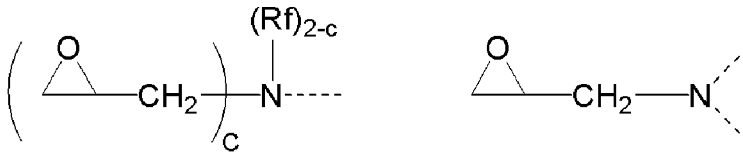

(F-2)

wherein a broken line represents an attachment point, Rf represents a linear, branched, or cyclic alkyl group having 1 to 6 carbon atoms, and "c" represents 1 or 2.

The component (F) is a component that causes a crosslinking reaction in post-curing after patterning of the negative-type photosensitive resin composition of the present invention to further increase strength of the cured product.

The above negative-type photosensitive resin composition preferably further contains (G) an antioxidant.

Containing the antioxidant of the component (G) can inhibit undesired crosslinking between the component (A) each other or between the component (A) and the component (B) in patterning to increase contrast. In addition, by an antirust effect for a metal material, oxidation of metal due to an outside water content, a photoacid generator, a thermal acid generator, etc. and decrease in adhesiveness or peeling involved therewith can be inhibited.

The above negative-type photosensitive resin composition preferably further contains (H) a silane compound.

The negative-type photosensitive resin composition of the present invention preferably contains a metal-adhesiveness improver for increasing adhesiveness to a metal material used for electrodes, wiring, etc. Examples of the metal-adhesiveness improver include the silane compound.

The above negative-type photosensitive resin composition preferably further contains (I) a polymerization inhibitor.

Containing (I) the polymerization inhibitor allows to add a thermal polymerization inhibitor for improving stability of viscosity and light sensitivity of the composition solution during storage.

The present invention can provide a patterning process, including:

(1) a step of applying the aforementioned photosensitive resin composition on a substrate to form a photosensitive material coating; then
(2) after a heating treatment, a step of exposing the photosensitive material coating with high-energy ray having a wavelength of 190 to 500 nm or electron beam though a photomask; and
(3) after the irradiation, a step of performing development by using a developer of an organic solvent.

The patterning process of the negative-type photosensitive composition as above particularly allows curing the negative-type photosensitive resin composition using the polymer compound having the polyimide precursor structure, which is a polymer having the aforementioned polymerizable unsaturated bond group for the base resin (A), without change in shape of the obtained pattern by containing the organic compound of the component (D) of the present invention. Therefore, the patterning process enables fine patterning.

The present invention can provide a method for forming a cured coating, the method including a subsequent step of heating and post-curing the patterned coating obtained by the above patterning process at a temperature of 100 to 300°C.

The patterning process as above allows the curing reaction after pattern formation, namely the imide ring-closing reaction, at the low temperature.

In addition, the present invention provides an interlayer insulating film including a cured coating formed by curing the above negative-type photosensitive resin composition.

The cured coating formed by curing the photosensitive resin composition of the present invention is beneficial as the interlayer insulating film.

In addition, the present invention provides a surface protecting film including a cured coating formed by curing the above negative-type photosensitive resin composition.

The cured coating formed by curing the photosensitive resin composition of the present invention is beneficial as the interlayer insulating film and the surface protecting film.

The present invention provides an electronic component including the above interlayer insulating film.

The present invention provides an electronic component including the above surface protecting film.

The electronic components as above have the protective coating having heat resistance, chemical resistance, and insulability (the interlayer insulating film or the surface protecting film), and therefore has excellent reliability.

ADVANTAGEOUS EFFECTS OF INVENTION

As noted above, the present invention can provide the negative-type photosensitive resin composition that enables the imide ring-closing reaction at a low temperature regardless of the molecular structure of the polyimide precursor and that contains the polymer compound having the polyimide precursor structure having high storage stability. In addition, the curing can be performed without change in shape of the obtained pattern, which enables fine patterning. The cured film obtained by curing after patterning exhibits excellent chemical resistance and a high glass transition temperature (Tg.).

DESCRIPTION OF EMBODIMENTS

As noted above, there has been a demand for development of a photosensitive resin composition that allows the imide ring-closing reaction at low temperature, that has excellent stability of the composition, that uses a polyimide precursor that enables fine patterning, and that can impart resistance against chemicals after curing.

The present inventors have made earnest study to achieve the above object, and consequently found that, in the photosensitive resin composition using the polymer compound having the polyimide precursor structure, composition of adding an organic compound represented by the following general formula (1) can achieve fine patterning without impairing, and that the curing reaction after patterning, namely the imide ring-closing reaction, can be performed at 200°C or lower.

In addition, it has been found that the obtained cured film has excellent chemical resistance and the cured film has a high glass transition temperature (Tg.). Further, it has been found that the photosensitive resin composition has good storage stability. These findings have led to completion of the present invention.

Specifically, the present invention is a negative-type photosensitive resin composition including:

(A) a polymer compound including a polyimide precursor structure;
(C) a photopolymerization initiator;
(D) an organic compound represented by the following general formula (1); and
(E) a solvent,

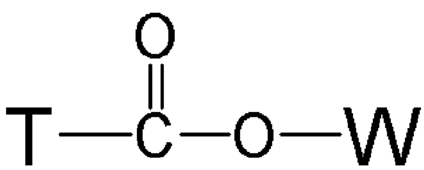

(1)

wherein T represents any one structure of the following general formulae (2) to (4), and W represents an alkyl group or an aryl group that are optionally substituted with an alkoxy group having 4 to 15 carbon atoms,

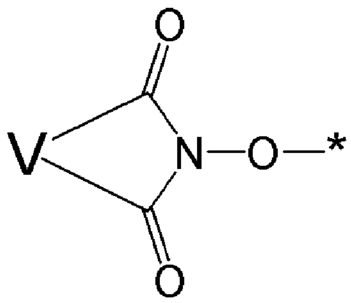

(2)

wherein V represents a divalent organic group, and "*" represents a bond,

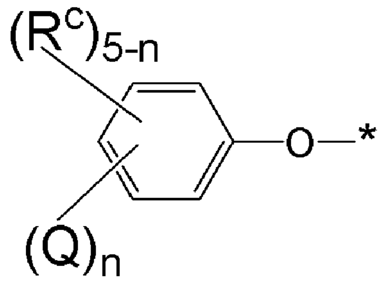

(3)

wherein Q represents a halogen atom or a nitro group, $R^C$ represents a hydrogen atom, a linear, branched, or cyclic alkyl group having 1 to 15 carbon atoms, or an aryl group having 6 to 15 carbon atoms, "n" represents an integer of 3 to 5 when Q represents the halogen atom or represents 1 when Q represents the nitro group, and "*" represents a bond,

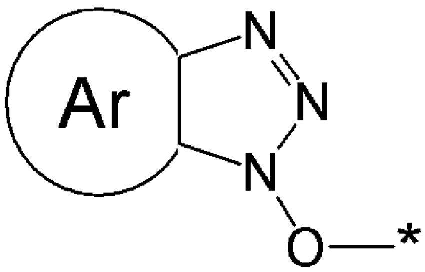

(4)

wherein Ar represents a substituted or unsubstituted aromatic cyclic structure or a heterocyclic structure having a heteroatom, and "*" represents a bond.

Hereinafter, the present invention will be described in detail, but the present invention is not limited thereto.

Component (A)

The polymer compound having the structural unit of the polyimide precursor according to the present invention is preferably a polymer compound represented by the following formula (5) from the viewpoint of film strength of the obtained cured film.

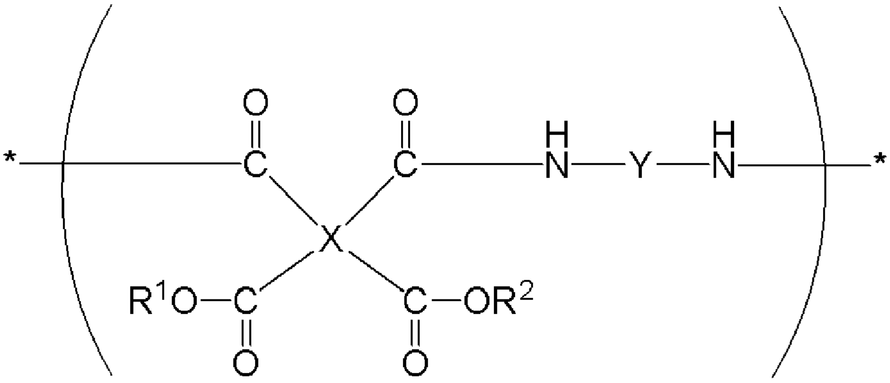

(5)

In the formula, X represents a tetravalent organic group, Y represents a divalent organic group, $R^1$ and $R^2$ each independently represent a hydrogen atom or a monovalent organic group, and at least one of $R^1$ and $R^2$ represents a group represented by the following general formula (6).

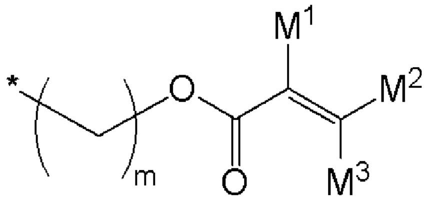

(6)

In the formula, $M^1$, $M^2$, and $M^3$ each independently represent a hydrogen atom or an organic group having 1 to 3 carbon atoms, and "m" represents an integer of 2 to 10. "*" represents a bond.

X in the general formula (5) represents a tetravalent organic group, and may be any tetravalent organic group without limitation. X preferably represents a tetravalent organic group being an alicyclic aliphatic group or aromatic group having 4 to 40 carbon atoms. X further preferably represents a tetravalent organic group represented by the following formula (7). The structure of X may be one type or combination of two or more types.

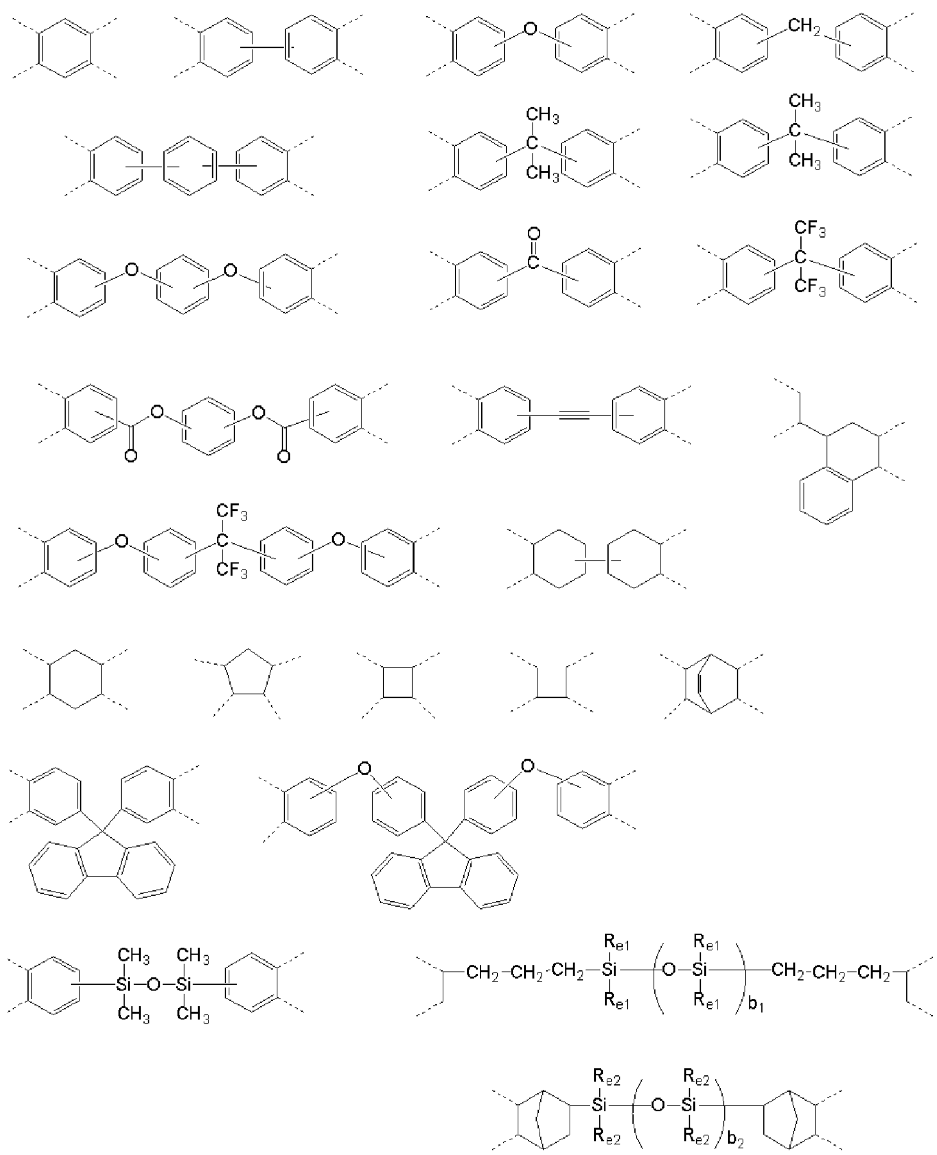

(7)

In the formulae, $R_{e1}$ and $R_{e2}$ each independently represent a methyl group or a phenyl group, $b_1$ and $b_2$ represent an integer of 1 to 20, and a broken line represents an attachment point.

Y in the general formula (5) represents the divalent organic group, and may be any divalent organic group without limitation. Y preferably represents a divalent organic group having 6 to 40 carbon atoms, and more preferably represents a divalent cyclic organic group having 1 to 4 aromatic rings or aliphatic rings having a substituent, or a divalent aliphatic group or a siloxane group having no cyclic structure. Examples of further preferable Y include structures represented by the following formula (8) or (9). The structure of Y may be one type or combination of two or more types.

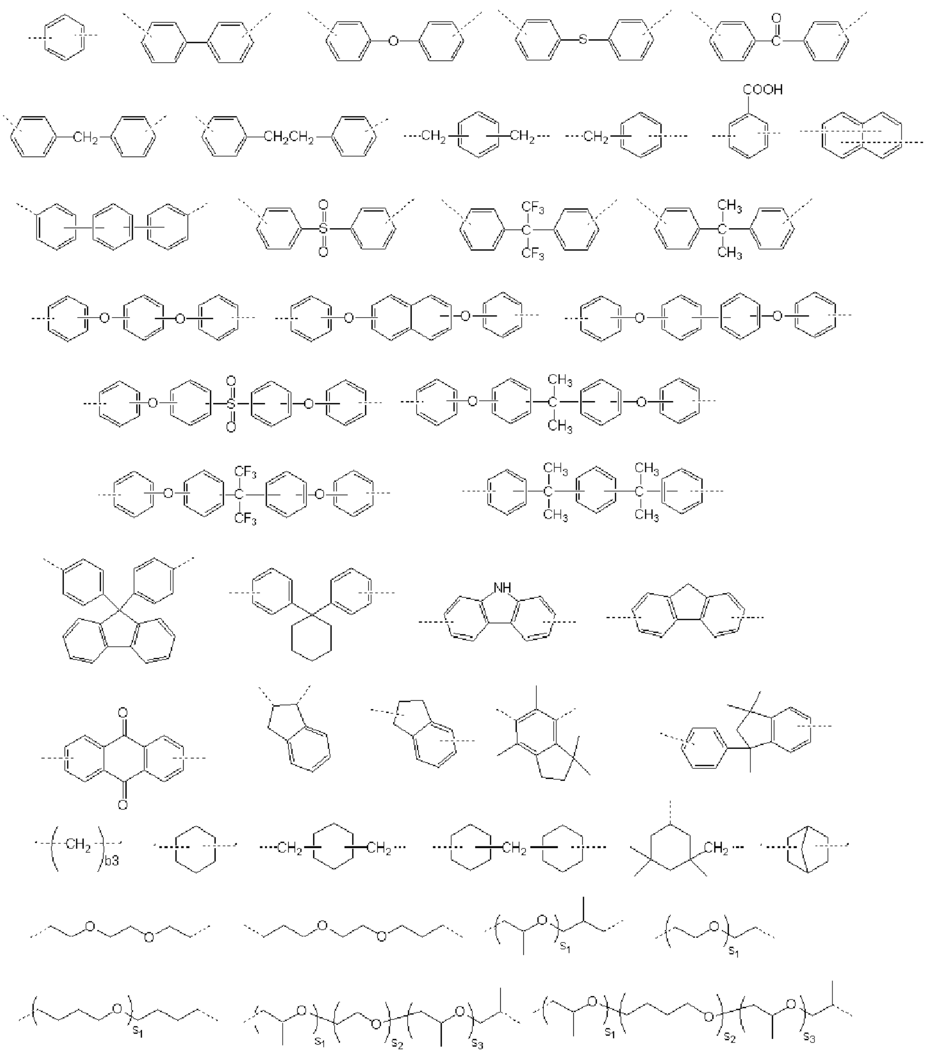

(8)

In the formulae, $b_3$ represents an integer of 1 to 20 , $s_1$ represents an integer of 1 to 40, $s_2$ and $s_3$ each independently represent an integer of 0 to 40, and a broken line represents an attachment point.

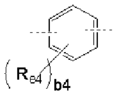
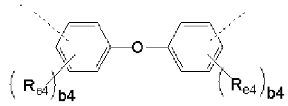
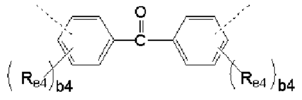
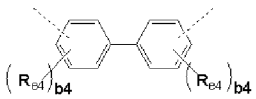
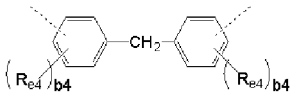
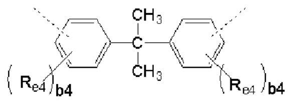
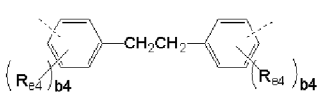
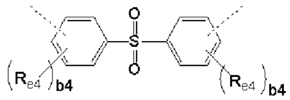
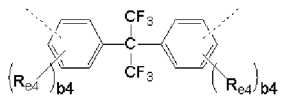
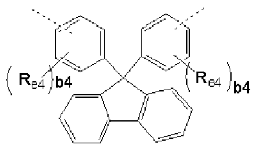
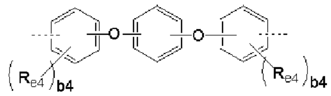
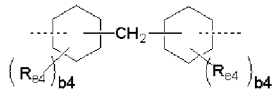
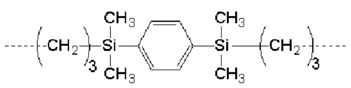
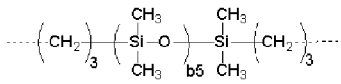
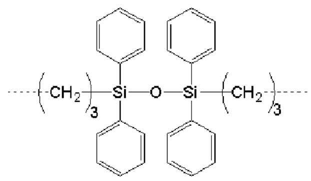

(9)

In the formulae, b4 represents an integer of 1 to 4, $R_{e4}$ represents a fluorine atom, a methyl group, an ethyl group, a propyl group, a n-butyl group, a methoxy group, an ethoxy group, a propoxy group, a butoxy group, or a trifluoromethyl group, when b4 represents 2 or more, $R_{e4}$ may be the same as or different from each other, b5 represents an integer of 1 to 40, and a broken line represents an attachment point.

$R^1$ and $R^2$ in the general formula (5) each independently represent a hydrogen atom or a monovalent organic group, the monovalent organic group may be a linear, branched, or cyclic alkyl group having 1 to 6 carbon atoms or the organic group represented by the general formula (6), and at least one of $R^1$ and $R^2$ represents the organic group represented by the general formula (6).

$M^1$ in the general formula (6) is not limited as long as $M^1$ represents a hydrogen atom or a monovalent organic group having 1 to 3 carbon atoms, but preferably a hydrogen atom or a methyl group from the viewpoint of a photosensitivity property of the negative-type photosensitive resin composition.

$M^2$ and $M^3$ in the general formula (6) are not limited as long as $M^2$ and $M^3$ each independently represent a hydrogen atom or a monovalent organic group having 1 to 3 carbon atoms, but preferably a hydrogen atom from the viewpoint of a photosensitivity property of the negative-type photosensitive resin composition.

"m" in the general formula (6) represents an integer of 2 to 10, and preferably an integer of 2 to 4 from the viewpoint of a photosensitivity property. "m" further preferably represents 2.

The polymer compound of the present invention may further have any one or more structural units represented the following general formulae (10) to (12) in addition to the structural unit represented by the general formula (5).

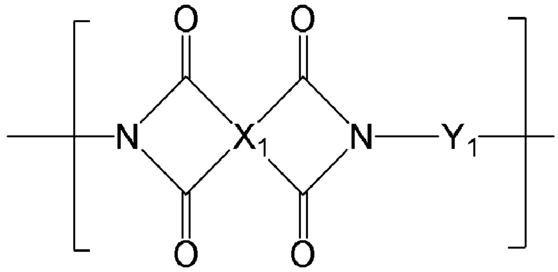

(10)

In the formula, $X_1$ represents a tetravalent organic group that is the same as or different from the X, and $Y_1$ represents a divalent organic group that is the same as or different from the Y.

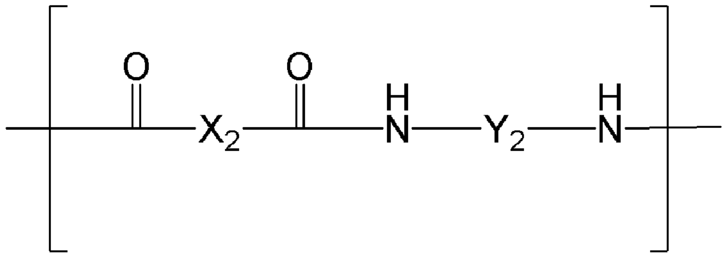

(11)

In the formula, $X_2$ represents a divalent organic group, and $Y_2$ represents a divalent organic group that are the same as or different from the Y.

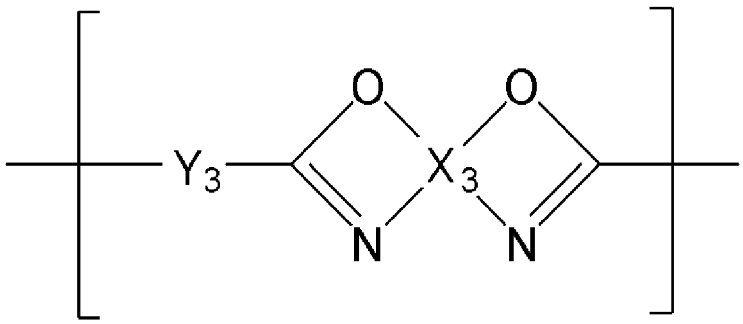

(12)

In the formula, $Y_3$ represents a divalent organic group that is the same as or different from the Y, and $X_3$ represents a tetravalent organic group.

$X_1$ in the general formula (10) represents a tetravalent organic group, which may be the same as or different from the X, and may be any tetravalent organic group without limitation. $X_1$ preferably represents a tetravalent alicyclic aliphatic group having 4 to 40 carbon atoms or a tetravalent aromatic group having 6 to 40 carbon atoms, and $X_1$ optionally has a siloxane skeleton. $X_1$ further preferably represents the tetravalent organic group represented by the formula (7). The structure of $X_1$ may be one type or combination of two or more types.

$Y_1$ in the general formula (10) represents the divalent organic group, which may be the same as or different from the Y, and may be any divalent organic group without limitation. $Y_1$ preferably represents a divalent organic group having 6 to 40 carbon atoms, and more preferably a divalent cyclic organic group having 1 to 4 aromatic rings or aliphatic rings having a substituent, or a divalent aliphatic group or a siloxane group having no cyclic structure. Examples of further preferable $Y_1$ include the structures represented by the formula (8) or (9). The structure of $Y_1$ may be one type or combination of two or more types.

The resin composition containing the polymer compound having the structural unit represented by the general formula (10) is preferable because mechanical strength, adhesiveness to the substrate, and heat resistance of the cured coating obtained by patterning can be improved. The structural unit (10) is preferable because the ring-closing reaction is not needed in post-curing, and the curing reaction temperature can be relatively lowered.

$X_2$ in the general formula (11) represents the divalent organic group, and may be any divalent organic group without limitation. $X_2$ preferably represents a divalent organic group being an aliphatic chain structure having 4 to 40 carbon atoms, a divalent alicyclic aliphatic group having 4 to 40 carbon atoms, or a divalent aromatic group having 6 to 40 carbon atoms. $X_2$ further preferably represents a divalent organic group represented by the following formula (13). The structure of $X_2$ may be one type or combination of two or more types.

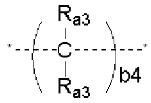
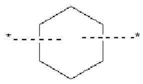
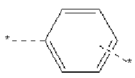
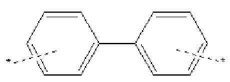
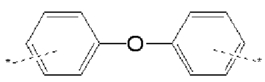
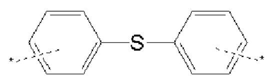
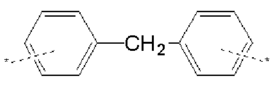
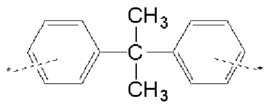
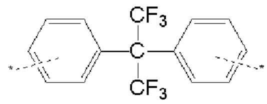
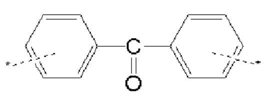
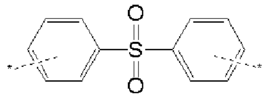

(1 3)

In the formulae, $R_{a3}$ each independently represents a hydrogen atom, a fluorine atom, or an alkyl group having 1 to 6 carbon atoms, b4 represents an integer of 1 to 30, and a broken line represents an attachment point.

$Y_2$ in the general formula (11) represents a divalent organic group, which may be the same as or different from the Y, and may be any divalent organic group without limitation. $Y_2$ preferably represents a divalent organic group having 6 to 40 carbon atoms, and preferably a divalent cyclic organic group having 1 to 4 aromatic rings or aliphatic rings having a substituent, or a divalent aliphatic group or a siloxane group having no cyclic structure. Examples of further preferable $Y_2$ include the structures represented by the formula (8) or (9). The structure of $Y_2$ may be one type or combination of two or more types.

$Y_3$ in the general formula (12) represents a divalent organic group, which may be the same as or different from the Y, and may be any divalent organic group without limitation. $Y_3$ preferably represents a divalent organic group being an aliphatic chain structure having 4 to 40 carbon atoms, a divalent alicyclic aliphatic group having 4 to 40 carbon atoms, or a divalent aromatic group having 6 to 40 carbon atoms. $Y_3$ further preferably represents a divalent organic group represented by the formula (13). The structure of $Y_3$ may be one type or combination of two or more types.

$X_3$ in the general formula (12) represents a tetravalent organic group, and may be any tetravalent organic group without limitation. $X_3$ preferably represents a tetravalent organic group having 6 to 40 carbon atoms, and more preferably a tetravalent cyclic organic group having 1 to 4 aromatic rings or aliphatic rings having a substituent, or a tetravalent aliphatic group or a siloxane group having no cyclic structure. Examples of further preferable $X_3$ include structures represented by the following formula (14). The structure of $X_3$ may be one type or combination of two or more types.

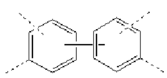
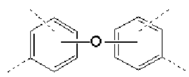
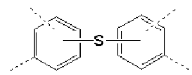
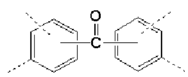
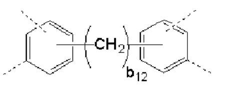
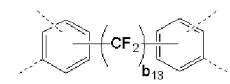
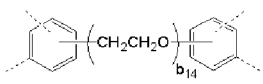
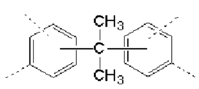
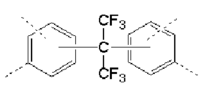
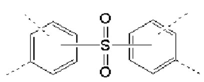
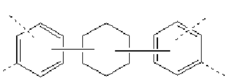
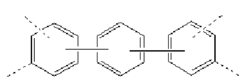
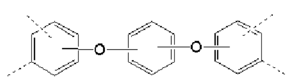
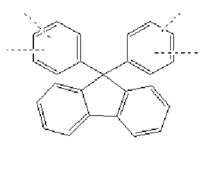
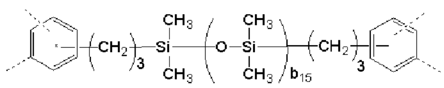

(1 4)

In the formulae, $b_{12}$, $b_{13}$, and $b_{14}$ represent an integer of 1 to 10, $b_{15}$ represents an integer of 1 to 20, and a broken line represents an attachment point.

The resin composition containing the polymer having the structural unit represented by the general formula (12) is preferable because mechanical strength, adhesiveness to the substrate, and heat resistance of the cured film obtained by patterning can be improved. The structural unit having the structure represented by the general formula (12) is preferable because the ring-closing reaction is not needed in post-curing, and the curing reaction temperature can be relatively lowered.

A preferable molecular weight of the polymer of the present invention is preferably 5,000 to 100,000, and more preferably 7,000 to 50,000. The molecular weight of 5,000 or more facilitates film formation of the photosensitive resin composition containing the polymer of the present invention on the substrate with a desired film thickness. The molecular weight of 100,000 or less does not cause considerably high viscosity of the photosensitive resin composition, and facilitates film formation. In the present invention, the weight-average molecular weight is a value in terms of polystyrene by gel permeation chromatography (GPC) measurement using DMF as an eluent under a condition at a temperature of 40°C.

Method for Producing Polymer Compound

The polymer compound contained in the negative-type photosensitive resin composition of the present invention preferably has a structural unit represented by the following formula (5).

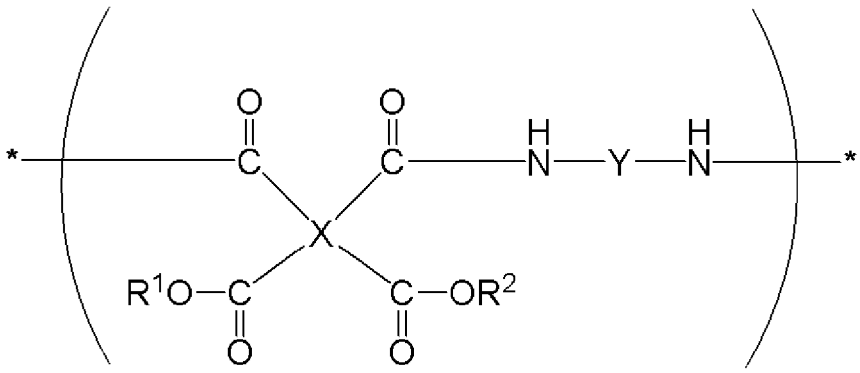

(5)

In the formula, X represents a tetravalent organic group, Y represents a divalent organic group, $R^1$ and $R^2$ each independently represent a hydrogen atom or a monovalent organic group, and at least one of $R^1$ and $R^2$ represents a group represented by the following general formula (6).

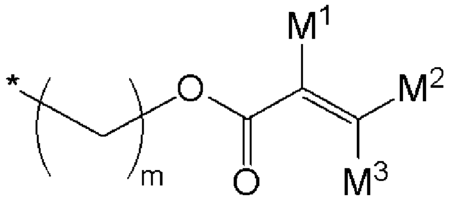

(6)

In the formula, $M^1$, $M^2$, and $M^3$ each independently represent a hydrogen atom or an organic group having 1 to 3 carbon atoms, and "m" represents an integer of 2 to 10. "*" represents a bond.

The polymer having the structural unit represented by the general formula (5) can be obtained by a reaction between a tetracarboxylic acid diester compound represented by the following general formula (15) and a diamine represented by the following general formula (16).

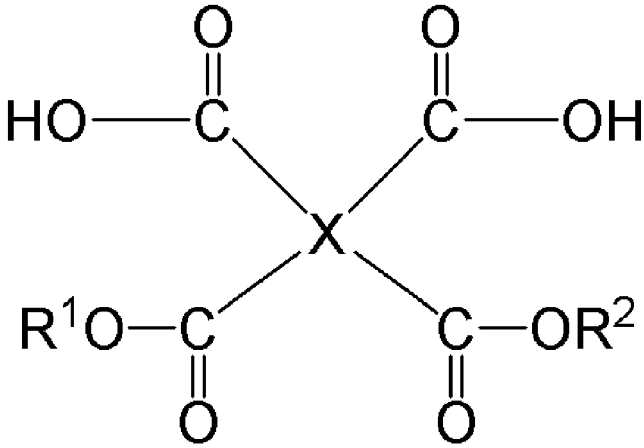

(15)

In the formula, X, $R^1$, and $R^2$ are the same as above.

$$H_2N-Y-NH_2$$ (16)

In the formula, Y is the same as above.

In the general formula (15), at least any one of $R^1$ and $R^2$ represents the organic group represented by the general formula (6), and the organic group represented by the general formula (6) can be introduced by a reaction between a tetracarboxylic dianhydride represented by the following general formula (17) and a compound having a hydroxy group at an end, represented by the following general formula (18), in the presence of a basic catalyst such as pyridine. Here, the tetracarboxylic dianhydride represented by the following general formula (17) is a source of X (for example, the tetravalent organic group represented by the formula (7)) in the general formula (5). The compound having a hydroxy group at an end, represented by the following general formula (18), can introduce the organic group represented by the general formula (6).

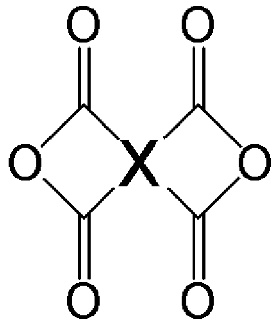

(17)

In the formula, X represents a tetravalent organic group, which is the same as X in the general formula (5).

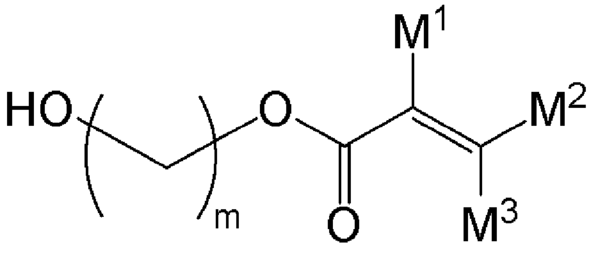

(18)

In the formula, $M^1$, $M^2$, $M^3$, and "m" are the same as $M^1$, $M^2$, $M^3$, and "m" in the general formula (6).

Preferable examples of the tetracarboxylic dianhydride represented by the general formula (17) include aromatic acid dianhydrides, alicyclic acid dianhydrides, aliphatic acid dianhydrides, and siloxane-skeleton-containing acid dianhydrides.

Examples of the aromatic acid dianhydrides include, but not limited to, pyromellitic dianhydride, 3,3',4,4'-biphenyltetracarboxylic dianhydride, 2,3,3',4'-biphenyltetracarboxylic dianhydride, 2,3,2',3'-biphenyltetracarboxylic dianhydride, 3,3',4,4'-terphenyltetracarboxylic dianhydride, 3,3',4,4'-oxyphthalic dianhydride, 2,3,3',4'-oxyphthalic dianhydride, 2,3,2',3'-oxyphthalic dianhydride, diphenylsulfone-3,3',4,4'-tetracarboxylic dianhydride, benzophenone-3,3',4,4'-tetracarboxylic dianhydride, 2,2-bis(3,4-dicarboxyphenyl)propane dianhydride, 2,2-bis(2,3-dicarboxyphenyl)propane dianhydride, 1,1-bis(3,4-dicarboxyphenyl)ethane dianhydride, 1,1-bis(2,3-dicarboxyphenyl)ethane dianhydride, bis(3,4-dicarboxyphenyl)methane dianhydride, bis(2,3-dicarboxyphenyl)methane dianhydride, 1,4-(3,4-dicarboxyphenoxy)benzene dianhydride, p-phenylenebis(trimellitic acid monoester anhydride), bis(1,3-dioxo-1,3-dihydroisobenzofuran-5-carboxylic acid)-1,4-phenylene, 2,2-bis(4-(4-aminophenoxy)phenyl)propane, 1,2,5,6-naphthalenetetracarboxylic dianhydride, 2,3,6,7-naphthalenetetracarboxylic dianhydride, 9,9-bis(3,4-dicarboxyphenyl)fluorene dianhydride, 9,9-bis(4-(3,4-dicarboxyphenoxy) phenyl) fluorene dianhydride, 2,3,5,6-pyridinetetracarboxylic dianhydride, 3,4,9,10-perylenetetracarboxylic dianhydride, 2,2-bis(3,4-dicarboxyphenyl)hexafluoropropane dianhydride, 2,2-bis(4-(3,4-dicarboxybenzoyloxy)phenyl)hexafluoropropane dianhydride, 1,6-difluoropyromellitic dianhydride, 1-trifluoromethylpyromellitic dianhydride, 1,6-ditrifluoromethylpyromellitic dianhydride, 2,2'-bis(trifluoromethyl)-4,4'-bis(3,4-dicarboxyphenoxy)biphenyl dianhydride, 2,2'-bis[(dicarboxyphenoxy)phenyl]propane dianhydride, and 2,2'-bis[(dicarboxyphenoxy)phenyl] hexafluoropropane dianhydride, or acid dianhydride compounds in which an aromatic ring in these dianhydrides is substituted with an alkyl group, an alkoxy group, a halogen atom, etc.

Examples of the alicyclic acid dianhydrides include, but not limited to, 1,2,3,4-cyclobutanetetracarboxylic dianhydride, 1,2,3,4-cyclopentanetetracarboxylic dianhydride, 1,2,4,5-cyclohexanetetracarboxylic dianhydride, 1,2,4,5-cyclopentanetetracarboxylic dianhydride, 1,2,3,4-tetramethyl-1,2,3,4-cyclobutanetetracarboxylic dianhydride, 1,2-dimethyl-1,2,3,4-cyclobutanetetracarboxylic dianhydride, 1,3-dimethyl-1,2,3,4-cyclobutanetetracarboxylic dianhydride, 1,2,3,4-cycloheptanetetracarboxylic dianhydride, 2,3,4,5-tetrahydrofurantetracarboxylic dianhydride, 3,4-dicarboxy-1-cyclohexylsuccinic dianhydride, 2,3,5-tricarboxycyclopentylacetic dianhydride, 3,4-dicarboxy-1,2,3,4-tetrahydro-1-naphthalenesuccinic dianhydride, bicyclo[3.3.0]octane-2,4,6,8-tetracarboxylic dianhydride, bicyclo[4.3.0]nonane-2,4,7,9-tetracarboxylic dianhydride, bicyclo[4.4.0]decane-2,4,7,9-tetracarboxylic dianhydride, bicyclo[4.4.0]decane-2,4,8,10-tetracarboxylic dianhydride, tricyclo[6.3.0.0$^{2,6}$]undecane-3,5,9,11-tetracarboxylic dianhydride, bicyclo[2.2.2]octane-2,3,5,6-tetracarboxylic dianhydride, bicyclo[2.2.2]oct-7-ene-2,3,5,6-tetracarboxylic dianhydride, bicyclo[2.2.1]heptanetetracarboxylic dianhydride, bicyclo[2.2.1]heptane-5-carboxymethyl-2,3, 6-tricarboxylic dianhydride, 7-oxabicyclo[2.2.1]heptane-2,4,6,8-tetracarboxylic dianhydride, octahydronaphthalene-1,2,6,7-tetracarboxylic dianhydride, tetradecahydroanthracene-1,2,8,9-tetracarboxylic dianhydride, 3,3',4,4'-dicyclohexanetetracarboxylic dianhydride, 3,3',4,4'-oxydicyclohexanetetracarboxylic dianhydride, 5-(2,5-dioxotetrahydro-3-furanyl)-3-methyl-3-cyclohexene-1,2-dicarboxylic anhydride, and "RIKACID" (R) BT-100 (the above is a trade name, available from New Japan Chemical Co., Ltd.) and derivatives thereof, or acid dianhydride compounds in which an aliphatic ring in these dianhydrides is substituted with an alkyl group, an alkoxy group, a halogen atom, etc.

Examples of the aliphatic acid dianhydrides include, but not limited to, 1,2,3,4-butanetetracarboxylic dianhydride, 1,2,3,4-pentanetetracarboxylic dianhydride, and derivatives thereof.

Examples of the siloxane-skeleton-containing acid dianhydrides include, but not limited to, 1,3-bis(3,4-dicarboxyphenyl)-1,1,3,3-tetramethyldisiloxane dianhydride, 3,3'-((1,1,3,3-tetramethyl-1,3-disiloxanediyl)-di-3,1-propanediyl)bis(dihydro-2,5-furandione), and derivatives thereof.

These aromatic acid dianhydrides, alicyclic acid dianhydrides, aliphatic acid dianhydrides, and siloxane-skeleton-containing acid dianhydrides may be used singly or in combination of two or more thereof.

$M^1$ in the general formula (18) is not particularly limited as long as $M^1$ represents a hydrogen atom or a monovalent organic group having 1 to 3 carbon atoms, but preferably a hydrogen atom or a methyl group from the viewpoint of a photosensitivity property of the negative-type photosensitive resin composition.

$M^2$ and $M^3$ in the general formula (18) are not particularly limited as long as $M^2$ and $M^3$ each independently represent a hydrogen atom or a monovalent organic group having 1 to 3 carbon atoms, but preferably a hydrogen atom from the viewpoint of a photosensitivity property of the negative-type photosensitive resin composition.

"m" in the general formula (18) represents an integer of 2 to 10, and preferably an integer of 2 to 4 from the viewpoint of a photosensitivity property. "m" more preferably represents 2.

Among the compounds having a hydroxy group at an end, represented by the general formula (18), examples of preferable compounds include 2-acryloyloxyethyl alcohol, 1-acryloyloxy-3-propyl alcohol, 2-methacryloyloxyethyl alcohol, and 1-methacryloyloxy-3-propyl alcohol.

$R^1$ and $R^2$ in the general formula (5) may be a linear, branched, or cyclic alkyl group having 1 to 6 carbon atoms. Examples of a method for introducing the linear, branched, or cyclic alkyl group having 1 to 6 carbon atoms into the general formula (5) (that is, $R^1$ and $R^2$ become the linear, branched, or cyclic alkyl group having 1 to 6 carbon atoms) include a method in which, in the reaction between the compound having a hydroxy group at an end, represented by the general formula (18), and the tetracarboxylic dianhydride in the presence of a basic catalyst such as pyridine, a linear, branched, or cyclic alcohol having 1 to 6 carbon atoms is simultaneously added.

Examples of a preferable alcohol usable in this case include methanol, ethanol, 1-propanol, 2-propanol, 1-butanol, 2-butanol, 1-pentanol, 2-pentanol, 3-pentanol, neopentyl alcohol, 1-hexanol, 2-hexanol, 3-hexanol, cyclopentanol, and cyclohexanol.

As for the reaction between the tetracarboxylic dianhydride represented by the general formula (17) and the compound having a hydroxy group at an end, represented by the general formula (18), a half-esterification reaction of the acid dianhydride proceeds by stirring, dissolving, and mixing the tetracarboxylic dianhydride represented by the general formula (17) and the compound having a hydroxy group at an end, represented by the general formula (18), in the presence of a basic catalyst such as pyridine in a reaction solvent at a reaction temperature of 20 to 50°C over 4 to 10 hours, and the desired tetracarboxylic acid diester compound represented by the general formula (15) can be obtained as a solution of the compound dissolved in the reaction solvent.

The obtained tetracarboxylic acid diester compound may be isolated, or the obtained solution may be used as it is for a reaction with a diamine in the next step, described later.

The reaction solvent is preferably a solvent that favorably dissolves the tetracarboxylic acid diester compound and the polymer having the structural unit of the polyimide precursor obtained by a subsequently performed polycondensation reaction between the tetracarboxylic acid diester compound and the diamines. Examples thereof include N-methyl-2-pyrrolidone, N,N-dimethylacetamide, N,N-dimethylformamide, dimethyl sulfoxide, tetramethylurea, and γ-butyrolactone. Ketones, esters, lactones, ethers, halogenated hydrocarbons, and hydrocarbons may also be used. Specific examples thereof include acetone, methyl ethyl ketone, methyl isobutyl ketone, cyclohexanone, methyl acetate, ethyl acetate, butyl acetate, diethyl oxalate, ethylene glycol dimethyl ether, diethylene glycol dimethyl ether, tetrahydrofuran, dichloromethane, 1,2-dichloroethane, 1,4-dichlorobutane, chlorobenzene, o-dichlorobenzene, hexane, heptane, benzene, toluene, and xylene. These may be used singly, or two or more thereof may be mixed for use as necessary.

Preferable examples of the diamine represented by the general formula (16) include, but not limited to, (2-methyl-4-amino)phenyl 4-aminobenzoate, (3-methyl-4-amino)phenyl 4-aminobenzoate, (2-ethyl-4-amino)phenyl 4-aminobenzoate, (3-ethyl-4-amino)phenyl 4-aminobenzoate, (2-propyl-4-amino)phenyl 4-aminobenzoate, (3-propyl-4-amino)phenyl 4-aminobenzoate, (2-isopropyl-4-amino)phenyl 4-aminobenzoate, (3-isopropyl-4-amino)phenyl 4-aminobenzoate, (2-butyl-4-amino)phenyl 4-aminobenzoate, (3-butyl-4-amino)phenyl 4-aminobenzoate, (2-isobutyl-4-amino) phenyl 4-aminobenzoate, (3-isobutyl-4-amino)phenyl 4-aminobenzoate, (2-pentyl-4-amino)phenyl 4-aminobenzoate, (3-pentyl-4-amino)phenyl 4-aminobenzoate, (2-hexyl-4-amino)phenyl 4-aminobenzoate, (3-hexyl-4-amino)phenyl 4-aminobenzoate, (2-methoxy-4-amino)phenyl 4-aminobenzoate, (3-methoxy-4-amino)phenyl 4-aminobenzoate, (2-ethoxy-4-amino)phenyl 4-aminobenzoate, (3-ethoxy-4-amino)phenyl 4-aminobenzoate, (2-propoxy-4-amino)phenyl 4-aminobenzoate, (3-propoxy-4-amino)phenyl 4-aminobenzoate, (2-butoxy-4-amino)phenyl 4-aminobenzoate, (3-butoxy-4-amino)phenyl 4-aminobenzoate, (2-pentoxy-4-amino)phenyl 4-aminobenzoate, (3-pentoxy-4-amino)phenyl 4-aminobenzoate, (2-phenyl-4-amino)phenyl 4-aminobenzoate, (3-phenyl-4-amino)phenyl 4-aminobenzoate, (2-methylphenyl-4-amino)phenyl 4-aminobenzoate, (3-methylphenyl-4-amino)phenyl 4-aminobenzoate, (2-ethylphenyl-4-amino) phenyl 4-aminobenzoate, (3-ethylphenyl-4-amino)phenyl 4-aminobenzoate, (2-propylphenyl-4-amino)phenyl 4-aminobenzoate, (3-propylphenyl-4-amino)phenyl 4-aminobenzoate, (2-butylphenyl-4-amino)phenyl 4-aminobenzoate, (3-butylphenyl-4-amino)phenyl 4-aminobenzoate, (2-fluorophenyl-4-amino)phenyl 4-aminobenzoate, (3-fluorophenyl-4-amino)phenyl 4-aminobenzoate, (2-chlorophenyl-4-amino)phenyl 4-aminobenzoate, (3-chlorophenyl-4-amino)phenyl 4-aminobenzoate, (2-bromophenyl-4-amino)phenyl 4-aminobenzoate, (3-bromophenyl-4-amino)phenyl 4-aminobenzoate, (2-methoxyphenyl-4-amino)phenyl 4-aminobenzoate, (3-methoxyphenyl-4-amino)phenyl 4-aminobenzoate, (2-ethoxyphenyl-4-amino)phenyl 4-aminobenzoate, (3-ethoxyphenyl-4-amino)phenyl 4-aminobenzoate, (2-ethoxyphenyl-4-amino)phenyl 4-aminobenzoate, (2-aminophenyl-4-amino)phenyl 4-aminobenzoate, (3-aminophenyl-4-amino) phenyl 4-aminobenzoate, (2-nitrophenyl-4-amino)phenyl 4-aminobenzoate, (3-nitrophenyl-4-amino)phenyl 4-aminobenzoate, (2-cyanophenyl-4-amino)phenyl 4-aminobenzoate, (3-cyanophenyl-4-amino)phenyl 4-aminobenzoate, (2-phenylethyl-4-amino)phenyl 4-aminobenzoate, (3-phenylethyl-4-amino)phenyl 4-aminobenzoate, (2-phenylamino-4-amino)phenyl 4-aminobenzoate, (3-phenylamino-4-amino)phenyl 4-aminobenzoate, (2-(4,4'-biphenyl)-4-amino)phenyl 4-aminobenzoate, (3-(4,4'-biphenyl)-4-amino)phenyl 4-aminobenzoate, (2-naphthyl-4-amino)phenyl 4-aminobenzoate, (3-naphthyl-4-amino)phenyl 4-aminobenzoate, (2-methylphenoxy-4-amino)phenyl 4-aminobenzoate, (3-methylphenoxy-4-amino)phenyl 4-aminobenzoate, (2-ethylphenoxy-4-amino)phenyl 4-aminobenzoate, (3-ethylphenoxy-4-amino)phenyl 4-aminobenzoate, (2-propylphenoxy-4-amino)phenyl 4-aminobenzoate, (3-propylphenoxy-4-amino)phenyl 4-aminobenzoate, (2-methoxyphenoxy-4-amino)phenyl 4-aminobenzoate, (3-methoxyphenoxy-4-amino)phenyl 4-aminobenzoate, (2-ethoxyphenoxy-4-amino)phenyl 4-aminobenzoate, (3-ethoxyphenoxy-4-amino)phenyl 4-aminobenzoate, (2-benzyl-4-amino)phenyl 4-aminobenzoate, (3-benzyl-4-amino)phenyl 4-aminobenzoate, (2-methylbenzyl-4-amino)phenyl 4-aminobenzoate, (3-methylbenzyl-4-amino)phenyl 4-aminobenzoate, (2-ethylbenzyl-4-amino)phenyl 4-aminobenzoate, (3-ethylbenzyl-4-amino)phenyl 4-aminobenzoate, (2-propylbenzyl-4-amino)phenyl 4-aminobenzoate, (3-propylbenzyl-4-amino)phenyl 4-aminobenzoate, (2-methoxybenzyl-4-amino)phenyl 4-aminobenzoate, (3-methoxybenzyl-4-amino)phenyl 4-aminobenzoate, (2-ethoxybenzyl-4-amino)phenyl 4-aminobenzoate, (3-ethoxybenzyl-4-amino) phenyl 4-aminobenzoate, (2-aminobenzyl-4-amino)phenyl 4-aminobenzoate, (3-aminobenzyl-4-amino)phenyl 4-aminobenzoate, (2-nitrobenzyl-4-amino)phenyl 4-aminobenzoate, (3-nitrobenzyl-4-amino)phenyl 4-aminobenzoate, (2-cyanobenzyl-4-amino)phenyl 4-aminobenzoate, (3-cyanobenzyl-4-amino)phenyl 4-aminobenzoate, (2-benzyloxy-4-amino) phenyl 4-aminobenzoate, (3-benzyloxy-4-amino)phenyl 4-aminobenzoate, (2-methylbenzyloxy-4-amino)phenyl 4-aminobenzoate, (3-methylbenzyloxy-4-amino)phenyl 4-aminobenzoate, (2-ethylbenzyloxy-4-amino)phenyl 4-aminobenzoate, (3-ethylbenzyloxy-4-amino)phenyl 4-aminobenzoate, (2-propylbenzyloxy-4-amino)phenyl 4-aminobenzoate, (3-propylbenzyloxy-4-amino)phenyl 4-aminobenzoate, (2-methoxybenzyloxy-4-amino)phenyl 4-aminobenzoate, (3-methoxybenzyloxy-4-amino)phenyl 4-aminobenzoate, (2-ethoxybenzyloxy-4-amino)phenyl 4-aminobenzoate, (3-ethoxybenzyloxy-4-amino)phenyl 4-aminobenzoate, 4-(4-aminophenoxy)-3-methylbenzeneamine, 4-(4-aminophenoxy)-2-methylbenzeneamine, 4-(4-aminophenoxy)-3-ethylbenzeneamine, 4-(4-aminophenoxy)-2-ethylbenzeneamine, 4-(4-aminophenoxy)-3-propylbenzeneamine, 4-(4-aminophenoxy)-2-propylbenzeneamine, 4-(4-aminophenoxy)-3-isopropylbenzeneamine, 4-(4-aminophenoxy)-2-isopropylbenzeneamine, 4-(4-aminophenoxy)-3-butylbenzeneamine, 4-(4-aminophenoxy)-2-butylbenzeneamine, 4-(4-aminophenoxy)-3-isobutylbenzeneamine, 4-(4-aminophenoxy)-2-isobutylbenzeneamine,

4-(4-aminophenoxy)-3-pentylbenzeneamine, 4-(4-aminophenoxy)-2-pentylbenzeneamine, 4-(4-aminophenoxy)-3-hexylbenzeneamine, 4-(4-aminophenoxy)-2-hexylbenzeneamine, 4-(4-aminophenoxy)-3-(trifluoromethyl)benzeneamine, 4-(4-aminophenoxy)-2-(trifluoromethyl)benzeneamine, 4-(4-aminophenoxy)-3-methoxybenzeneamine, 4-(4-aminophenoxy)-2-methoxybenzeneamine, 4-(4-aminophenoxy)-3-ethoxybenzeneamine, 4-(4-aminophenoxy)-2-ethoxybenzeneamine, 4-(4-aminophenoxy)-3-propoxybenzeneamine, 4-(4-aminophenoxy)-2-propoxybenzeneamine, 4-(4-aminophenoxy)-3-butoxybenzeneamine, 4-(4-aminophenoxy)-2-butoxybenzeneamine, 4-(4-aminophenoxy)-3-phenylbenzeneamine, 4-(4-aminophenoxy)-2-phenylbenzeneamine, 4-(4-aminophenoxy)-3-methylphenylbenzeneamine, 4-(4-aminophenoxy)-2-methylphenylbenzeneamine, 4-(4-aminophenoxy)-3-ethylphenylbenzeneamine, 4-(4-aminophenoxy)-2-ethylphenylbenzeneamine, 4-(4-aminophenoxy)-3-propylphenylbenzeneamine, 4-(4-aminophenoxy)-2-propylphenylbenzeneamine, 4-(4-aminophenoxy)-3-butylphenylbenzeneamine, 4-(4-aminophenoxy)-2-butylphenylbenzeneamine, 4-(4-aminophenoxy)-3-fluorophenylbenzeneamine, 4-(4-aminophenoxy)-2-fluorophenylbenzeneamine, 4-(4-aminophenoxy)-3-chlorophenylbenzeneamine, 4-(4-aminophenoxy)-2-chlorophenylbenzeneamine, 4-(4-aminophenoxy)-3-bromophenylbenzeneamine, 4-(4-aminophenoxy)-2-bromophenylbenzeneamine, 4-(4-aminophenoxy)-3-methoxyphenylbenzeneamine, 4-(4-aminophenoxy)-2-methoxyphenylbenzeneamine, 4-(4-aminophenoxy)-3-ethoxyphenylbenzeneamine, 4-(4-aminophenoxy)-2-ethoxyphenylbenzeneamine, 4-(4-aminophenoxy)-3-(phenylethyl) phenylbenzeneamine, 4-(4-aminophenoxy)-2-(phenylethyl)phenylbenzeneamine, 4-(4-aminophenoxy)-3-naphthylphenylbenzeneamine, 4-(4-aminophenoxy)-2-naphthylphenylbenzeneamine, 4-(4-aminophenoxy)-3-benzylphenylbenzeneamine, 4-(4-aminophenoxy)-2-benzylphenylbenzeneamine, 4-((4-aminophenyl)thio)-3-methylbenzeneamine, 4-((4-aminophenyl)thio)-2-methylbenzeneamine, 4-((4-aminophenyl)thio)-3-ethylbenzeneamine, 4-((4-aminophenyl)thio)-2-ethylbenzeneamine, 4-((4-aminophenyl)thio)-3-propylbenzeneamine, 4-((4-aminophenyl)thio)-2-propylbenzeneamine, 4-((4-aminophenyl)thio)-3-isopropylbenzeneamine, 4-((4-aminophenyl)thio)-2-isopropylbenzeneamine, 4-((4-aminophenyl)thio)-3-butylbenzeneamine, 4-((4-aminophenyl)thio)-2-butylbenzeneamine, 4-((4-aminophenyl)thio)-3-isobutylbenzeneamine, 4-((4-aminophenyl)thio)-2-isobutylbenzeneamine, 4-((4-aminophenyl)thio)-3-(trifluoromethyl)benzeneamine, 4-((4-aminophenyl)thio)-2-(trifluoromethyl)benzeneamine, 4-((4-aminophenyl)thio)-3-methoxybenzeneamine, 4-((4-aminophenyl)thio)-2-methoxybenzeneamine, 4-((4-aminophenyl)thio)-3-ethoxybenzeneamine, 4-((4-aminophenyl)thio)-2-ethoxybenzeneamine, 4-((4-aminophenyl)thio)-3-propoxybenzeneamine, 4-((4-aminophenyl)thio)-2-propoxybenzeneamine, 4-((4-aminophenyl)thio)-3-isopropoxybenzeneamine, 4-((4-aminophenyl)thio)-2-isopropoxybenzeneamine, 4-((4-aminophenyl)thio)-3-butoxybenzeneamine, 4-((4-aminophenyl)thio)-2-butoxybenzeneamine, 4-((4-aminophenyl)thio)-3-phenylbenzeneamine, 4-((4-aminophenyl)thio)-2-phenylbenzeneamine, 4-((4-aminophenyl) thio)-3-naphthylbenzeneamine, 4-((4-aminophenyl)thio)-2-naphthylbenzeneamine, 4-((4-aminophenyl)thio)-3-methoxyphenylbenzeneamine, 4-((4-aminophenyl)thio)-2-methoxyphenylbenzeneamine, 4-((4-aminophenyl)methyl)-3-methylbenzeneamine, 4-((4-aminophenyl)methyl)-2-methylbenzeneamine, 4-((4-aminophenyl)methyl)-3-ethylbenzeneamine, 4-((4-aminophenyl)methyl)-2-ethylbenzeneamine, 4-((4-aminophenyl)methyl)-3-propylbenzeneamine, 4-((4-aminophenyl)methyl)-2-propylbenzeneamine, 4-((4-aminophenyl)methyl)-3-isopropylbenzeneamine, 4-((4-aminophenyl)methyl)-2-isopropylbenzeneamine, 4-((4-aminophenyl)methyl)-3-butylbenzeneamine, 4-((4-aminophenyl) methyl)-2-butylbenzeneamine, 4-((4-aminophenyl)methyl)-3-isobutylbenzeneamine, 4-((4-aminophenyl)methyl)-2-isobutylbenzeneamine, 4-((4-aminophenyl)methyl)-3-(trifluoromethyl)benzeneamine, 4-((4-aminophenyl)methyl)-2-(trifluoromethyl)benzeneamine, 4-((4-aminophenyl)methyl)-3-methoxybenzeneamine, 4-((4-aminophenyl)methyl)-2-methoxybenzeneamine, 4-((4-aminophenyl)methyl)-3-ethoxybenzeneamine, 4-((4-aminophenyl)methyl)-2-ethoxybenzeneamine, 4-((4-aminophenyl)methyl)-3-propoxybenzeneamine, 4-((4-aminophenyl)methyl)-2-propoxybenzeneamine, 4-((4-aminophenyl)methyl)-3-isopropoxybenzeneamine, 4-((4-aminophenyl)methyl)-2-isopropoxybenzeneamine, 4-((4-aminophenyl)methyl)-3-butoxybenzeneamine, 4-((4-aminophenyl)methyl)-2-butoxybenzeneamine, 4-((4-aminophenyl)methyl)-3-phenylbenzeneamine, 4-((4-aminophenyl)methyl)-2-phenylbenzeneamine, 4-((4-aminophenyl)methyl)-3-naphthylbenzeneamine, 4-((4-aminophenyl)methyl)-2-naphthylbenzeneamine, 4-((4-aminophenyl) methyl)-3-methoxyphenylbenzeneamine, 4-((4-aminophenyl)methyl)-2-methoxyphenylbenzeneamine, (4-amino-2-methylphenyl)(4-aminophenyl)methanone, (4-amino-2-ethylphenyl)(4-aminophenyl)methanone, (4-amino-2-propylphenyl) (4-aminophenyl)methanone, (4-amino-2-isopropylphenyl) (4-aminophenyl)methanone, (4-amino-2-butylphenyl) (4-aminophenyl)methanone, (4-amino-2-(trifluoromethyl)phenyl)(4-aminophenyl)methanone, (4-amino-2-methoxyphenyl)(4-aminophenyl)methanone, (4-amino-2-ethoxyphenyl)(4-aminophenyl)methanone, (4-amino-2-(phenyl)phenyl) (4-aminophenyl)methanone, and (4-amino-2-(methoxyphenyl)phenyl) (4-aminophenyl)methanone.

Here, the polymer compound having the polyimide precursor having the structural unit represented by the general formula (5) can be obtained by, for example, a reaction between the tetracarboxylic acid diester compound represented by the general formula (15) and the diamine represented by the general formula (16) in the presence of a dehydrative condensation agent. That is, the tetracarboxylic acid diester compound represented by the general formula (15) is used for the reaction as a state of being dissolved in the above reaction solvent, a known dehydrative condensation agent (for example, dicyclohexylcarbodiimide, 1-ethoxycarbonyl-2-ethoxy-1,2-dihydroquinoline, 1,1-carbonyldioxy-di-1,2,3-benzotriazole, N,N'-disuccineimidiylcarbonate, etc.) is fed and mixed into this reaction solution under ice cooling to convert the tetracarboxylic acid diester compound represented by the general formula (15) into a polyacid anhydride, and then the diamine represented by the general formula (16) is separately dissolved or dispersed in a solvent and added dropwise thereinto for polycondensation to obtain the polymer compound having the polyimide precursor having the structural unit represented by the general formula (2).

Examples of another method for reacting the tetracarboxylic acid diester compound represented by the general formula (15) and the diamine compound represented by the general formula (16) to obtain the polymer compound having the polyimide precursor having the structural unit represented by the general formula (5) include a synthesis method of converting the tetracarboxylic acid diester compound represented by the general formula (15) into an acid chloride by using a chlorinating agent such as thionyl chloride or oxalyl dichloride, and reacting with the diamine represented by the general formula (16).

In the reaction of converting the aforementioned tetracarboxylic acid diester compound into the acid chloride by using the chlorinating agent, a basic compound may be used. As this basic compound, pyridine, 4-dimethylaminopyridine, triethylamine, etc. may be used, for example.

Then, the obtained acid chloride of the tetracarboxylic acid diester compound and the diamine represented by the general formula (16) are reacted in the presence of a basic catalyst to obtain the target polymer compound having the polyimide precursor having the structural unit represented by the general formula (5). Examples of the basic catalyst in this case include pyridine, dimethylaminopyridine, 1,8-diazabicyclo[5.4.0]undec-7-ene, and 1,5-diazabicyclo[4.3.0]non-5-ene.

Among the methods for producing the polymer compound having the polyimide precursor used for the negative-type photosensitive resin composition of the present invention, a solvent used in the method via the acid chloride is preferably a solvent that favorably dissolves the tetracarboxylic acid diester compound and the acid chloride thereof, and the polymer of the polyimide precursor obtained by the polycondensation reaction with the diamines, and a solvent same as the aforementioned solvents may be used. Specific examples thereof include N-methyl-2-pyrrolidone, N,N-dimethylacetamide, N,N-dimethylformamide, dimethyl sulfoxide, tetramethylurea, hexamethylphosphoric triamide, and γ-butyrolactone. As a solvent other than the polar solvents, ketones, esters, lactones, ethers, halogenated hydrocarbons, and hydrocarbons may also be used. Examples thereof include acetone, diethyl ketone, methyl ethyl ketone, methyl isobutyl ketone, cyclohexanone, methyl acetate, ethyl acetate, butyl acetate, diethyl oxalate, diethyl malonate, diethyl ether, ethylene glycol dimethyl ether, diethylene glycol dimethyl ether, tetrahydrofuran, dichloromethane, 1,2-dichloroethane, 1,4-dichlorobutane, trichloroethane, chlorobenzene, o-dichlorobenzene, hexane, heptane, octane, benzene, toluene, and xylene. These organic solvents may be used singly, or in combination of two or more thereof.

As noted above, the polymer compound having the polyimide precursor used for the negative-type photosensitive resin composition of the present invention may further have a structural unit represented by the following general formula (10) in addition to the structural unit represented by the general formula (5).

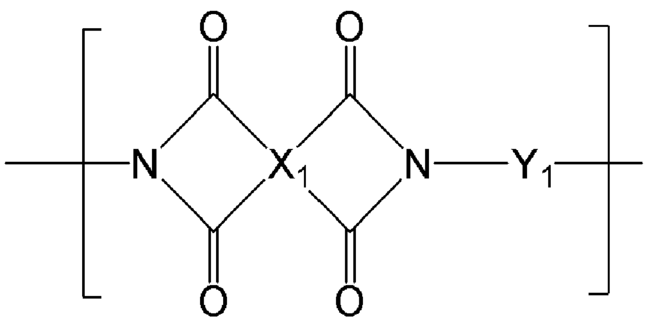

(10)

In the formula, $X_1$ and $Y_1$ are the same as above.

The polymer having the structural unit represented by the general formula (10) can be obtained by a reaction

between a tetracarboxylic dianhydride represented by the following general formula (19) and a diamine represented by the following general formula (20). First, the tetracarboxylic dianhydride represented by the following general formula (19) and the diamine represented by the following general formula (20) are reacted to synthesize an amidic acid, and then chemical imidization or imidization with heating dehydration is performed to obtain the polymer having the structural unit (10).

The structural unit (10) can be produced by: dissolving the diamine in a highly polar solvent having high boiling point, such as γ-butyrolactone and N-methyl-2-pyrrolidone; then adding the acid anhydride; performing the reaction at 0 to 80°C, preferably 10 to 50°C, to form the amidic acid; and then performing the imidization reaction by adding, for example, acetic anhydride and pyridine in the case of the chemical imidization or performing the imidization reaction by adding a non-polar solvent such as xylene and heating the mixture to 100 to 200°C, preferably 130 to 180°C, while removing water from the reaction system in the case of the imidization with heating dehydration.

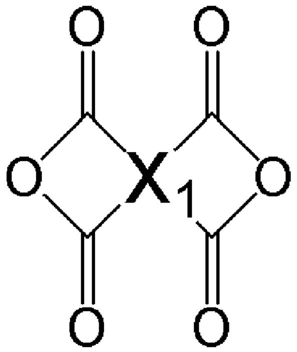

(19)

In the formula, $X_1$ is the same as above.

$$H_2N-Y_1-NH_2 \quad (20)$$

In the formula, $Y_1$ is the same as above.

Examples of the tetracarboxylic dianhydride represented by the general formula (19) include the examples described in the tetracarboxylic dianhydride represented by the general formula (17), as preferable examples.

Examples of the diamine represented by the general formula (20) include the examples described in the diamine represented by the general formula (16), as preferable examples.

As noted above, the polymer compound having the polyimide precursor used for the negative-type photosensitive resin composition of the present invention may further have a structural unit represented by the following general formula (11) in addition to the structural unit represented by the general formula (5).

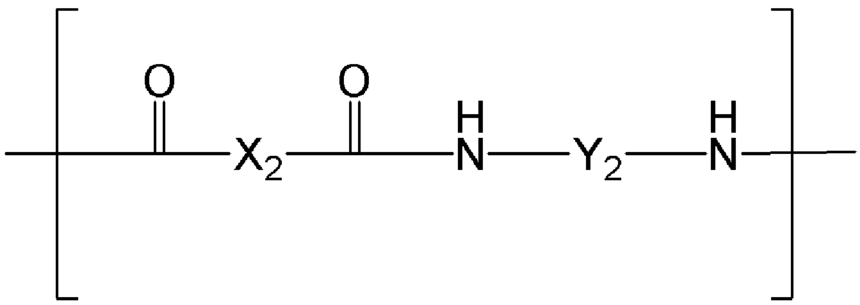

(11)

In the formula, $X_2$ and $Y_2$ are the same as above.

The polymer having the structural unit represented by the general formula (11) can be obtained in the reaction procedure same as for the structural unit (5). That is, the polymer can be obtained by: performing a reaction of a dicarboxylic acid compound represented by the following general formula (21) in the presence of a dehydrative condensation agent or a conversion reaction into an acid chloride by using a chlorinating agent; and then reacting the resultant with the diamine represented by the general formula (22).

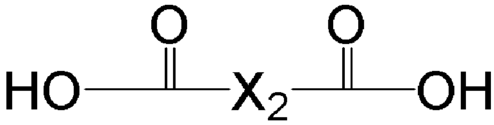

(2 1)

In the formula, $X_2$ is the same as above.

$$H_2N-Y_2-NH_2$$ (2 2)

In the formula, $Y_2$ is the same as above.

Examples of the dicarboxylic acid compound represented by the general formula (21) include malonic acid, dimethylmalonic acid, ethylmalonic acid, isopropylmalonic acid, di-n-butylmalonic acid, succinic acid, tetrafluorosuccinic acid, methylsuccinic acid, 2,2-dimethylsuccinic acid, 2,3-dimethylsuccinic acid, dimethylmethylsuccinic acid, glutaric acid, hexafluoroglutaric acid, 2-methylglutaric acid, 3-methylglutaric acid, 2,2-dimethylglutaric acid, 3,3-dimethylglutaric acid, 3-ethyl-3-methylglutaric acid, adipic acid, octafluoroadipic acid, 3-methyladipic acid, octafluoroadipic acid, pimelic acid, 2,2,6,6-tetramethylpimelic acid, suberic acid, dodecafluorosuberic acid, azelaic acid, sebacic acid, hexadecafluorosebacic acid, 1,9-nonanedioic acid, dodecanedioic acid, tridecanedioic acid, tetradecanedioic acid, pentadecanedioic acid, hexadecanedioic acid, heptadecanedioic acid, octadecanedioic acid, nonadecanedioic acid, icosanedioic acid, henicosanedioic acid, docosanedioic acid, tricosanedioic acid, tetracosanedioic acid, pentacosanedioic acid, hexacosanedioic acid, heptacosanedioic acid, octacosanedioic acid, nonacosanedioic acid, triacontanedioic acid, hentriacontanedioic acid, dotriacontanedioic acid, and diglycolic acid.

Furthermore, examples of the dicarboxylic acid compound having an aromatic ring include, but not limited to, phthalic acid, isophthalic acid, terephthalic acid, 4,4'-diphenyl ether dicarboxylic acid, 3,4'-diphenyl ether dicarboxylic acid, 3,3'-diphenyl ether dicarboxylic acid, 4,4'-biphenyldicarboxylic acid, 3,4'-bipenyldicarboxylic acid, 3,3'-biphenyldicarboxylic acid, 4,4'-benzophenonedicarboxylic acid, 3,4'-benzophenonedicarboxylic acid, 3,3'-benzophenonedicarboxylic acid, 4,4'-hexafluoroisopropylidene dibenzoic acid, 4,4'-dicarboxydiphenylamide, 1,4-phenylenediethanoic acid, bis(4-carboxyphenyl) sulfide, 2,2-bis(4-carboxyphenyl)-1,1,1,3,3,3-hexafluoropropane, bis(4-carboxyphenyl)tetraphenyldisiloxane, bis(4-carboxyphenyl)tetramethyldisiloxane, bis(4-carboxyphenyl) sulfone, bis(4-carboxyphenyl)methane, 5-tert-butylisophthalic acid, 5-bromoisophthalic acid, 5-fluoroisophthalic acid, 5-chloroisophthalic acid, 2,2-bis(p-carboxyphenyl)propane, and 2,6-naphthalenedicarboxylic acid. These may be used singly, or mixed for use.

Examples of the diamine represented by the general formula (22) include the examples described in the diamine represented by the general formula (16), as preferable examples.

As noted above, the polymer compound having the polyimide precursor used for the negative-type photosensitive resin composition of the present invention may further have a structural unit represented by the following general formula (12) in addition to the structural unit represented by the general formula (5).

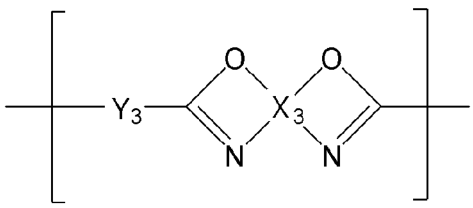

(12)

In the formula, $X_3$ and $Y_3$ are the same as above.

The polymer having the structural unit represented by the general formula (12) can be obtained by performing a converting reaction of a dicarboxylic acid compound represented by the following general formula (23) in the presence of a dehydrative condensation agent or by using a chlorinating agent to an acid chloride; then reacting the resultant with a dihydroxydiamine compound represented by the following general formula (24) to synthesize a hydroxyamide (a polyoxazole precursor); and then forming an oxazole ring via a heating dehydration step.

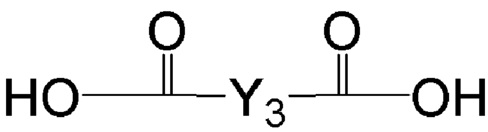

(2 3)

In the formula, $Y_3$ is the same as above.

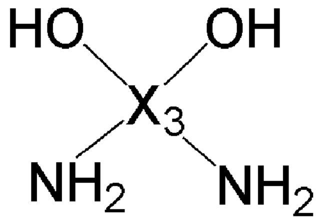

(24)

In the formula, $X_3$ is the same as above.

Examples of the dicarboxylic acid compound represented by the general formula (23) include the examples described in the dicarboxylic acid compound represented by the general formula (21), as preferable examples.

Examples of the dihydroxydiamine compound represented by the general formula (24) include, but not limited to, 3,3'-diamino-4,4'-dihydroxybiphenyl, 3,3'-diamino-4,4'-dihydroxybiphenyl ether, 2,2'-bis(3-amino-4-hydroxyphenyl) sulfide, 2,2'-bis(3-amino-4-hydroxyphenyl) ketone, 3,3'-diamino-4,4'-dihydroxyphenylmethane, 1,2-bis(3-amino-4-hydroxyphenyl) ethane, 2,2'-bis(3-amino-4-hydroxyphenyl)difluoromethane, 4,4'-(1,1,2,2,3,3-hexafluoro-1,3-propanediyl) bis(2-aminophenol), 2,2'-bis(3-amino-4-hydroxyphenyl)propane, 2,2'-bis(3-amino-4-hydroxyphenyl)hexafluoropropane, 2,2'-bis(3-amino-4-hydroxyphenyl) sulfone, 1,1-bis(3-amino-4-hydroxyphenyl)cyclohexane, 4,4'-(1,4-phenylenebis(oxy))bis(2-aminophenol), and 9,9-bis(3-amino-4-hydroxyphenyl)fluorene. These may be used singly, or mixed for use.

(Molecular Weight of Polymer and Introduction of End-Blocking Agent)

A preferable molecular weight of the polymer compound is preferably 5,000 to 100,000, and more preferably 7,000 to 50,000. The molecular weight of 5,000 or more facilitates film formation of the negative-type photosensitive resin composition of the present invention using the above polymer on the substrate with a desired film thickness. The molecular weight of 100,000 or less allows the negative-type photosensitive resin composition to have appropriate viscosity to cause no problem of film formation.

Both ends of the polymer may be blocked with an end-blocking agent for purposes of controlling the molecular weight in the polycondensation reaction and inhibiting change in the molecular weight of the obtained polymer with time, namely gelation. Examples of an end-blocking agent to react with the acid dianhydride include monoamines and monohydric alcohols. Examples of an end-blocking agent to react with the diamine compound include acid anhydrides, monocarboxylic acids, monoacid chloride compounds, mono-activated ester compounds, dicarbonate esters, and vinyl ethers. A reaction with the end-blocking agent can introduce various organic groups as an end group.

Examples of the monoamine used as the blocking agent for the end of the acid anhydride group include, but not limited to, aniline, 5-amino-8-hydroxyquinoline, 4-amino-8-hydroxyquinoline, 1-hydroxy-8-aminonaphthalene, 1-hydroxy-7-aminonaphthalene, 1-hydroxy-6-aminonaphthalene, 1-hydroxy-5-aminonaphthalene, 1-hydroxy-4-aminonaphthalene, 1-hydroxy-3-aminonaphthalene, 1-hydroxy-2-aminonaphthalene, 1-amino-7-hydroxynaphthalene, 2-hydroxy-7-aminonaphthalene, 2-hydroxy-6-aminonaphthalene, 2-hydroxy-5-aminonaphthalene, 2-hydroxy-4-aminonaphthalene, 2-hydroxy-3-aminonaphthalene, 1-amino-2-hydroxynaphthalene, 1-carboxy-8-aminonaphthalene, 1-carboxy-7-aminonaphthalene, 1-carboxy-6-aminonaphthalene, 1-carboxy-5-aminonaphthalene, 1-carboxy-4-aminonaphthalene, 1-carboxy-3-aminonaphthalene, 1-carboxy-2-aminonaphthalene, 1-amino-7-carboxynaphthalene, 2-carboxy-7-aminonaphthalene, 2-carboxy-6-aminonaphthalene, 2-carboxy-5-aminonaphthalene, 2-carboxy-4-aminonaphthalene, 2-carboxy-3-aminonaphthalene, 1-amino-2-carboxynaphthalene, 2-aminonicotinic acid, 4-aminonicotinic acid, 5-aminonicotinic acid, 6-aminonicotinic acid, 4-aminosalicylic acid, 5-aminosalicylic acid, 6-aminosalicylic acid, ammelide, 2-aminobenzoic acid, 3-aminobenzoic acid, 4-aminobenzoic acid, 2-aminobenzenesulfonic acid, 3-aminobenzenesulfonic acid, 4-aminobenzenesulfonic acid, 3-amino-4,6-dihydroxypyrimidine, 2-aminophenol, 3-aminophenol, 4-aminophenol, 5-amino-8-mercaptoquinoline, 4-amino-8-mercaptoquinoline, 1-mercapto-8-aminonaphthalene, 1-mercapto-7-aminonaphthalene, 1-mercapto-6-aminonaphthalene, 1-mercapto-5-aminonaphthalene, 1-mercapto-4-aminonaphthalene, 1-mercapto-3-aminonaphthalene, 1-mercapto-2-aminonaphthalene, 1-amino-7-mercaptonaphthalene, 2-mercapto-7-aminonaphthalene, 2-mercapto-6-aminonaphthalene, 2-mercapto-5-aminonaphthalene, 2-mercapto-4-aminonaphthalene, 2-mercapto-3-aminonaphthalene, 1-amino-2-mercaptonaphthalene, 3-amino-4,6-dimercaptopyrimidine, 2-aminothiophenol, 3-aminothiophenol, 4-aminothiophenol, 2-ethynylaniline, 3-ethynylaniline, 4-ethynylaniline, 2,4-diethynylaniline, 2,5-diethynylaniline, 2,6-diethynylaniline, 3,4-diethynylaniline, 3,5-diethynylaniline, 1-ethynyl-2-aminonaphthalene, 1-ethynyl-3-aminonaphthalene, 1-ethynyl-4-aminonaphthalene, 1-ethynyl-5-aminonaphthalene, 1-ethynyl-6-aminonaphthalene, 1-ethynyl-7-aminonaphthalene, 1-ethynyl-8-aminonaphthalene, 2-ethynyl-1-aminonaphthalene, 2-ethynyl-3-aminonaphthalene, 2-ethynyl-4-aminonaphthalene, 2-ethynyl-5-aminonaphthalene, 2-ethynyl-6-aminonaphthalene, 2-ethynyl-7-aminonaphthalene, 2-ethynyl-8-aminonaphthalene, 3,5-diethynyl-1-aminonaphthalene, 3,5-diethynyl-2-aminonaphthalene, 3,6-diethynyl-1-aminonaphthalene, 3,6-diethynyl-2-aminonaphthalene, 3,7-diethynyl-1-aminonaphthalene, 3,7-diethynyl-2-aminonaphthalene, 4,8-diethynyl-1-aminonaphthalene, 4,8-diethynyl-2-aminonaphthalene, 4-fluoroaniline, 3-fluoroaniline, 2-fluoroaniline, 2,4-difluoroaniline, 3,4-difluoroaniline, 2,4,6-trifluoroaniline, 2,3,4-trifluoroaniline, and pentafluoroaniline. These may be used singly, or in combination of two or more thereof.

Meanwhile, examples of the monohydric alcohol used as the blocking agent for the end of the acid anhydride group include, but not limited to, methanol, ethanol, 1-propanol, 2-propanol, 1-butanol, 2-butanol, 1-pentanol, 2-pentanol, 3-pentanol, 1-hexanol, 2-hexanol, 3-hexanol, 1-heptanol, 2-heptanol, 3-heptanol, 1-octanol, 2-octanol, 3-octanol, 1-nonanol, 2-nonanol, 1-decanol, 2-decanol, 1-undecanol, 2-undecanol, 1-dodecanol, 2-dodecanol, 1-tridecanol, 2-tridecanol, 1-tetradecanol, 2-tetradecanol, 1-pentadecanol, 2-pentadecanol, 1-hexadecanol, 2-hexadecanol, 1-heptadecanol, 2-heptadecanol, 1-octadecanol, 2-octadecanol, 1-nonadecanol, 2-nonadecanol, 1-icosanol, 2-methyl-1-propanol, 2-methyl-2-propanol, 2-methyl-1-butanol, 3-methyl-1-butanol, 2-methyl-2-butanol, 3-methyl-2-butanol, 2-propyl-1-pentanol, 2-ethyl-1-hexanol, 4-methyl-3-heptanol, 6-methyl-2-heptanol, 2,4,4-trimethyl-1-hexanol, 2,6-dimethyl-4-heptanol, isononyl alcohol, 3,7-dimethyl-3-octanol, 2,4-dimethyl-1-heptanol, 2-heptylundecanol, ethylene glycol monoethyl ether, ethylene glycol monomethyl ether, ethylene glycol monobutyl ether, propylene glycol 1-methyl ether, diethylene glycol monoethyl ether, diethylene glycol monomethyl ether, diethylene glycol monobutyl ether, cyclopentanol, cyclohexanol, cyclopentanemonomethylol, dicyclopentanemonomethylol, tricyclodecanemonomethylol, norborneol, and terpineol. These may be used singly, or may be used in combination of two or more thereof.

Examples of the acid anhydrides, the monocarboxylic acids, monoacid chloride compounds, and mono-activated ester compounds used as the blocking agent of the amino group end include: acid anhydrides such as phthalic anhydride, maleic anhydride, nadic anhydride, cyclohexanedicarboxylic anhydride, and 3-hydroxyphthalic anhydride; monocarboxylic acids such as 2-carboxyphenol, 3-carboxyphenol, 4-carboxyphenol, 2-carboxythiophenol, 3-carboxythiophenol, 4-carboxythiophenol, 1-hydroxy-8-carboxynaphthalene, 1-hydroxy-7-carboxynaphthalene, 1-hydroxy-6-carboxynaphthalene, 1-hydroxy-5-carboxynaphthalene, 1-hydroxy-4-carboxynaphthalene, 1-hydroxy-3-carboxynaphthalene, 1-hydroxy-2-carboxynaphthalene, 1-mercapto-8-carboxynaphthalene, 1-mercapto-7-carboxynaphthalene, 1-mercapto-6-carboxynaphthalene, 1-mercapto-5-carboxynaphthalene, 1-mercapto-4-carboxynaphthalene, 1-mercapto-3-carboxynaphthalene, 1-mercapto-2-carboxynaphthalene, 2-carboxybenzenesulfonic acid, 3-carboxybenzenesulfonic acid, 4-carboxybenzenesulfonic acid, 2-ethynylbenzoic acid, 3-ethynylbenzoic acid, 4-ethynylbenzoic acid, 2,4-diethynylbenzoic acid, 2,5-diethynylbenzoic acid, 2,6-diethynylbenzoic acid, 3,4-diethynylbenzoic acid, 3,5-diethynylbenzoic acid, 2-ethynyl-1-naphthoic acid, 3-ethynyl-1-naphthoic acid, 4-ethynyl-1-naphthoic acid, 5-ethynyl-1-naphthoic acid, 6-ethynyl-1-naphthoic acid, 7-ethynyl-1-naphthoic acid, 8-ethynyl-1-naphthoic acid, 2-ethynyl-2-naphthoic acid, 3-ethynyl-2-naphthoic acid, 4-ethynyl-2-naphthoic acid, 5-ethynyl-2-naphthoic acid, 6-ethynyl-2-naphthoic acid, 7-ethynyl-2-naphthoic acid, and 8-ethynyl-2-naphthoic acid, and monoacid chloride compounds in which a carboxy group in these acids forms an acid chloride; monoacid chloride compounds in which only a monocarboxy group in dicarboxylic acids, such as terephthalic acid, phthalic acid, maleic acid, cyclohexanedicarboxylic acid, 3-hydroxyphthalic acid, 5-norbornene-2,3-dicarboxylic acid, 1,2-dicarboxynaphthalene, 1,3-dicarboxynaphthalene, 1,4-dicarboxynaphthalene, 1,5-dicarboxynaphthalene, 1,6-dicarboxynaphthalene, 1,7-dicarboxynaphthalene, 1,8-dicarboxynaphthalene, 2,3-dicarboxynaphthalene, 2,6-dicarboxynaphthalene, and 2,7-dicarboxynaphthalene, forms an acid chloride; and mono-activated ester compounds obtained by a reaction between the monoacid chloride compound and N-hydroxybenzotriazole or N-hydroxy-5-norbornene-2,3-dicarboxyimide.

Examples of the dicarbonate ester compound used as the blocking agent for the amino group end include: di-tert-butyl dicarbonate, dibenzyl dicarbonate, dimethyl dicarbonate, and diethyl dicarbonate.

Examples of the vinyl ether compound used as the blocking agent for the amino group end include: butyl vinyl ether, cyclohexyl vinyl ether, ethyl vinyl ether, 2-ethylhexyl vinyl ether, isobutyl vinyl ether, isopropyl vinyl ether, n-propyl vinyl ether, tert-butyl vinyl ether, and benzyl vinyl ether.

Examples of other compounds used as the blocking agent for the amino group end include: benzoyl chloride; chloroformate esters such as fluorenylmethyl chloroformate, 2,2,2-trichloroethyl chloroformate, tert-butyl chloroformate, n-butyl chloroformate, isobutyl chloroformate, benzyl chloroformate, allyl chloroformate, ethyl chloroformate, and isopropyl chloroformate; isocyanate compounds such as butyl isocyanate, 1-naphthyl isocyanate, octadecyl isocyanate, and phenyl isocyanate; and methanesulfonic chloride and p-toluenesulfonic chloride.

An introducing proportion of the blocking agent for the acid anhydride group end is preferably within a range of 0.1 to 60 mol%, particularly preferably 5 to 50 mol%, and further preferably 5 to 20 mol% relative to a total amount of the tetracarboxylic dianhydride component and the dicarboxylic acid component. An introducing proportion of the blocking agent for the amino group end is preferably within a range of 0.1 to 100 mol%, and particularly preferably 5 to 90 mol% relative to the diamine component. A plurality of different end groups may be introduced by reactions of a plurality of the end blocking agents.

Component (D)

Next, the organic compound of the component (D) of the present invention, represented by the following general formula (1), will be described.

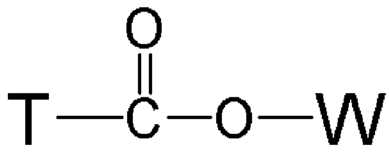

(1)

In the formula, T represents any one structure of the following general formulae (2) to (4), and W represents an alkyl group or an aryl group that are optionally substituted with an alkoxy group having 4 to 15 carbon atoms.

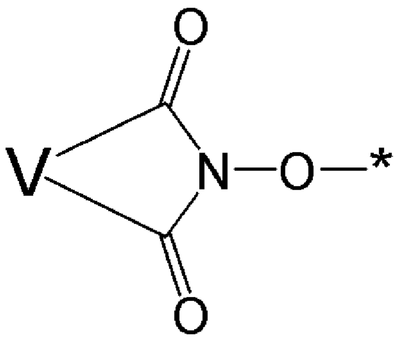

(2)

In the formula, V represents a divalent organic group, and "*" represents a bond.

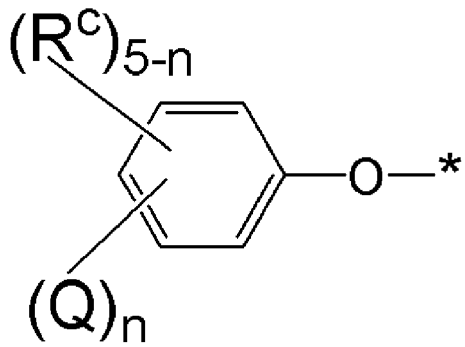

(3)

In the formula, Q represents a halogen atom or a nitro group, $R^C$ represents a hydrogen atom, a linear, branched, or cyclic alkyl group having 1 to 15 carbon atoms, or an aryl group having 6 to 15 carbon atoms. "n" represents an integer of 3 to 5 when Q represents the halogen atom or represents 1 when Q represents the nitro group. "*" represents a bond.

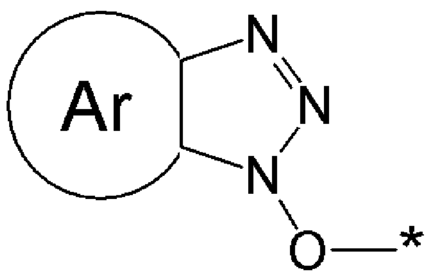

(4)

In the formula, Ar represents a substituted or unsubstituted aromatic cyclic structure or a heterocyclic structure having a heteroatom, and "*" represents a bond.

Among these, the general formula (2) preferably represents a structure represented by the following general

formula (2-1).

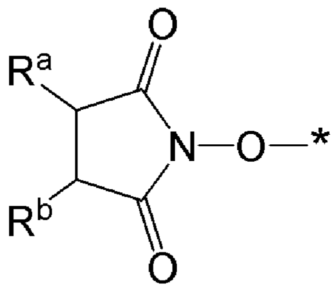

(2－1)

In the formula, $R^a$ and $R^b$ represent a hydrogen atom, a linear, branched, or cyclic alkyl group having 1 to 15 carbon atoms, or an aryl group having 6 to 15 carbon atoms, $R^a$ and $R^b$ are optionally bonded to each other to form a ring together with a carbon atom to which $R^a$ and $R^b$ are bonded. "*" represents a bond.

Preferable examples of a case where the general formula (2) in the general formula (1) of the component (D) represents organic compounds or structures represented by the general formula (2) or (2-1) include structures of the following general formulae (2-2) and (2-3).

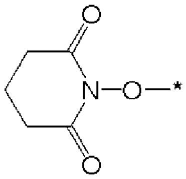
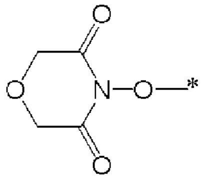
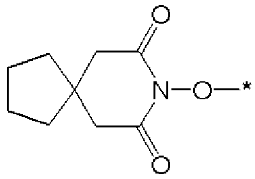
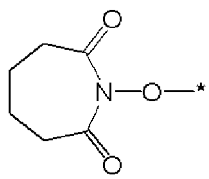

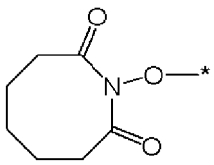
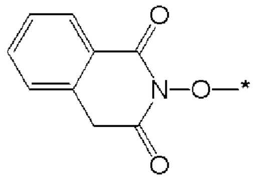
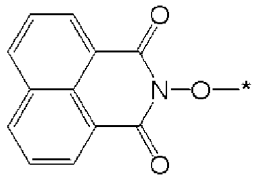

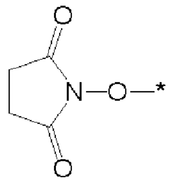
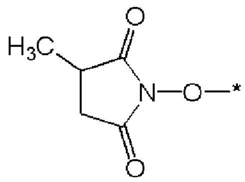
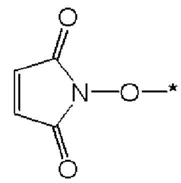
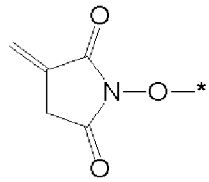

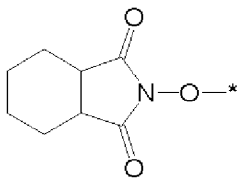
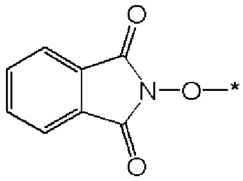
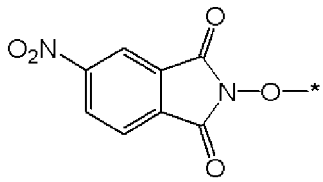

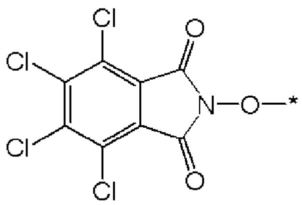
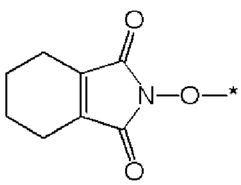
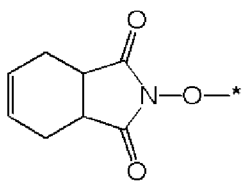

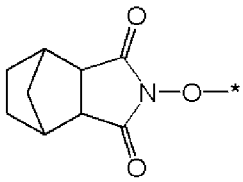
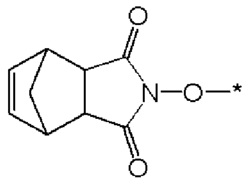

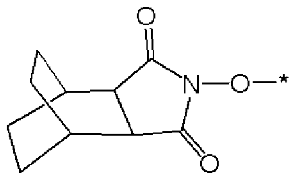
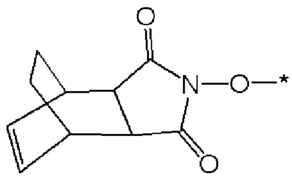

(2 − 2)

In the formulae, "*" represents a bond.

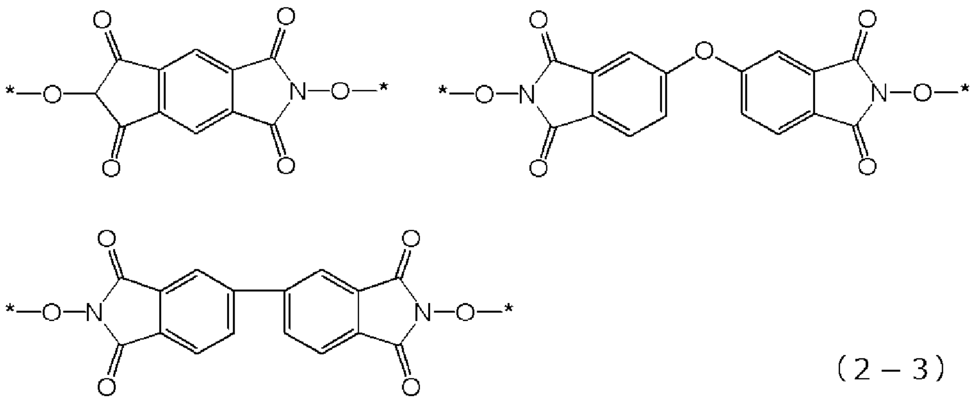

(2 - 3)

In the formulae, "*" represents a bond.

Next, organic compounds in which T in the general formula (1) of the component (D) contains a structure represented by the following general formula (3) will be described.

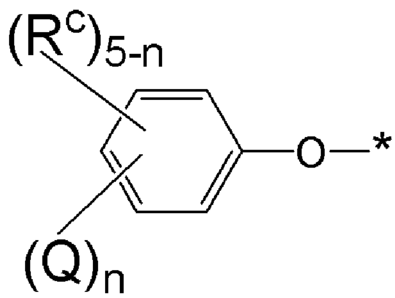

(3)

In the formula, Q represents a halogen atom or a nitro group, $R^C$ represents a hydrogen atom, a linear, branched, or cyclic alkyl group having 1 to 15 carbon atoms, or an aryl group having 6 to 15 carbon atoms. "n" represents an integer of 3 to 5 when Q represents the halogen atom or represents 1 when Q represents the nitro group. "*" represents a bond.

Examples of a preferable structure in which T in the general formula (1) of the component (D) is the general formula (3) include the following general formula (3-4).

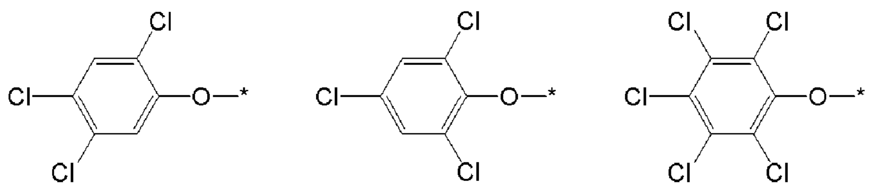

(3 - 4)

In the formulae, "*" represents a bond.

Further, the general formula (3) preferably represents a structure represented by the following formula (3-1) or (3-2).

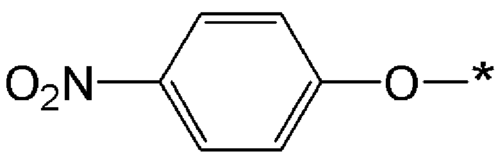

(3-1)

In the formula, "*" represents a bond.

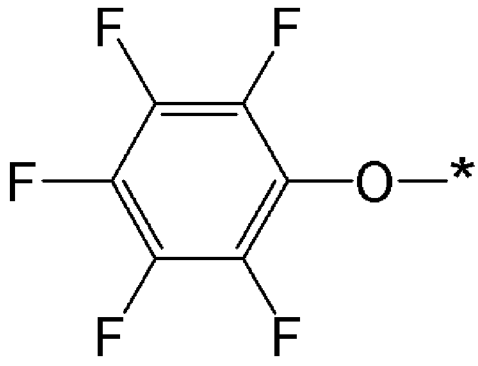

(3-2)

In the formula, "*" represents a bond.

Among the general formula (1) of the component (D), the organic compounds in which T represented by the general formula (3) is represented by the following general formula (3-1) or (3-2) are further preferable examples because of easy availability of the raw materials, safety of the compounds, low toxicity, etc.

When the general formula (3) represents the structure represented by the general formula (3-1) or (3-2), the hydroxyl group of 4-nitrophenol or pentafluorophenol, which is the activated esterifying agent to enhance the imidization reaction, is protected with the aforementioned tert-butoxycarbonyl group (Boc group) or benzyloxycarbonyl protective group (Z group), which yields better storage stability of the photosensitive resin composition containing the polyimide precursor resin.

Next, organic compounds in which T in the general formula (1) of the component (D) contains a structure represented by the following general formula (4) will be described.

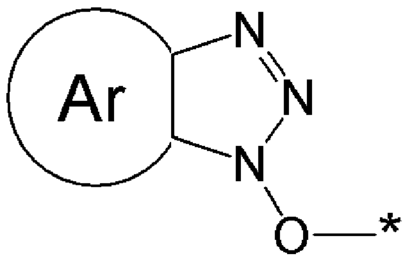

(4)

In the formula, Ar represents a substituted or unsubstituted aromatic cyclic structure or a heterocyclic structure having a heteroatom, and "*" represents a bond.

Examples of a preferable structure in which T in the general formula (1) of the component (D) is the general formula (4) include the following general formula (4-2).

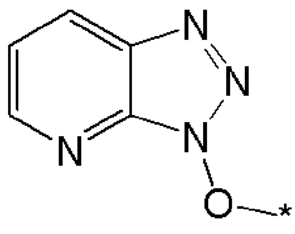

(4-2)

In the formulae, "*" represents a bond.

Further, T represented by the general formula (4) in the general formula (1) of the component (D) preferably represents a structure represented by the following general formula (4-1).

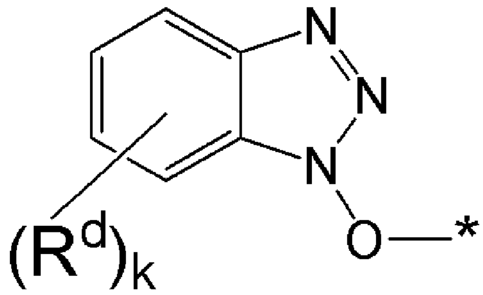

(4−1)

In the formula, $R^d$ represents a linear, branched, or acyclic alkyl group having 1 to 15 carbon atoms and optionally having a halogen atom, or an aryl group having 6 to 15 carbon atoms, and "k" represents an integer of 0 to 4. "*" represents a bond.

Examples of a specific structure in which T in the general formula (1) of the component (D) represents the general formula (4-1) specifically include structures represented by the following general formula (4-3).

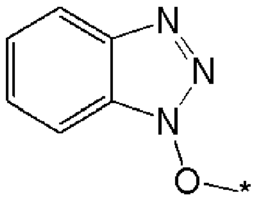

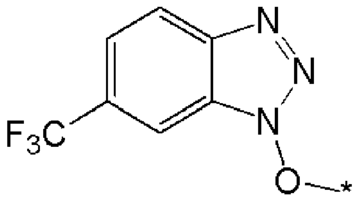

(4 − 3)

In the formulae, "*" represents a bond.

The organic compound in which T in the general formula (1) of the component (D) represents the structure represented by the general formula (4-3) is further preferable because the raw material is easily available and storage stability of the negative-type photosensitive resin composition of the present invention containing this organic compound hardly deteriorates.

Next, W in the general formula (1) of the component (D) will be described. W in the general formula (1) of the component (D) preferably represents a tert-butyl group. The case where W represents a tert-butyl group describes a compound in which the organic compound represented by the general formula (1) is protected with a tert-butoxycarbonyl group (an N-Boc group). The tert-butoxycarbonyl group (the N-Boc group) is deprotected at within a range of 100°C to 150°C in the heating step for the curing reaction to generate an activated esterifying agent, which is a hydroxy compound that can enhance the imide ring-closing reaction, and therefore, imidization at 200°C or lower can be achieved.

Further, in this case, W in the general formula (1) of the component (D) preferably represents a benzyl group. The case where W represents a benzyl group describes a compound in which the organic compound represented by the general formula (1) is protected with a benzyloxycarbonyl protective group (a Z group). The benzyloxycarbonyl protective group (the Z group) is deprotected at within a range of 120°C to 190°C in the heating step for the curing reaction to generate an activated esterifying agent, which is a hydroxy compound that can enhance the imide ring-closing reaction, and therefore, imidization at 200°C or lower can be achieved.

Examples of further preferable organic compounds represented by the formula (1) include the following compounds.

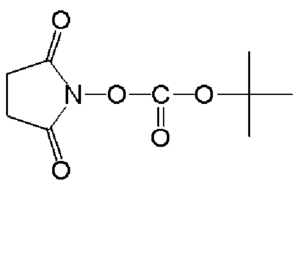

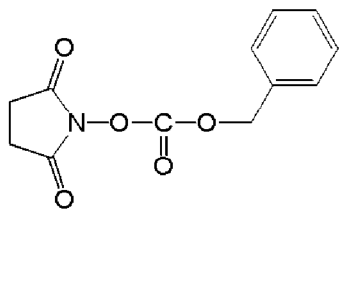

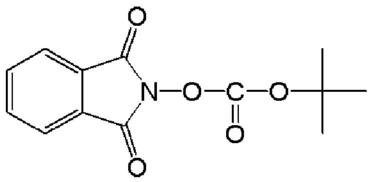

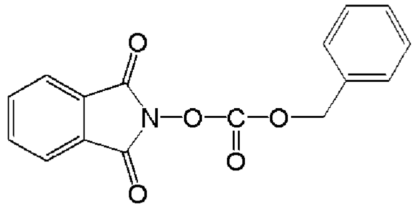

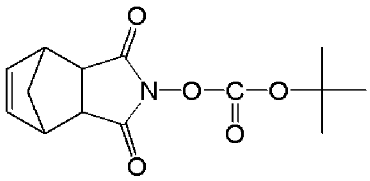

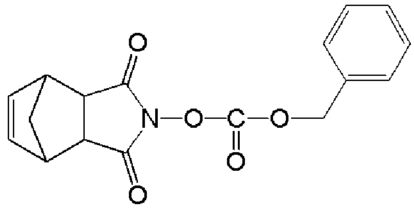

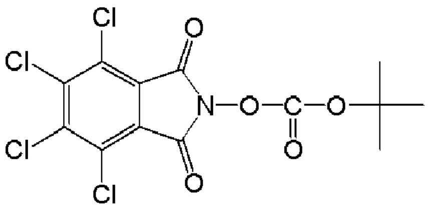

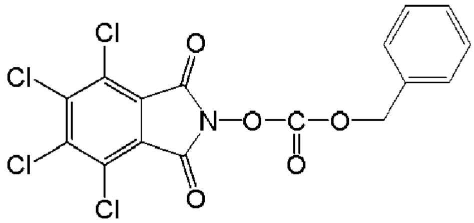

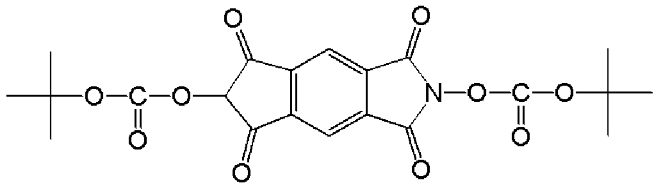

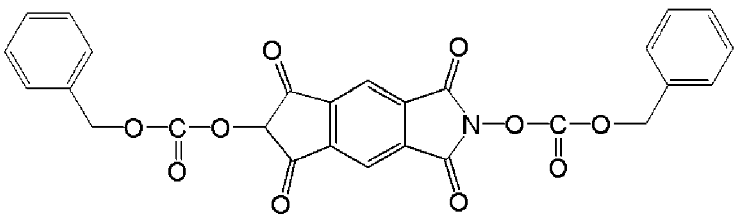

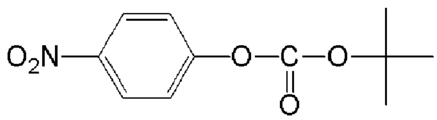

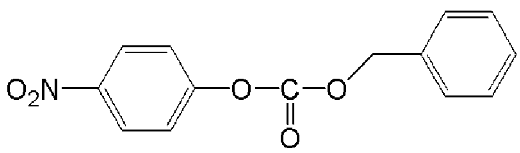

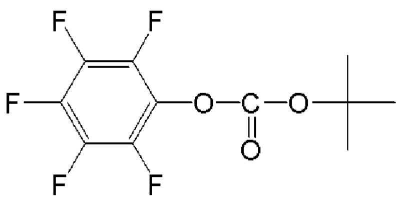

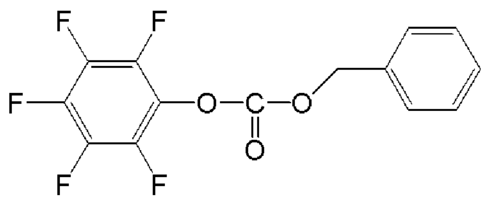

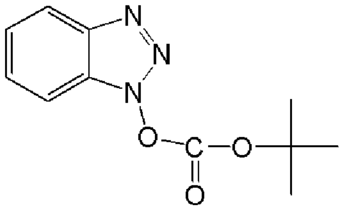

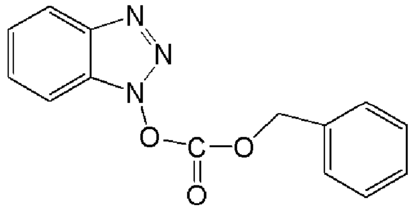

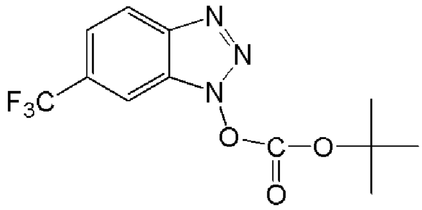

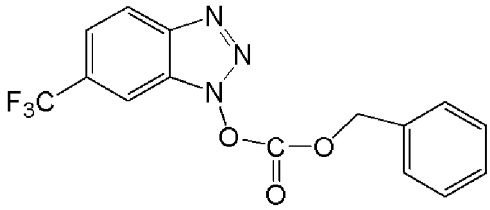

The above organic compounds can be suitably used because the organic compounds are easily available as the component (D) of the negative-type photosensitive resin composition of the present invention or because the raw materials of the organic compounds are easily available.

The organic compound represented by the general formula (1) can be obtained by, for example, a method described by the following reaction formula, but not limited thereto.

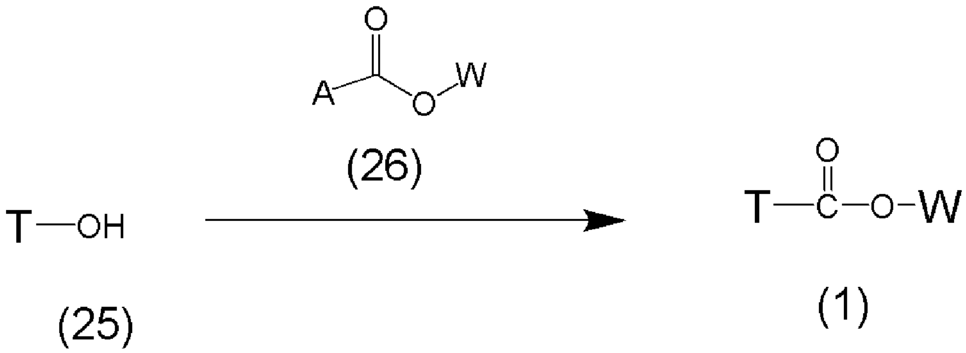

(26)

(25)

(1)

In the formula, T and W are the same as above. A represents a halogen atom or a group represented by the following formula (27).

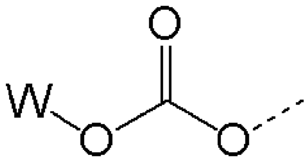

(27)

Here, a broken line represents an attachment point. W is the same as above.

Further specifically, when T in the general formula (1) being the organic compound of the component (D) is the general formula (2) or (2-1), the organic compound can be obtained by methods represented by the following reaction formulae.

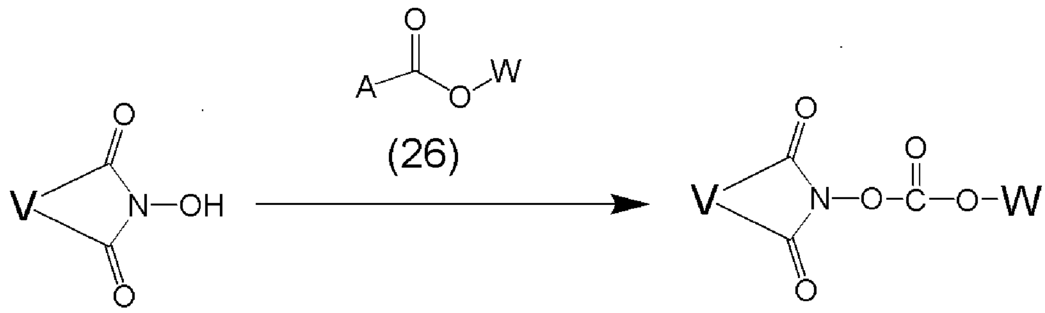

(25-2) (1-2)

In the formula, V, W, and A are the same as above.

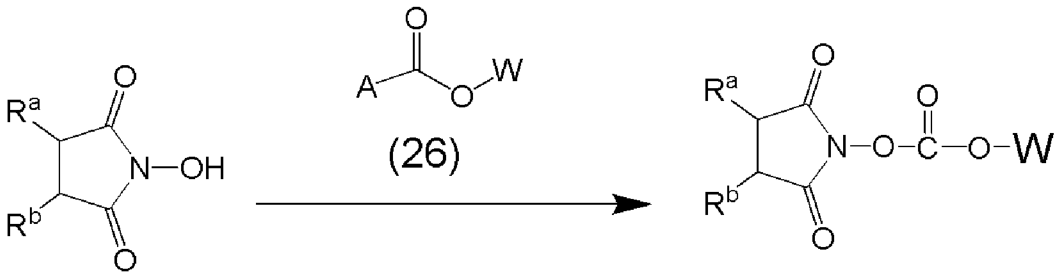

(25-2-1) (1-2-1)

In the formula, W, A, $R^a$, and $R^b$ are the same as above.

Further specifically, when T in the general formula (1) being the organic compound of the component (D) represents the general formula (3), (3-1), or (3-2), the organic compound can be obtained by methods represented by the following reaction formulae.

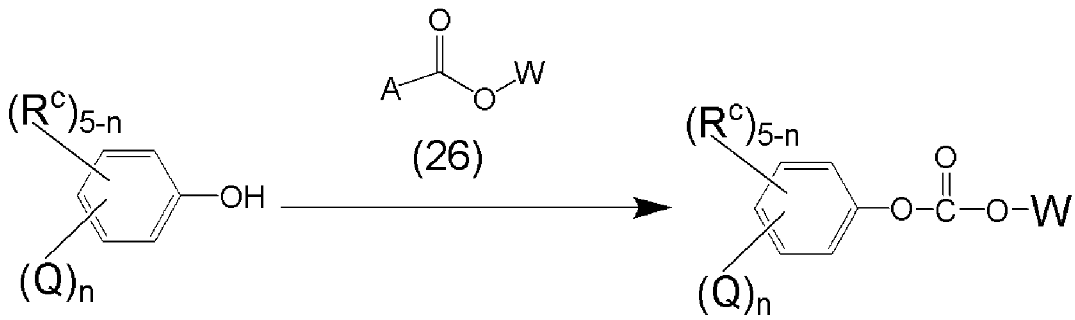

(25-3) (1-3)

In the formula, Q, W, and A are the same as above.

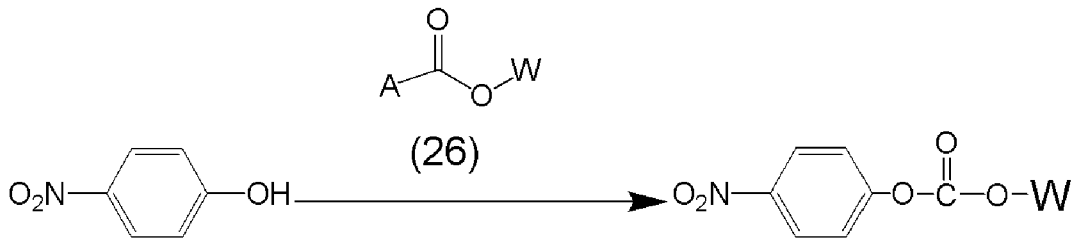

(26)

(25-3-1) (1-3-1)

In the formula, Q, W, and A are the same as above.

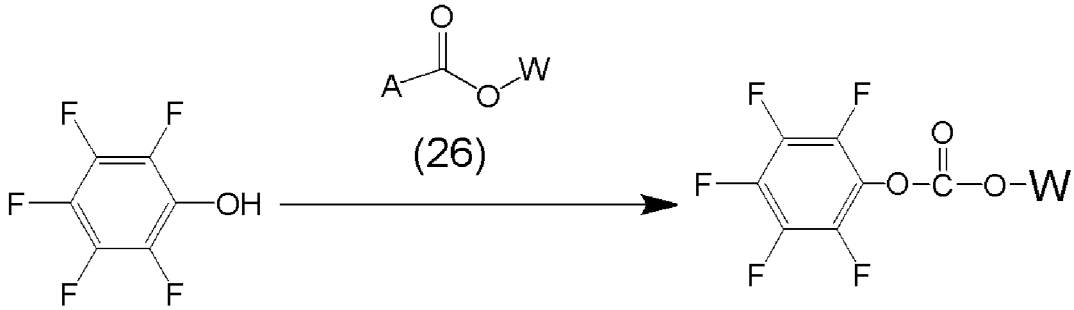

(26)

(25-3-2) (1-3-2)

In the formula, W and A are the same as above.

Further specifically, when T in the general formula (1) being the organic compound of the component (D) represents the general formula (4), (4-1), or (4-2), the organic compound can be obtained by methods represented by the following reaction formulae.

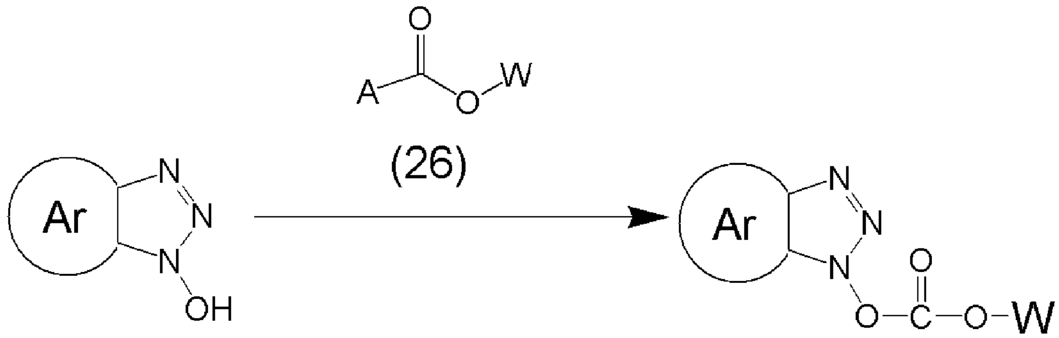

(26)

(25-4) (1-4)

In the formula, Ar, W, and A are the same as above.

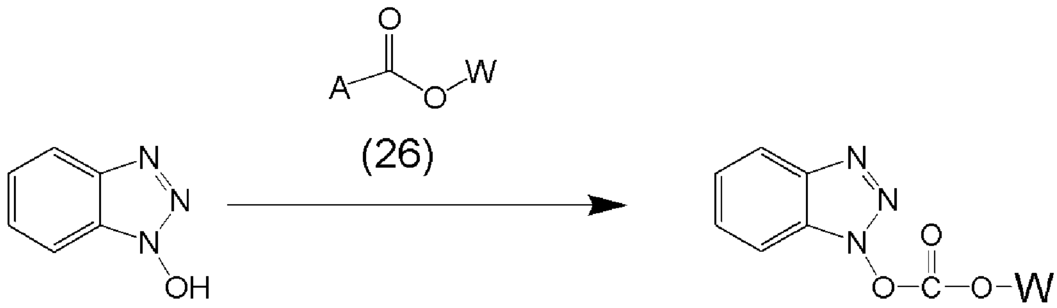

(26)

(25-4-1)

(1-4-1)

In the formula, W and A are the same as above.

The organic compound of the general formula (1) of the component (D) in the negative-type photosensitive resin composition of the present invention can be obtained by: a reaction between a hydroxy compound having the structure of T in the general formula (1) in the above reaction formulae, represented by the general formulae (25), (25-2), (25-2-1), (25-3), (25-3-1), (25-3-2), (25-4), and (25-4-1) and halo-carbonate esters (compounds in which A in the formula (26) represents a halogen atom in the above reaction formulae); or a reaction between a hydroxy compound having the structure of T in the general formula (1) in the above reaction formulae, represented by the general formulae (25), (25-2), (25-2-1), (25-3), (25-3-1), (25-3-2), (25-4), and (25-4-1) and dicarbonate diesters (compounds in which A represents the above formula (27), in the above reaction formulae).

Among the organic compounds of the general formula (1) of the component (D) in the negative-type photosensitive resin composition of the present invention, the organic compound in which W represents a tert-butyl group can be obtained by a reaction between a hydroxy compound having the structure of T in the general formula (1) in the above reaction formulae, represented by the general formulae (25), (25-2), (25-2-1), (25-3), (25-3-1), (25-3-2), (25-4), and (25-4-1) and di-tert-butyl dicarbonate (a compound in which A in the formula (26) represents the formula (27) and W represents a tert-butyl group, in the above reaction formulae).

Among the organic compounds of the general formula (1) of the component (D) in the negative-type photosensitive resin composition of the present invention, the organic compound in which W represents a benzyl group can be obtained by: a reaction between a hydroxy compound having the structure of T in the general formula (1) in the above reaction formulae, represented by the general formulae (25), (25-2), (25-2-1), (25-3), (25-3-1), (25-3-2), (25-4), and (25-4-1) and a benzyloxycarbonyl halide (a compound in which A in the formula (26) represents a halogen atom and W represents a benzyl group, in the above reaction formulae); or a reaction between a hydroxy compound having the structure of T in the general formula (1) in the above reaction formulae, represented by the general formulae (25), (25-2), (25-2-1), (25-3), (25-3-1), (25-3-2), (25-4), and (25-4-1) and a dibenzyl carbonate (a compound in which A in the formula (26) represents the formula (27) and W represents a benzyl group, in the above reaction formulae).

The reaction to obtain the organic compound of the above general formula (1) being the component (D) of the negative-type photosensitive resin composition of the present invention is favorably performed by, in a case of using the hydroxy compound having the structure of T in the general formula (1) in the above reaction formulae, represented by the general formulae (25), (25-2), (25-2-1), (25-3), (25-3-1), (25-3-2), (25-4), and (25-4-1) and the halocarbonate esters, sequentially or simultaneously adding the hydroxy compound, the corresponding halocarbonate ester such as benzyl chlorocarbonate and 4-methoxybenzyl chlorocarbonate, and a base such as triethylamine, pyridine, 2,6-lutidine, and N,N-dimethylaniline in the absence of a solvent or in a solvent such as methylene chloride, acetonitrile, diethyl ether, tetrahydrofuran, N,N-dimethylformamide, toluene, and hexane, with cooling or heating as necessary.

The reaction to obtain the organic compound of the above general formula (1) being the component (D) of the negative-type photosensitive resin composition of the present invention is favorably performed by, in a case of using the hydroxy compound having the structure of T in the general formula (1) in the above reaction formulae, represented by the general formulae (25), (25-2), (25-2-1), (25-3), (25-3-1), (25-3-2), (25-4), and (25-4-1) and the dicarbonate diesters, sequentially or simultaneously adding the hydroxy compound, the carbonate diesters, and a base such as triethylamine, pyridine, 2,6-lutidine, and N,N-dimethylaniline in a solvent such as methylene chloride, acetonitrile, diethyl ether, tetrahydrofuran, N,N-dimethylformamide, toluene, and hexane, with cooling or heating as necessary.

A use amount of the halocarbonate ester or the carbonate diesters represented in the above reaction formula (26) is, although variously depending on the conditions, for example, 1.0 to 5.0 mol, and particularly desirably 1.0 to 2.0 mol relative to 1 mol of the hydroxy compound being the raw material. A use amount of the base is, although variously depending on the conditions, for example, 0 to 5.0 mol, and particularly desirably 0 to 2.0 mol relative to 1 mol of the hydroxy

compound being the raw material. The reaction is desirably completed by monitoring the reaction by gas chromatography (GC) or silica-gel thin layer chromatography (TCL) in terms of the yield, and the reaction time is typically about 0.5 to 24 hours. The target organic compound being the component (D) in the negative-type photosensitive resin composition of the present invention, represented by the general formula (1), can be obtained by a common aqueous treatment from the reaction mixture, and may be purified according to a normal method such as distillation, chromatography, and recrystallization, as necessary. Alternatively, without the aqueous after-treatment, the reaction liquid may be purified after filtering a salt generated by the reaction or may be directly purified.

Meanwhile, the organic compound of the component (D) is preferably contained at 1 to 10 parts by mass relative to 100 parts by mass of the component (A). When the amount of the organic compound of the component (D) is 10 parts by mass or less, the added organic compound of the component (D) does not act as a plasticizer, does not cause deformation of the formed pattern due to heat, namely thermal flow, and does not impair the patterning. After the curing, the glass transition temperature (Tg.) of the obtained cured film is not lowered. The glass transition temperature (Tg.) of the obtained cured film is required to be high because durability against heat in a step of producing an electronic component formed by using an interlayer insulating film or a surface protecting film using the obtained cured film is required.

The constitution of the negative-type photosensitive resin composition of the present invention is a negative-type photosensitive resin composition including:

(A) a polymer compound having a polyimide precursor structure;
(C) a photopolymerization initiator;
(D) an organic compound represented by a general formula (1); and
(E) a solvent.

(A) the polymer compound having the polyimide precursor structure and (D) the organic compound represented by the general formula (1) have been described above. Next, (C) the photopolymerization initiator will be described.

Component (C)

As (C) the photopolymerization initiator, compounds conventionally used as a photopolymerization initiator for UV curing may be freely selected. Examples thereof preferably include, but not limited to: benzophenone derivatives such as benzophenone, methyl o-benzoylbenzoate, 4-benzoyl-4'-methyldiphenyl ketone, dibenzyl ketone, and fluorenone; acetophenone derivatives such as 2,2'-diethoxyacetophenone, 2-hydroxy-2-methylpropiophenone, and 1-hydroxycyclohexyl phenyl ketone; thioxanthone derivatives such as thioxanthone, 2-methylthioxanthone, 2-isopropylthioxanthone, and diethylthioxanthone; benzil derivatives such as benzil, benzil dimethyl ketal, and benzil-β-methoxyethyl acetal; benzoin derivatives such as benzoin and benzoin methyl ether; oximes such as 1-phenyl-1,2-butanedione-2-(O-methoxycarbonyl) oxime, 1-phenyl-1,2-propanedione-2-(O-ethoxycarbonyl) oxime, 1-phenyl-1,2-propanedione-2-(O-benzoyl) oxime, 1,3-diphenylpropanetrione-2-(O-ethoxycarbonyl) oxime, and 1-phenyl-3-ethoxypropanetrione-2-(O-benzoyl) oxime; N-arylglycines such as N-phenylglycine; peroxides such as benzoyl perchloride; and aromatic biimidazoles. These may be used singly, or two or more thereof may be mixed for use. Among (C) the above photopolymerization initiators, oximes are more preferable particularly in terms of photosensitivity.

A blending amount of (C) the photopolymerization initiator is 0.1 part by mass to 20 parts by mass relative to 100 parts by mass of the polymer having the structural unit of the polyimide precursor of the present invention being (A) the base resin, and preferably 2 parts by mass to 15 parts by mass from the viewpoint of a photosensitive property. Blending (C) the photopolymerization initiator at 0.1 part by mass or more relative to 100 parts by mass of (A) the base resin allows the photosensitive resin composition to have excellent photosensitivity, and blending (C) the photopolymerization initiator at 20 parts by mass or less allows the photosensitive resin composition to have excellent thick-film curability.

Component (E)

Next, (E) the solvent in the negative-type photosensitive resin composition of the present invention will be described.

An organic solvent that can be selected is not limited as long as the organic solvent dissolves (A) the base resin, (C) the photopolymerization initiator, and (D) the organic compound represented by the general formula (1). Examples of (E) the solvent include: ketones such as cyclohexanone, cyclopentanone, and methyl-2-n-amyl ketone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, propylene glycol mono-tert-butyl ether acetate, and γ-butyrolactone. One or more of them may be used. Particularly, ethyl lactate, cyclohexanone, cyclopentanone, propylene glycol monomethyl ether acetate, γ-butyrolactone, or a mixed solvent thereof is preferable.

A blending amount of the solvent is preferably 50 to 2,000 parts by mass, and particularly preferably 100 to 1,000 parts by mass relative to 100 parts by mass of a total of blending amounts of a total of (A) the base resin and (C) the photopolymerization initiator.

Component (B)

The negative-type photosensitive resin composition of the present invention preferably further contains (B) a polymerizable compound having two or more ethylenically unsaturated groups.

As above, containing the crosslinking agent having two or more photopolymerizable unsaturated bonds in one molecule can enhance crosslinking due to photopolymerization of the component (A) in the exposed portion to improve contrast between the exposed portion and unexposed portion.

(B) the polymerizable compound having two or more ethylenically unsaturated groups is preferably a (meth)acryl compound, and preferably, for example, ethylene glycol diacrylate, ethylene glycol dimetacrylate, polyethylene glycol diacrylate (in which a number of ethylene glycol units is 2 to 20), polyethylene glycol dimethacrylate (in which a number of ethylene glycol units is 2 to 20), poly(1,2-propylene glycol) diacrylate, poly(1,2-propylene glycol) dimethacrylate, 1,6-hexanediol diacrylate, neopentyl glycol diacrylate, pentaerythritol diacrylate, trimethylolpropane triacrylate, pentaerythritol triacrylate, dipentaerythritol hexaacrylate, tetramethylolpropane tetraacrylate, tetraethylene glycol diacrylate, 1,6-hexanediol dimethacrylate, neopentyl glycol dimethacrylate, pentaerythritol dimethacrylate, trimethylolpropane trimethacrylate, pentaerythritol trimethacrylate, dipentaerythritol hexamethacrylate, tetramethylolpropane tetramethacrylate, glycerol diacrylate, glycerol dimethacrylate, methylene bisacrylamide, N-methylol acrylamide, ethylene glycol diglycidyl ether methacrylic acid adduct, glycerol diglycidyl ether acrylic acid adduct, bisphenol A diglycidyl ether acrylic acid adduct, bisphenol A diglycidyl ether methacrylic acid adduct, N,N'-bis(2-methacryloyloxyethyl)urea, etc., but not limited thereto.

(B) the polymerizable compound having two or more ethylenically unsaturated groups is preferably blended at 1 to 100 parts by mass, and further preferably within a range of 3 to 50 parts by mass relative to 100 parts by mass of the polymer compound having the structural unit of the polyimide precursor of the present invention. A blending amount of out of the range of 1 to 100 parts by mass may fail to obtain the target effect, and may cause an unpreferable effect on developability. As the copolymerizable monomer, one type of compound may be used, or a plurality of types may be mixed for use.

Component (F)

The negative-type photosensitive resin composition of the present invention may further contain, as (F) a thermal crosslinking agent, one or two or more (F) crosslinking agents selected from: an amino condensate modified with formaldehyde or with formaldehyde and an alcohol; a phenol compound having two or more methylol groups or alkoxymethylol groups in average in one molecule; a compound in which hydrogen atoms of hydroxy groups in a polyhydric phenol are substituted with glycidyl groups; a compound in which hydrogen atoms of hydroxy groups in a polyhydric phenol or of hydroxy groups in a polyhydric alcohol are substituted with a substituent represented by the following formula (F-1); and a compound having two or more nitrogen atoms having a glycidyl group, represented by the following formula (F-2).

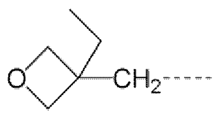
(F-1)

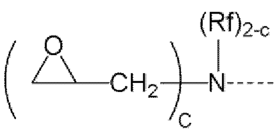
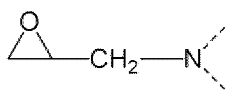
(F-2)

In the formula, a broken line represents an attachment point, Rf represents a linear, branched, or cyclic alkyl group having 1 to 6 carbon atoms, and "c" represents 1 or 2.

Examples of the amino condensate modified with formaldehyde or with formaldehyde and an alcohol include: a melamine condensate modified with formaldehyde or with formaldehyde and an alcohol; or a urea condensate modified with formaldehyde or with formaldehyde and an alcohol.

As the preparation of the melamine condensate modified with formaldehyde or with formaldehyde and an

alcohol, for example, a melamine monomer is subjected to methylolation and modified with formalin according to a known method, or this modified product is further alkoxylated and modified with an alcohol to prepare a modified melamine represented by the following general formula (23). The alcohol is preferably a lower alcohol, for example, an alcohol having 1 to 4 carbon atoms.

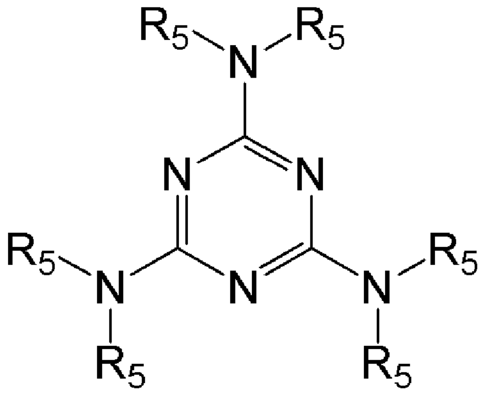

(2 3)

In the formula $R_5$, which may be same as or different from each other, represents a methylol group, an alkoxymethyl group having an alkoxy group having 1 to 4 carbon atoms, or a hydrogen atom, and at least one of them represents the methylol group or the alkoxymethyl group.
Examples of the $R_5$ include a methylol group, alkoxymethyl groups such as a methoxymethyl group and an ethoxymethyl group, and a hydrogen atom.

Specific examples of the modified melamine represented by the general formula (23) include trimethoxymethylmonomethylolmelamine, dimethoxymethylmonomethylolmelamine, trimethylolmelamine, hexamethylolmelamine, and hexamethoxymethylolmelamine. Then, the modified melamine represented by the general formula (23) or a multimer thereof (for example, an oligomer form such as a dimer or a trimer) is subjected to addition-condensation polymerization with formaldehyde according to a common method until a desired molecular weight to obtain the melamine condensate modified with formaldehyde or with formaldehyde and an alcohol.

As the preparation of the urea condensate modified with formaldehyde or with formaldehyde and an alcohol, for example, a urea condensate having a desired molecular weight is subjected to methylolation and modified with formaldehyde according to a known method, or this modified product is further alkoxylated and modified with an alcohol.

Specific examples of the urea condensate modified with formaldehyde or with formaldehyde and an alcohol include methoxymethylated urea condensate, ethoxymethylated urea condensate, and propoxymethylated urea condensate.

One or two or more of these modified melamine condensates and modified urea condensates may be mixed for use.

Next, examples of the phenol compound having two or more methylol groups or alkoxymethylol groups in average in one molecule include (2-hydroxy-5-methyl)-1,3-benzenedimethanol, 2,2',6,6'-tetramethoxymethylbisphenol A, and compounds represented by the following formulae (F-3) to (F-8).

(F-3)

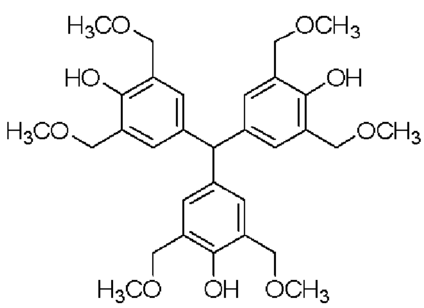

(F-4)

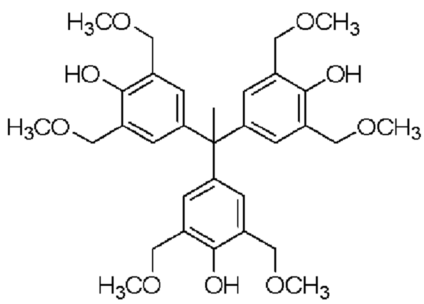

(F-5)

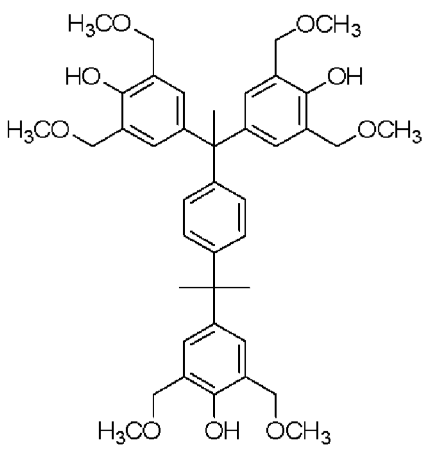

(F-6)

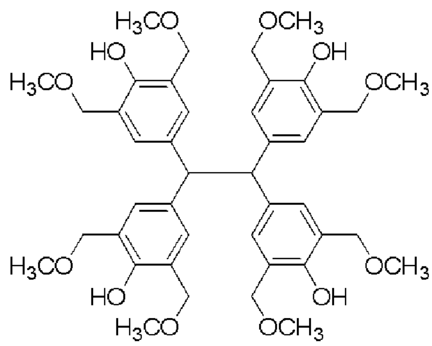

(F-7)

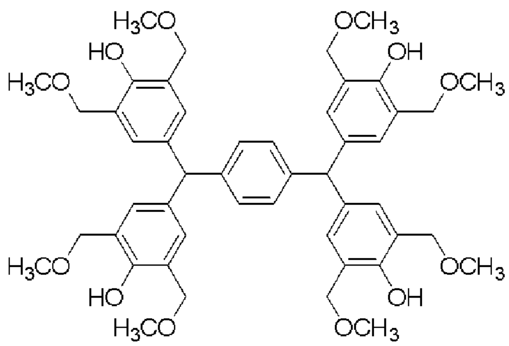

(F-8)

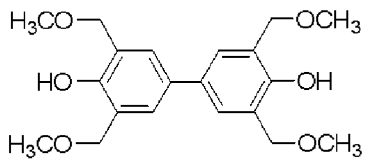

The crosslinking agent may be used singly or in combination of two or more thereof.

Meanwhile, examples of the compound in which hydrogen atoms of hydroxy groups in a polyhydric phenol are substituted with glycidyl groups include compounds obtained by a reaction of hydroxy groups in bisphenol A, tris(4-hydroxyphenyl)methane, or 1,1,1-tris(4-hydroxyphenyl) ethane with epichlorohydrin in the present of a base. Preferable examples of the compound in which hydrogen atoms of hydroxy groups in a polyhydric phenol are substituted with glycidyl groups include compounds represented by the following formulae (F-9) to (F-15).

(F-9)

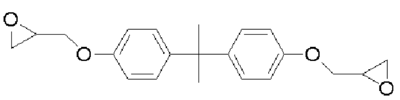

(F-10)

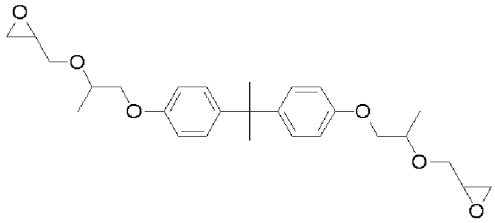

(F-11)

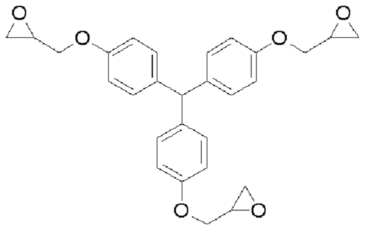

(F-12)

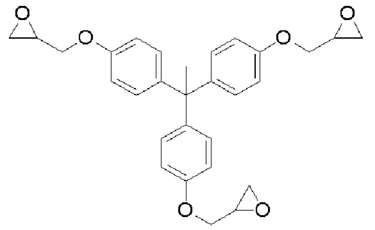

(F-13)

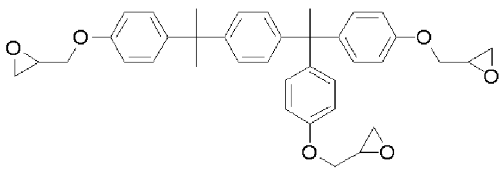

(F-14)

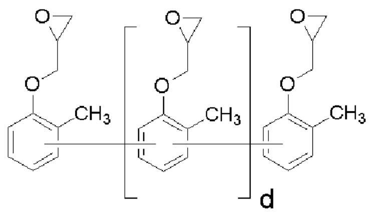

(F-15)

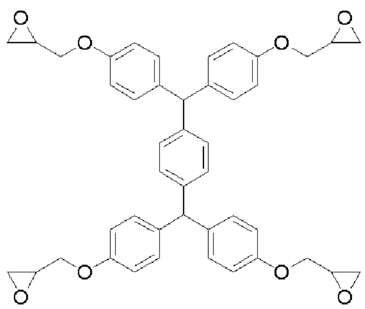

In the formula, "d" satisfies 2 ≤ d ≤ 3.

Further, preferable examples of the compounds other than the formulae (F-9) to (F-15) include EPICLON 850-S, EPICLON HP-4032, EPICLON HP-7200, EPICLON HP-820, EPICLON HP-4700, EPICLON EXA-4710, EPICLON HP-4770, EPICLON EXA-859CRP, EPICLON EXA-4880, EPICLON EXA-4850, EPICLON EXA-4816, and EPICLON EXA-4822 (the above are trade names, available from DIC Corporation); RIKARESIN BPO-20E and RIKARESIN BEO-60E (the above are trade names, available from New Japan Chemical Co., Ltd.); EP-4003S, EP-4000S, EP-4000S, and EP-4000L (the above are trade names available from ADEKA CORPORATION); and jER828EL and YX7105 (the above are trade names, available from Mitsubishi Chemical Corporation).

One or two or more of these compounds in which hydroxy groups in a polyhydric phenol are substituted with glycidoxy groups (the compounds in which hydrogen atoms of hydroxy groups in a polyhydric phenol are substituted with glycidyl groups) may be used as the crosslinking agent.

Examples of the compound in which hydrogen atoms of hydroxy groups in a polyhydric phenol are substituted with substituents represented by the following formula (F-1) include compounds having two or more of the substituent, represented by the following formula (F-16).

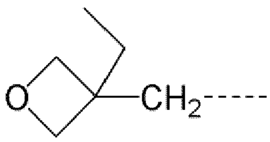

(F-1)

In the formula, a broken line represents a bond.

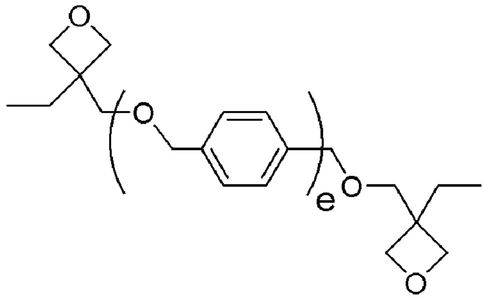

(F-16)

In the formula, "e" satisfies $1 \leq e \leq 3$.

Further, preferable examples of the compound other than the formula (F-9) to (F-16) include 3-ethyl-3-hydroxymethyloxetane 1,4-bis{[(3-ethyl-3-oxetanyl)methoxy]methyl}benzene, 3-ethyl-3-(2-ethylhexylmethyl)oxetane, 1,4-benzenedicarboxylic acid bis[(3-ethyl-3-oxetanyl)methyl] ester, and ARON OXETANE series, available from TOAGOSEI CO., LTD.

Meanwhile, examples of the compound having two or more nitrogen atoms having a glycidyl group, represented by the following formula (F-2), include compounds represented by the following formula (F-17).

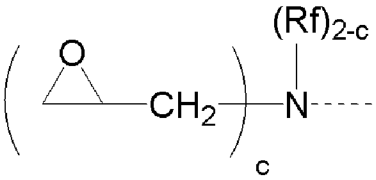

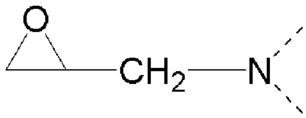

(F-2)

In the formulae, a broken line represents an attachment point, Rf represents a linear, branched, or cyclic alkyl group having 1 to 6 carbon atoms, and "c" represents 1 or 2.

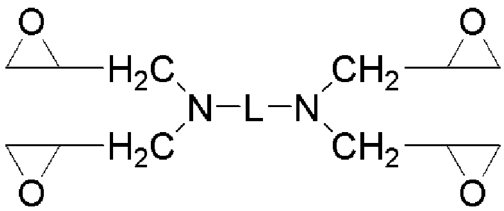

(F-17)

In the formula, L represents a linear, branched, or cyclic alkylene group having 2 to 12 carbon atoms, or a divalent aromatic group. L herein is applied only in the above formula.

Examples of the compound represented by the formula (F-17) include compounds represented by the following formulae (F-18) to (F-21).

(F-18)

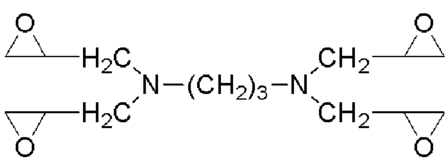

(F-19)

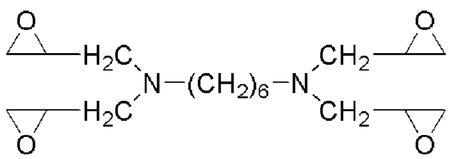

(F-20)

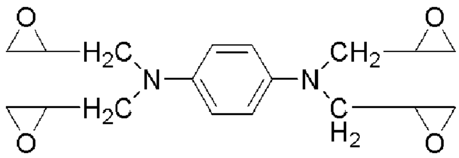

(F-21)

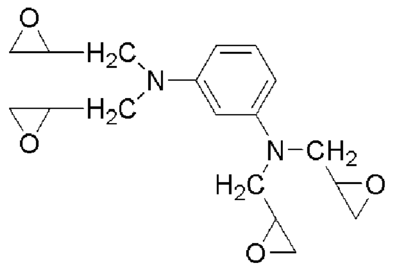

Meanwhile, as the compound having two or more nitrogen atoms having a glycidyl group, represented by the following formula (F-2), compounds represented by the following formulae (F-22) and (F-23) may be suitably used.

(F-22)

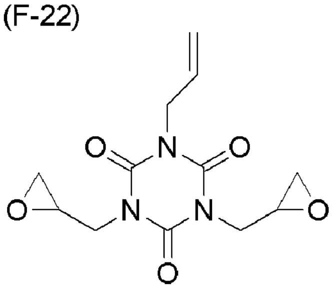

(F-23)

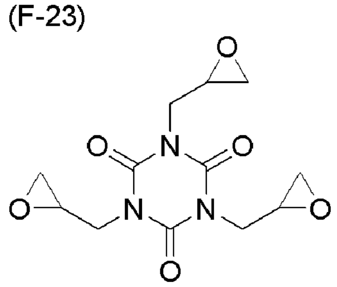

One or two or more of these compounds having two or more nitrogen atoms having a glycidyl group, represented by the following formula (F-2), may be used as the crosslinking agent.

The epoxy group has large strain of the ring and high reactivity, and the oxetane has high basicity to be easily bonded to an acid. It has been reported that combination of the oxetanyl group with the epoxy group remarkably improves reactivity of cation polymerization.

The component (F) is a component that causes the crosslinking reaction in post-curing, after patterning with the negative-type photosensitive resin composition of the present invention, to further increase strength of the cured product. The weight-average molecular weight of the component (F) as above is preferably 150 to 10,000, and particularly preferably 200 to 3,000 from the viewpoints of photo-curability and heat resistance.

A blending amount of the component (F) is preferably 0.5 to 100 parts by mass, and particularly preferably 1 to 80 parts by mass relative to 100 parts by mass of the component (A) in the negative-type photosensitive resin composition of the present invention.

Component (G)

The negative-type photosensitive resin composition of the present invention preferably further contains (G) an antioxidant. Containing the antioxidant of the component (G) can inhibit undesired crosslinking between the components (A) or between the component (A) and the component (B) in patterning to improve the contrast. Due to the antirust effect on a metal material, the component (G) can inhibit metal oxidation caused by external moisture, the photoacid generator, the thermal acid generator, etc. and adhesiveness deterioration or peeling involved therewith.

Specific examples of the usable (G) antioxidant preferably include hindered-phenol-type antioxidants, phosphorus-type antioxidants, and sulfur-type antioxidants. (G) the antioxidant is not limited thereto. These (G) antioxidants may be used singly or in combination of two or more thereof.

Among the specific examples of (G) the antioxidant, examples of the hindered-phenol-type antioxidant include pentaerythritol tetrakis[3-(3,5-di-tert-butyl-4-hydroxyphenyl)propionate] (BASF Japan Ltd., Irganox 1010 (trade name)), thiodiethylene bis[3-(3,5-di-tert-butyl-4-hydroxyphenyl)propionate] (BASF Japan Ltd., Irganox 1035 (trade name)), octadecyl [3-(3,5-di-tert-butyl-4-hydroxyphenyl)propionate] (BASF Japan Ltd., Irganox 1076 (trade name)), octyl-1-3,5-di-tert-butyl-4-hydroxyhydrocinnamic acid (BASF Japan Ltd., Irganox 1135 (trade name)), 4,6-bis(octylthiomethyl-o-cresol) (BASF Japan Ltd., Irganox 1520L), SUMILIZER GA80 (available from Sumitomo Chemical Co., Ltd., trade name), ADK STAB AO-20 (available from ADEKA CORPORATION, trade name), ADK STAB AO-30 (available from ADEKA CORPORATION, trade name), ADK STAB AO-40 (available from ADEKA CORPORATION, trade name), ADK STAB AO-50 (available from ADEKA CORPORATION, trade name), ADK STAB AO-60 (available from ADEKA CORPORATION, trade name), ADK STAB AO-80 (available from ADEKA CORPORATION, trade name), ADK STAB AO-330

(available from ADEKA CORPORATION, trade name), and hindered-phenol-type antioxidants described in WO 2017/188153 A1.

Among the specific examples of (G) the antioxidant, examples of the phosphorus-type antioxidant include triphenylphosphite, tris(methylphenyl)phosphite, triisooctylphosphite, tridecylphosphite, tris(2-ethylhexyl)phosphite, tris(nonylphenyl)phosphite, tris(octylphenyl)phosphite, tris[decylpoly(oxyethylene)]phosphite, tris(cyclohexylphenyl) phosphite, tricyclohexylphosphite, tri(decyl)thiophosphite, triisodecylthiophosphite, phenyl-bis(2-ethylhexyl)phosphite, phenyl-diisodecylphosphite, tetradecylpoly(oxyethylene)-bis(ethylphenyl)phosphite, phenyl-dicyclohexylphosphite, phenyl-diisooctylphosphite, phenyl-di(tridecyl)phosphite, diphenyl-cyclohexylphosphite, diphenyl-isooctylphosphite, diphenyl-2-ethylhexylphosphite, diphenyl-isodecylphosphite, diphenyl-cyclohexylphenylphosphite, and diphenyl-(tridecyl) thiophosphite.

Among the specific examples of (G) the antioxidant, examples of the sulfur-type antioxidant include ADK STAB AO-412S (available from ADEKA CORPORATION, trade name), AO-503S (available from ADEKA CORPORATION, trade name), and SUMILIZER TP-D (available from Sumitomo Chemical Co., Ltd., trade name).

The sulfur-type antioxidant and the phosphorus-type antioxidant are expected to yield an effect of decomposing a peroxide.

A content of (G) the antioxidant is preferably 0.1 to 10 parts by mass, and more preferably 0.2 to 5 parts by mass relative to 100 parts by mass of the polymer of the component (A). The content of 0.1 part by mass or more improves adhesiveness to the metal material and inhibits peeling. The content of 10 parts by mass or less does not deteriorate developability of the composition and toughness of the cured coating.

Component (H)

The negative-type photosensitive resin composition of the present invention preferably further contains (H) a silane compound. The negative-type photosensitive resin composition of the present invention preferably contains a metal-adhesiveness improver for improving adhesiveness to the metal material used for an electrode, wiring, etc. Examples of the metal-adhesiveness improver include the silane compound.

Examples of the silane compound include compounds described in paragraph 0167 of WO 2015-199219 A1, compounds described in paragraphs 0062 to 0073 of JP 2014-191002 A, compounds described in paragraphs 0063 to 0071 of WO 2011-080992 A1, compounds described in paragraphs 0060 to 0061 of JP 2014-191252 A, compounds described in paragraphs 0045 to 0052 of JP 2014-041264 A, and compounds described in paragraph 0055 of WO 2014-097594 A1. As described in paragraphs 0050 to 0058 of JP 2011-128358 A, two or more different silane coupling agents are also preferably used.

(H) the silane compound usable here is not particularly limited, but preferably has an alkoxysilyl group. Specific preferable examples include followings: γ-glycidoxypropyltriethoxysilane, γ-glycidoxypropyltrimethoxysilane, 2-(3,4-epoxycyclohexyl)ethyltrimethoxysilane, bis(2-hydroxyethyl)-3-aminopropyl-triethoxysilane, γ-aminopropyltrimethoxysilane, γ-aminopropyltriethoxysilane, vinyltriethoxysilane, vinyltrimethoxysilane, γ-methacryloxypropyltrimethoxysilane, γ-acryloxypropyltrimethoxysilane, 3-mercaptopropyltrimethoxysilane, 3-isocyanatepropyltriethoxysilane, bis(2-hydroxyethyl)-3-aminopropyltriethoxysilane, triethoxysilylpropyl ethylcarbamate, 3-(triethoxysilyl)propylsuccinic anhydride, phenyltriethoxysilane, phenyltrimethoxysilane, N-phenyl-3-aminopropyltrimethoxysilane, 3-triethoxysilyl-N-(1,3-dimethylbutylidene)propylamine, amide-group-containing silane compounds described in JP 6414060 B, thiourea-group-containing silane compounds described in WO 2016/140024 A1 and JP 5987984 B, and thiol-group-containing silane compounds described in JP 2017-044964 A. (H) the silane compound is not limited thereto. Further, these (H) silane compounds may be used singly or in combination of two or more thereof.

As the silane coupling agent, compounds represented by the following formulae (H-1) to (H-7) are also preferably used.

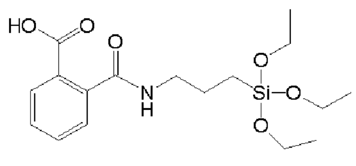

( H-1 )

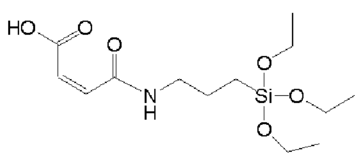

( H-2 )

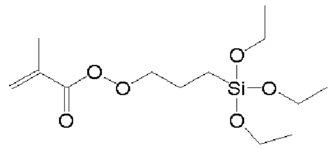

( H-3 )

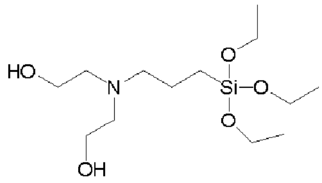

( H-4 )

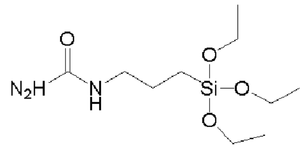

( H-5 )

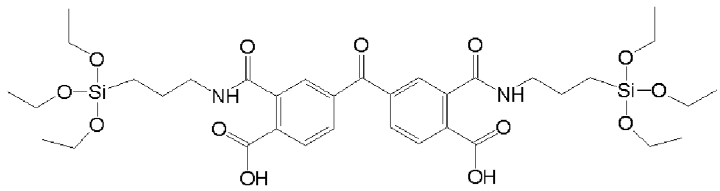

( H-6 )

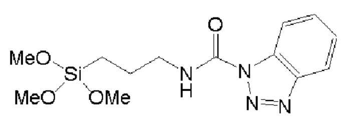

( H-7 )

A content of (H) the silane compound being the metal-adhesiveness improver is preferably 0.1 to 30 parts by mass, more preferably within a range of 0.5 to 15 parts by mass, and further preferably within a range of 0.5 to 5 parts by mass relative to 100 parts by mass of the polymer compound having the structural unit of the polyimide precursor used for the negative-type photosensitive resin composition of the present invention. Setting the content to be the lower limit or more yields good adhesiveness between the cured film and the metal layer after the curing step, and setting the content to be the upper limit or less yields good heat resistance and mechanical properties of the cured film after the curing step. (H) the silane compound of the metal-adhesiveness improver may be one type or two or more types. When two or more thereof are used, a total content thereof is preferably within the above range.

Component (I)

In the present invention, (I) a polymerization inhibitor is preferably further contained. As (I) the polymerization inhibitor, a thermal polymerization inhibitor may be added in order to improve stability of viscosity and photosensitivity of the composition solution during storage. As the thermal polymerization inhibitor, known materials may be used without departing from the spirit of the present invention. An example thereof includes hydroquinone, N-nitrosodiphenylamine, p-tert-butylcatechol, phenothiazine, N-phenylnaphthylamine, ethylenediamine tetraacetate, 1,2-cyclohexanediamine tetraacetate, glycol ether diamine tetraacetate, 2,6-di-tert-butyl-p-methylphenol, 5-nitroso-8-hydroxyquinoline, 1-nitroso-2-naphthol, 2-nitroso-1-naphthol, 2-nitroso-5-(N-ethyl-N-sulfopropylamino)phenol, N-nitroso-N-phenylhydroxylamine ammonium salt, and N-nitroso-N-(1-naphthyl)hydroxylamine ammonium salt. An amount of (I) the polymerization inhibitor added in the negative-type photosensitive resin composition of the present invention is preferably within a range of 0.005 to 5 parts by mass relative to 100 parts by mass of the polymer compound having the structural unit of the polyimide precursor used in the negative-type photosensitive resin composition of the present invention.

Others

The negative-type photosensitive resin composition of the present invention may further contain components other than (A) the polymer compound having the polyimide precursor structure, (C) the photopolymerization initiator, and (D) the organic compound represented by the general formula (1). Examples of the other components include (J) a sensitizer, (K) a migration inhibitor, and (L) a surfactant.

Examples of (J) the sensitizer include Michler's Ketone, 4,4'-bis(diethylamino)benzophenone, 2,5-bis(4'-diethylaminobenzal)cyclopentane, 2,6-bis(4'-diethylaminobenzal)cyclohexanone, 2,6-bis(4'-diethylaminobenzal)-4-methylcyclohexanone, 4,4'-bis(dimethylamino)chalcone, 4,4'-bis(diethylamino)chalcone, p-dimethylaminocinnamylideneindanone, p-dimethylaminobenzylideneindanone, 2-(p-dimethylaminopheylbiphenylene)-benzothiazole, 2-(p-dimethylaminophenylvinylene)benzothiazole, 2-(p-dimethylaminophenylvinylene)isonaphthothiazole, 1,3-bis(4'-dimethylaminobenzal)acetone, 1,3-bis(4'-diethylaminobenzal)acetone, 3,3'-carbonyl-bis(7-diethylaminocoumarin), 3-acetyl-7-dimethylaminocoumarin, 3-ethoxycarbonyl-7-dimethylaminocoumarin, 3-benzyloxycarbonyl-7-dimethylaminocoumarin, 3-methoxycarbonyl-7-diethylaminocoumarin, 3-ethoxycarbonyl-7-diethylaminocoumarin, N-phenyl-N'-ethylethanolamine, N-phenyldiethanolamine, N-p-tolyldiethanolamine, N-phenylethanolamine, 4-morpholinobenzophenone, isoamyl dimethylaminobenzoate, isoamyl diethylaminobenzoate, 2-mercaptobenzimidazole, 1-phenyl-5-mercaptotetrazole, 2-mercaptobenzothiazole, 2-(p-diethylaminostyryl)benzoxazole, 2-(p-dimethylaminostyryl)benzothiazole, 2-(p-dimethylaminostyryl)naphtho(1,2-d)thiazole, and 2-(p-dimethylaminobenzoyl)styrene. These may be used singly or in combination of, for example, two to five thereof.

A blending amount of (J) the sensitizer is preferably 0.05 to 20 parts by mass, and more preferably 0.1 to 10 parts by mass relative to 100 parts by mass of the polymer of the component (A).

The negative-type photosensitive resin composition of the present invention preferably further contains (K) a migration inhibitor. Containing the migration inhibitor can effectively inhibit migration of metal ions derived from the metal layer (the metal wiring) into the curable resin composition layer.

(K) the migration inhibitor is not particularly limited, and examples thereof include compounds having a heteroring (a pyrrole ring, a furan ring, a thiophene ring, an imidazole ring, an oxazole ring, a thiazole ring, a pyrazole ring, an isoxazole ring, an isothiazole ring, a tetrazole ring, a pyridine ring, a pyridazine ring, a pyrimidine ring, a pyrazine ring, a piperidine ring, a piperazine ring, a morpholine ring, a 2H-pyran ring and a 6H-pyran ring, or a triazine ring), thioureas, compounds having a sulfanyl group, hindered-phenol-type compounds, salicylic acid derivative compounds, and hydrazide derivative compounds. Particularly, triazole compounds such as 1,2,4-triazole and benzotriazole and tetrazole compounds such as 1H-tetrazole and 5H-phenyltetrazole can be preferably used.

As (K) the migration inhibitor, an ion-trapping agent that traps anions such as halogen ions may also be used.

As other migration inhibitors, antirust agents described in paragraph 0094 in JP 2013-01571 A, compounds described in paragraphs 0073 to 0076 of JP 2009-283711 A, compounds described in paragraph 0052 of JP 2011-059656 A, compounds described in paragraphs 0114, 0116, and 0118 of JP 2012-194520 A, compounds described in paragraph 0166 of WO 2015/199219 A1, etc. may be used.

Specific examples of the migration inhibitor include the following compounds.

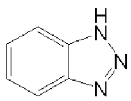

( K-1 )

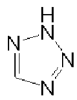

( K-2 )

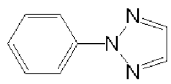

( K-3 )

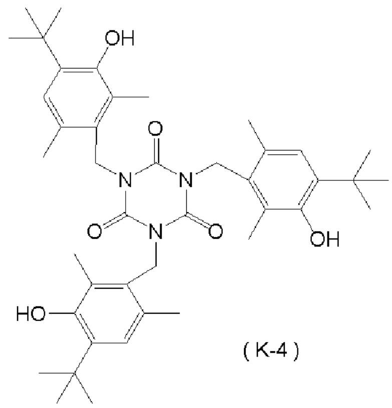

( K-4 )

When the negative-type photosensitive resin composition of the present invention contains the migration inhibitor, a content of the migration inhibitor is preferably 0.01 to 5.0 mass%, more preferably 0.05 to 2.0 mass%, and further preferably 0.1 to 1.0 mass% relative to 100 parts by mass of the polymer compound having the structural unit of the polyimide precursor used in the negative-type photosensitive resin composition of the present invention.

The migration inhibitor may be one type, or may be two or more types. When the migration inhibitor is two or more types, the total content is preferably within the above range.

(L) the surfactant is preferably nonionic, and examples thereof include fluorine surfactants, specifically a perfluoroalkyl polyoxyethylene ethanol, a fluorinated alkyl ester, a perfluoroalkylamine oxide, and a fluorine-containing organosiloxane compound.

As these surfactants, commercially available products may be used. Examples thereof include Fluorad "FC-4430" (available from Sumitomo 3M Limited), Surflon "S-141" and "S-145" (the above are available from Asahi Glass Co., Ltd.), UNIDYNE "DS-401", "DS-4031", and "DS-451" (the above are available from DAIKIN INDUSTRIES, Ltd.), MEGAFACE "F-8151" (available from DIC Corporation), and "X-70-093" (available from Shin-Etsu Chemical Co., Ltd.). Among these, Fluorad "FC-4430" (available from Sumitomo 3M Limited) and "X-70-093" (available from Shin-Etsu Chemical Co., Ltd.) are preferable.

A blending amount of (L) the surfactant is preferably 0.01 to 0.05 parts by mass relative to 100 parts by mass of the polymer of the component (A). The amount within this range has an advantage of improvement of coatability on the substrate without impairing the patterning performance and properties of the cured coating.

Patterning Process

Next, a patterning process of the negative-type photosensitive resin composition of the present invention will be

described.

The present invention provides a patterning process including:

(1) a step of applying the photosensitive resin composition according to any one of the above on a substrate to form a photosensitive material coating; then
(2) after a heating treatment, a step of exposing the photosensitive material coating with high-energy ray having a wavelength of 190 to 500 nm or electron beam though a photomask; and
(3) after the irradiation, a step of performing development by using a developer of an organic solvent.

As for the negative-type photosensitive resin composition of the present invention, a known lithography technology may be applied. For example, the composition is applied by spin-coating technique on a silicon wafer, a $SiO_2$ substrate, a SiN substrate, or a substrate on which a pattern such as copper wiring is formed, and prebaking is performed under a condition of 80 to 130°C for about 50 to 600 seconds to form a resist film having a thickness of 1 to 50 μm, preferably 1 to 30 μm, and further preferably 5 to 20 μm. Then, a mask for forming a target pattern is placed over the resist film, and the resist film is irradiated for exposure with high-energy ray having a wavelength of 190 to 500 nm, such as i-line and g-line, so that an exposure dose is about 1 to 5,000 $mJ/cm^2$, preferably about 100 to 2,000 $mJ/cm^2$.

Thereafter, development is performed. For the above negative-type photosensitive resin composition of the present invention, organic solvent development is preferable. As the organic solvent usable for the preferable organic solvent development, the aforementioned solvent used in preparing the photosensitive resin composition of the present invention may be used. For example, ketones such as cyclohexanone and cyclopentanone and glycols such as propylene glycol monomethyl ether are preferable. The development can be performed by a common method such as a spraying method and a puddle method, immersion in a developer, etc. Thereafter, washing, rinsing, drying, etc. are performed as necessary to obtain a resist coating having the desired pattern.

The obtained coating having the pattern is subjected to post-curing by using an oven or a hotplate at a temperature of 100 to 300°C, preferably 150 to 300°C, further preferably 180 to 250°C. The post-curing temperature of 100 to 300°C can increase a crosslinking density of the coating of the photosensitive resin composition and remove a remaining volatile component, and is preferable from the viewpoints of an adhesive force to the substrate, heat resistance, strength, and electric properties. The post-curing time may be 10 minutes to 10 hours.

The cured coating obtained as above has excellent adhesiveness to the substrate, heat resistance, electric properties, mechanical strength, and chemical resistance, and excellent reliability of a semiconductor device using the cured coating as a protective coating. Particularly, occurrence of cracking in a temperature cycle test can be prevented, and the cured coating is suitably used as the protective coating for an electric or electronic component, a semiconductor device, etc.

Specifically, the present invention provides an interlayer insulating film or a surface protecting film that include a cured coating formed by curing the above negative-type photosensitive resin composition.

The protective coating is effective for an insulative film for a semiconductor device including rewiring application, an insurability for a multilayer printed substrate, a solder mask, a cover lay film application, etc. due to its heat resistance, chemical resistance, and insurability.

Further, the present invention provides an electronic component having the above interlayer insulating film or the above surface protecting film.

Since the electronic component as above has the protective coating (the interlayer insulating film or the surface protecting film) having heat resistance, chemical resistance, and insurability, the electronic component has excellent reliability.

## EXAMPLE

Hereinafter, the present invention will be specifically described with showing Synthesis Examples, Examples, and Comparative Examples, but the present invention is not limited to the following examples.

### I. Synthesis of Polymer Compound

Chemical structural formulae and names of compounds used in Synthesis Examples of polymer compounds used in the following negative-type photosensitive resin compositions of the present invention are shown below.

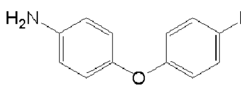

ODA

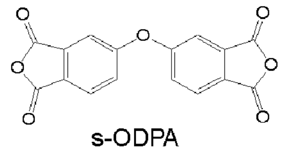

s-ODPA

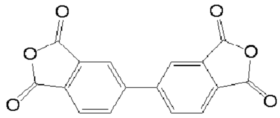

s-BPDA

ODA 4,4'-Diaminodiphenyl ether
s-ODPA 3,3',4,4'-Oxydiphthalic dianhydride
s-BPDA 3,3',4,4'-Biphenyltetracarboxylic dianhydride

Synthesis Example 1: Synthesis of Tetracarboxylic Acid Diester Compound (X-1)

Into a 3-L flask equipped with a stirrer and a thermometer, 100 g (322 mmol) of 3,3',4,4'-oxydiphthalic dianhydride (s-ODPA), 65.2 g (644 mmol) of triethylamine, 39.3 g (322 mmol) of N,N-dimethyl-4-aminopyridine, and 400 g of γ-butyrolactone were added. While stirring the mixture at room temperature, 83.8 g (644 mmol) of hydroxyethyl methacrylate (HEMA) was added dropwise, and then the mixture was stirred at room temperature for 24 hours. Thereafter, 370 g of a 10% aqueous hydrochloric acid solution was added dropwise under ice cooling to terminate the reaction. Into the reaction liquid, 800 g of 4-methyl-2-pentanone was added, an organic layer was collected, and then washed with 600 g of water six times. The solvent in the obtained organic layer was evaporated to obtain 180 g of a tetracarboxylic acid diester compound (X-1) having the following structure.

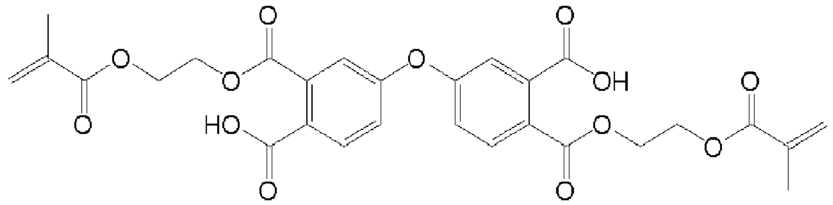

(X-1)

Synthesis Example 2: Synthesis of Tetracarboxylic Acid Diester Compound (X-2)

Obtained was 172 g of a tetracarboxylic acid diester compound (X-2) having the following structure by the same procedure in Synthesis Example 1 except that 3,3',4,4'-oxydiphthalic dianhydride (s-ODPA) was replaced with 94.8 g (322 mmol) of 3,3',4,4'-biphenyltetracarboxylic dianhydride (s-BPDA).

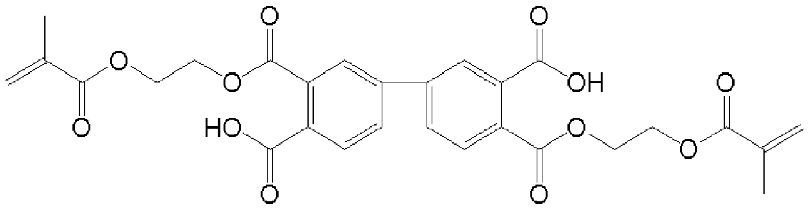

(X-2)

Synthesis Example 3: Synthesis of Polyimide Precursor (A-1)

Into a 1-L flask equipped with a stirrer and a thermometer, 44.0 g (77.1 mmol) of (X-1) and 176 g of N-methyl-2-pyrrolidone were added, and the mixture was stirred and dissolved at room temperature. Then, 18.8 g (158.1 mmol) of thionyl chloride was added dropwise under ice cooling so that a temperature of the reaction solution was maintained at 10°C or lower, and after the dropwise addition was finished, the mixture was stirred under ice cooling for 2 hours. Subsequently, a solution in which 14.4 g (71.7 mmol) of 4,4'-diaminodiphenyl ether (ODA) and 25.0 g (316.2 mmol) of pyridine were dissolved with 70 g of N-methyl-2-pyrrolidone was added dropwise under ice cooling so that a temperature of the reaction solution was maintained at 10°C or lower. After the dropwise addition was finished, the temperature was returned to room temperature, and this reaction liquid was added dropwise into 3 L of stirred water. The precipitate was filtered, appropriately washed with water, and then dried under a reduced pressure at 40°C for 48 hours to obtain a polyimide precursor (A-1). A molecular weight of this polymer was measured by GPC using DMF as an eluent under a condition at a temperature of 40°C to be a weight-average molecular weight of 24,000 in terms of polystyrene.

Synthesis Example 4: Synthesis of Polyimide Precursor (A-2)

A polyimide precursor (A-2) was obtained by the same method except that (X-1) shown in Synthesis Example 3 was replaced with 42.8 g (77.1 mmol) of (X-2). A molecular weight of this polymer was measured by GPC using DMF as an eluent under a condition at a temperature of 40°C to be a weight-average molecular weight of 23,000 in terms of polystyrene.

II. Component (D) Organic Compound

Compounds used in Synthesis Examples of component (D) organic compounds used for the negative-type photosensitive resin composition of the present invention are shown below.

(D-2) N-hydroxyphthalimide
(D-3) N-hydroxy-5-norbornene-2,3-dicarboxyimide
(D-4) N-hydroxytetrachlorophthalimide
(D-5) N,N'-dihydroxypyromellitimide
(D-6) 4-Nitrophenol
(D-7) Pentafluorophenol
(D-8) 1-Hydroxybenzotriazole
(D-9) 1-Hydroxy-6-(trifluoromethyl)benzotriazole

Synthesis Example 5: Synthesis of N-(tert-butoxycarbonyloxy)-5-norbornene-2,3-dicarboxyimide (D-3-1)

In a 300-ml flask equipped with a reflux condenser, a stirrer, and a thermometer, 62 mg (0.51 mmol) of 4-(N,N-dimethylamino)pyridine and 6.55 g (30.0 mmol) of di-tert-butyl dicarbonate were stirred at 25°C under nitrogen. This mixture was added into 100 mL of an acetonitrile solution of 4.48 g (25.0 mmol) of (D-3) N-hydroxy-5-norbornene-2,3-dicarboxyimide. The mixture was then stirred at 25°C for 12 hours. After the reaction was finished, the reaction liquid was poured into 200 mL of cold water, and the organic layer was extracted by using 30 mL of ethyl acetate three times. The organic layer was further washed with 50 mL of cold water three times, the organic layer was dried with magnesium sulfate, then condensed under a reduced pressure, and crystallized by using petroleum ether to obtain N-(tert-butoxycarbonyloxy)-5-norbornene-2,3-dicarboxyimide (D-3-1) having the following structure (5.31 g, yield: 76.0%).

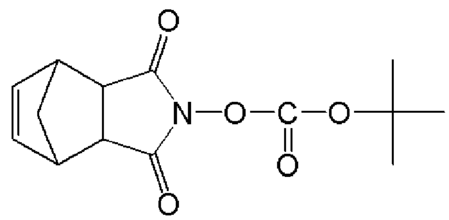

(D-3-1) N-(tert-butoxycarbonyloxy)-5-norbornene-2,3-dicarboxyimide

Synthesis Example 6: Synthesis of N-(tert-butoxycarbonyloxy)-tetrachlorophthalimide (D-4-1)

The same reaction was performed while (D-3) N-hydroxy-5-norbornene-2,3-dicarboxyimide in Synthesis Example 5 was replaced with 7.52 g of (D-4) N-hydroxytetrachlorophthalimide to obtain N-(tert-butoxycarbonyloxy)-tetrachlorophthalimide (D-4-1) having the following structure (7.15 g, yield: 71.5%).

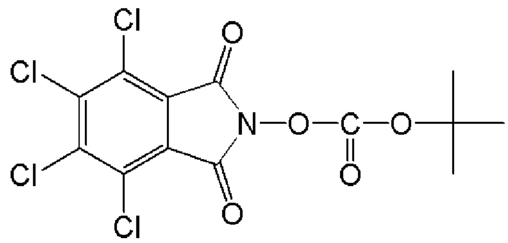

(D-4-1) N-(tert-butoxycarbonyloxy)-tetrachlorophthalimide

Synthesis Example 7: Synthesis of N,N'-di(tert-butoxycarbonyloxy)pyromellitimide (D-5-1)

The same reaction was performed while (D-3) N-hydroxy-5-norbornene-2,3-dicarboxyimide in Synthesis Example 5 was replaced with 6.18 g of (D-5) N,N'-dihydroxypyromellitimide as 13.10 g (60.0 mmol) of di-tert-butyl dicarbonate to obtain N,N'-di(tert-butoxycarbonyloxy)pyromellitimide (D-5-1) having the following structure (9.03 g, yield: 70.1%).

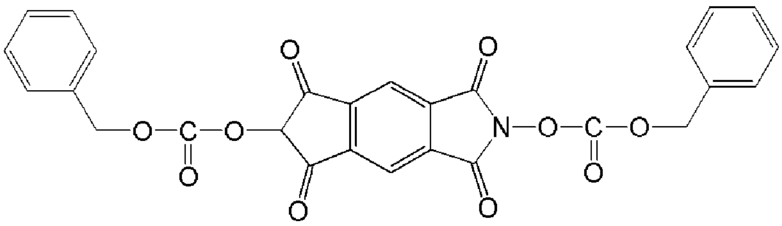

(D-5-1) N,N'-di(tert-butoxycarbonyloxy)pyromellitimide

Synthesis Example 8: Synthesis of tert-butyl-4-nitrophenyl carbonate (D-6-1)

The same reaction was performed while (D-3) N-hydroxy-5-norbornene-2,3-dicarboxyimide in Synthesis Example 5 was replaced with 3.48 g of (D-6) 4-nitrophenol to obtain tert-butyl-4-nitrophenyl carbonate (D-6-1) having the following structure (5.31 g, yield: 88.8%).

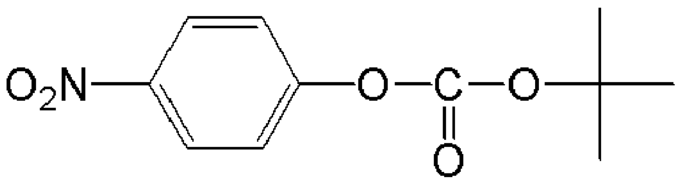

(D-6-1) tert-Butyl-4-nitrophenyl carbonate

Synthesis Example 9: Synthesis of tert-butyl-2,3,4,5,6-pentafluorophenyl carbonate (D-7-1)

The same reaction was performed while (D-3) N-hydroxy-5-norbornene-2,3-dicarboxyimide in Synthesis Example 5 was replaced with 4.60 g of (D-7) pentafluorophenol to obtain tert-butyl-2,3,4,5,6-pentafluorophenyl carbonate (D-7-1) having the following structure (5.34 g, yield: 75.2%).

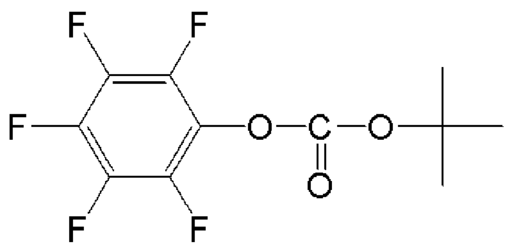

(D-7-1) tert-Butyl-2,3,4,5,6-pentafluorophenyl carbonate

Synthesis Example 10: Synthesis of 1-(tert-butoxycarbonyloxy)-benzotriazole (D-8-1)

The same reaction was performed while (D-3) N-hydroxy-5-norbornene-2,3-dicarboxyimide in Synthesis Example 5 was replaced with 3.38 g of (D-8) 1-hydroxybenzotriazole to obtain 1-(tert-butoxycarbonyloxy)-benzotriazole (D-8-1) having the following structure (4.06 g, yield: 69.0%).

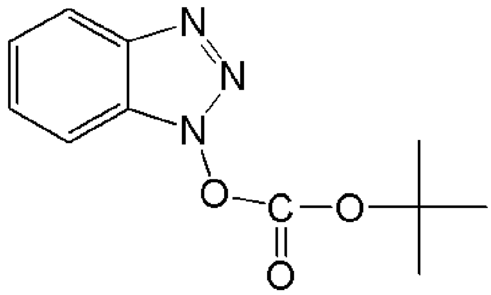

(D-8-1) 1-(tert-Butoxycarbonyloxy)-benzotriazole

Synthesis Example 11: Synthesis of 1-(tert-butoxycarbonyloxy)-6-(trifluoromethyl)benzotriazole (D-9-1)

The same reaction was performed while (D-3) N-hydroxy-5-norbornene-2,3-dicarboxyimide in Synthesis Example 5 was replaced with 5.08 g of (D-9) 1-hydroxy-6-(trifluoromethyl)benzotriazole to obtain 1-(tert-butoxycarbonyloxy)-6-(trifluoromethyl)benzotriazole (D-9-1) having the following structure (5.17 g, yield: 68.2%) .

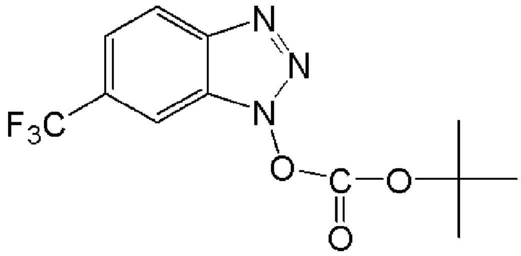

(D-9-1) 1-(tert-Butoxycarbonyloxy)-6-(trifluoromethyl)benzotriazole

Synthesis Example 12: Synthesis of N-(benzyloxycarbonyloxy)phthalimide (D-2-2)

In a 300-ml flask equipped with a reflux condenser, a stirrer, a thermometer, 4.26 g (25.0 mmol) of benzyl chloroformate was added dropwise at 0°C into a mixed solution of 51 mg (0.51 mmol) of triethylamine, 8.17 g (50.0 mmol) of (D-2) N-hydroxyphthalimide, and 70 g of tetrahydrofuran, and then the mixture was stirred at 50°C for 20 hours. After the reaction was finished, the reaction liquid was poured into 200 mL of cold water, 30 mL of ethyl acetate was used three times to extract the organic layer. The organic layer was further washed with 50 mL of cold water three times, the organic layer was dried with magnesium sulfate, then concentrated under a reduced pressure, and crystallized by using petroleum ether to obtain N-(benzyloxycarbonyloxy)-phthalimide (D-2-2) having the following structure (6.03 g, yield: 81.2%).

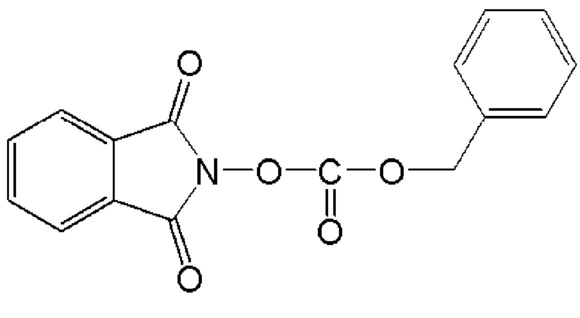

(D-2-2) N-(benzyloxycarbonyloxy)-phthalimide

Synthesis Example 13: Synthesis of N-(benzyloxycarbonyloxy)-5-norbornene-2,3-dicarboxyimide (D-3-2)

The same reaction was performed while (D-2) N-hydroxyphthalimide in Synthesis Example 12 was replaced with 4.48 g of (D-3) N-hydroxy-5-norbornene-2,3-dicarboxyimide to obtain N-(benzyloxycarbonyloxy)-5-norbornene-2,3-dicarboxyimide (D-3-2) having the following structure (6.18 g, yield: 78.9%).

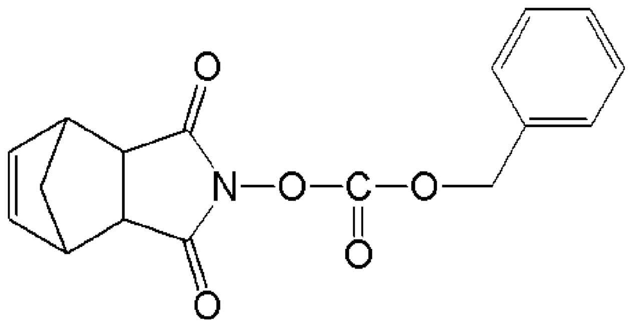

(D-3-2) N-(benzyloxycarbonyloxy)-5-norbornene-2,3-dicarboxyimide

Synthesis Example 14: Synthesis of N-(benzyloxycarbonyloxy)-tetrachlorophthalimide (D-4-2)

The same reaction was performed while (D-2) N-hydroxyphthalimide in Synthesis Example 12 was replaced with 7.52 g of (D-4) N-hydroxytetrachlorophthalimide to obtain N-(benzyloxycarbonyloxy)-tetrachlorophthalimide (D-4-2) having the following structure (6.78 g, yield: 62.3%).

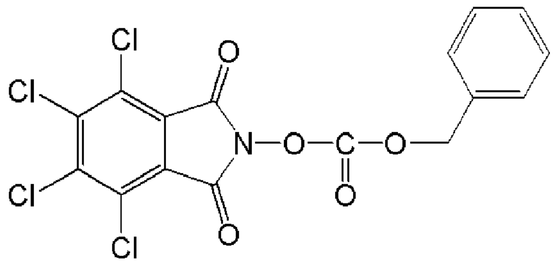

(D-4-2) N-(benzyloxycarbonyloxy)-tetrachlorophthalimide

Synthesis Example 15: Synthesis of N,N'-di(benzyloxycarbonyloxy)pyromellitimide (D-5-2)

The same reaction was performed while (D-2) N-hydroxyphthalimide in Synthesis Example 12 was replaced with 6.18 g of (D-5) N,N'-dihydroxypyromellitimide and while using 10.23 g (60.0 mmol) of benzyl chloroformate to obtain N,N'-di(benzyloxycarbonyloxy)pyromellitimide (D-5-2) having the following structure (7.52 g, yield: 58.4%) .

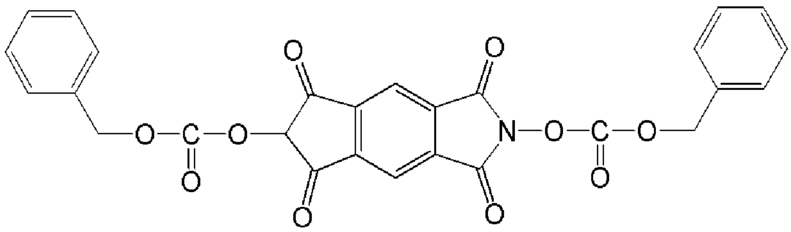

(D-5-2) N,N'-di(benzyloxycarbonyloxy)pyromellitimide

Synthesis Example 16: Synthesis of benzyl 4-nitrophenyl carbonate (D-6-2)

The same reaction was performed while (D-2) N-hydroxyphthalimide in Synthesis Example 12 was replaced with 3.48 g of (D-6) 4-nitrophenol to obtain benzyl 4-nitrophenyl carbonate (D-6-2) having the following structure (5.85 g, yield: 85.6%).

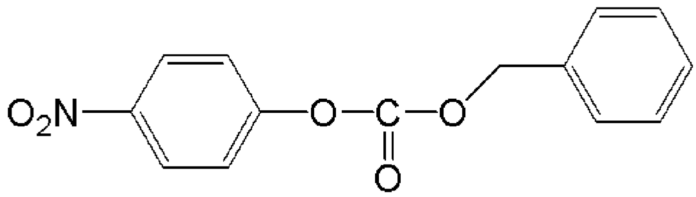

(D-6-2) Benzyl 4-nitrophenyl carbonate

Synthesis Example 17: Synthesis of Benzyl 2,3,4,5,6-pentafluorophenyl carbonate (D-7-2)

The same reaction was performed while (D-2) N-hydroxyphthalimide in Synthesis Example 12 was replaced with 4.60 g of (D-7) pentafluorophenol to obtain tert-butyl 2,3,4,5,6-pentafluorophenyl carbonate (D-7-2) having the following structure (4.77 g, yield: 60.0%).

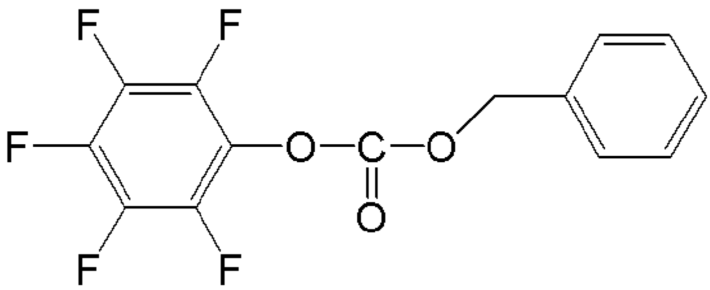

(D-7-2) Benzyl 2,3,4,5,6-pentafluorophenyl carbonate

Synthesis Example 18: Synthesis of 1-(benzyloxycarbonyloxy)-benzotriazole (D-8-2)

The same reaction was performed while (D-2) N-hydroxyphthalimide in Synthesis Example 12 was replaced with 3.38 g of (D-8) 1-hydroxybenzotriazole to obtain 1-(benzyloxycarbonyloxy)-benzotriazole (D-8-2) having the following structure (4.13 g, yield: 61.3%).

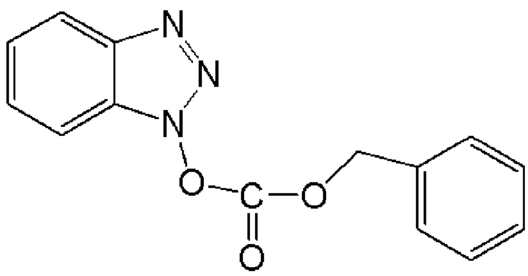

(D-8-2) 1-(Benzyloxycarbonyloxy)-benzotriazole

Synthesis Example 19: Synthesis of 1-(benzyloxycarbonyloxy)-6-(trifluoromethyl)benzotriazole (D-9-2)

The same reaction was performed while (D-2) N-hydroxyphthalimide in Synthesis Example 12 was replaced with 5.08 g of (D-9) 1-hydroxy-6-(trifluoromethyl)benzotriazole to obtain 1-(benzyloxycarbonyloxy)-6-(trifluoromethyl)benzotriazole (D-9-2) having the following structure (5.43 g, yield: 64.4%).

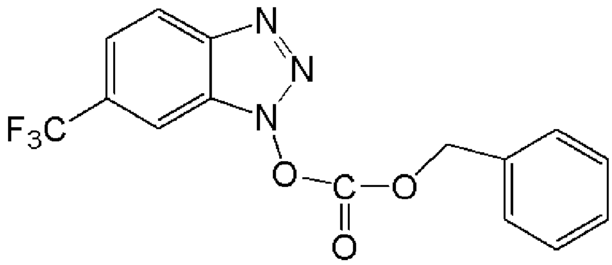

(D-9-2) 1-(Benzyloxycarbonyloxy)-6-(trifluoromethyl)benzotriazole

As (D-1-1) N-(tert-butoxycarbonyloxy)succinimide represented by the following structural formula, a commercially available reagent (FUJIFILM Wako Pure Chemical Corporation) was used.

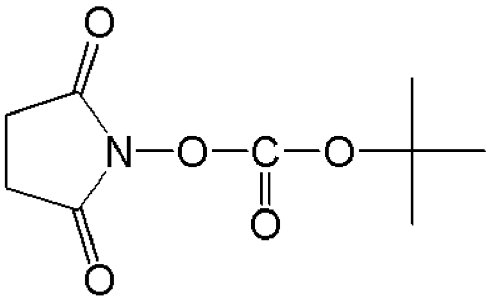

(D-1-1) N-(tert-butoxycarbonyloxy)succinimide

As (D-2-1) N-(tert-butoxycarbonyloxy)phthalimide and

(D-1-2) N-(benzyloxycarbonyloxy)succinimide,
represented by the following structural formula, commercially available reagents (Tokyo Chemical Industry Co., Ltd.) were used.

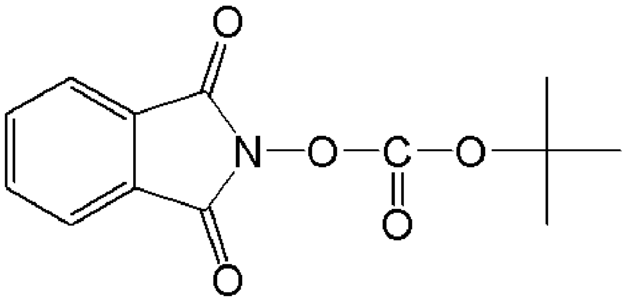

(D-2-1) N-(tert-butoxycarbonyloxy)phthalimide

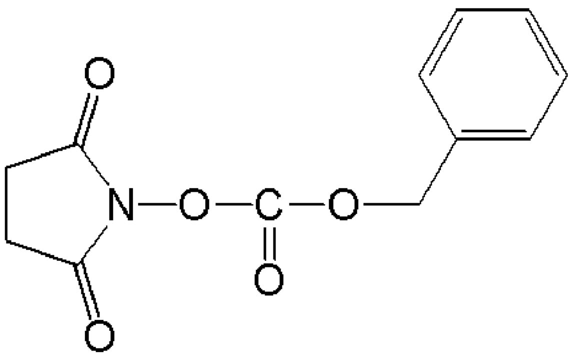

(D-1-2) N-(benzyloxycarbonyloxy)succinimide

III. Imide Ring-Closing Temperature

Into γ-butyrolactone (hereinafter, "GBL") being a solvent, 100 parts by weight of the polymer compound (A-1) synthesized above, 5 parts by weight of the organic compound of the component (D) (D-1-1) to (D-9-2) obtained above, as described in the following Table 1 (Example 1) to (Example 18), and 4.0 parts by weight of a photopolymerization initiator (C-1): N-1919, available from ADEKA CORPORATION, were dissolved. Thereafter, the solution was finely filtered with a 1.0-μm filter made of Teflon (R) to prepare a negative-type photosensitive resin composition. A composition in which the organic compound of the component (D) was not added was prepared as Comparative Example.

Then, 5 mL of the obtained composition solution was dispensed on a silicon substrate, and then applied by rotating the substrate, namely by a spin-coating method. Thereafter, prebaking on a hotplate at 100°C for 3 minutes was performed. The number of rotation in applying the composition solution was adjusted so that a final film thickness after the prebaking was 0.9 μm to 1.2 μm.

The entire surface of the composition film applied on the silicon substrate was irradiated with i-line by using an i-line stepper NSR-2205i11, available from NIKON CORPORATION, at an exposure dose of 600 mJ.

The obtained cured film was heated for 1 hour at 100°C to 250°C in 10°C increments, and then an absorption intensity by infrared spectroscopy at each temperature was measured by using the following FT-IR. In addition, the obtained cured film was heated at 300°C for 1 hour, and then the absorption intensity was similarly measured.

FT-IR Nicolet iN10 MX (Thermo Fisher Scientific, Inc.)

When the ring-closing reaction from the polymer compound being the polyimide precursor to the polyimide proceeds in the composition film, a new C-N bond is formed. Thus, an absorption intensity at 1379 $cm^{-1}$, attributed to a C-N stretching motion, increases in an IR spectrum. Meanwhile, since the C-C double bond in the benzene ring does not change even after the imidization, an absorption intensity at 1552 $cm^{-1}$, attributed to a C-C stretching motion of the benzene ring, does not change in the IR spectrum. While using this absorption intensity at 1552 $cm^{-1}$ of the C-C stretching motion of the benzene ring as an internal standard, the absorption intensity at 1379 $cm^{-1}$, attributed to the C-N stretching motion, can be expressed as a degree of reaction progress of the ring-closing reaction into imide, namely an imidization rate, at each temperature by the following expression (30). Accordingly, the degree of progress of the imidization at each temperature can be relatively compared.

[Expression 1]

$$\text{Imidization rate} = \frac{\text{Absorption intensity at 1379 cm}^{-1}\text{, attributed to C-N stretching motion}}{\text{Absorption intensity at 1552 cm}^{-1}\text{, attributed to C-C stretching motion of benzene ring}} \quad (30)$$

The imidization rate of the cured film after heating at 300°C for 1 hour determined by the expression (30) can be regarded as the complete progress of the ring-closing reaction of the polymer compound being the polyimide precursor into the polyimide. When the imidization rate of the cured film determined by varying the temperature is equal to this imidization rate of the cured film at 300°C, such a temperature can be described as a temperature at which the imide ring-closing reaction of the polyimide precursor in the composition film can be completed.

In the cured films of the photosensitive resin compositions in which the component (D) organic compounds (D-1-1) to (D-9-2) were added in (Example 1) to (Example 18) in the following Table 1, the lowest temperature equal to the temperature at which the imidization rate of the cured film after heating at 300°C for 1 hour is described as an imide ring-closing temperature of the composition film.

[Table 1]

| | Component (D) organic compound | Imide ring-closing temperature |
|---|---|---|
| Example 1 | D-1-1 | 190°C |
| Example 2 | D-2-1 | 190°C |
| Example 3 | D-3-1 | 190°C |
| Example 4 | D-4-1 | 190°C |
| Example 5 | D-5-1 | 190°C |
| Example 6 | D-6-1 | 180°C |
| Example 7 | D-7-1 | 200°C |
| Example 8 | D-8-1 | 200°C |

(continued)

| | Component (D) organic compound | Imide ring-closing temperature |
|---|---|---|
| Example 9 | D-9-1 | 200°C |
| Example 10 | D-1-2 | 190°C |
| Example 11 | D-2-2 | 190°C |
| Example 12 | D-3-2 | 190°C |
| Example 13 | D-4-2 | 190°C |
| Example 14 | D-5-2 | 190°C |
| Example 15 | D-6-2 | 180°C |
| Example 16 | D-7-2 | 200°C |
| Example 17 | D-8-2 | 200°C |
| Example 18 | D-9-2 | 200°C |
| Comparative Example 1 | Component (D) organic compound was not added | 230°C |

As shown in the Table 1, the component (D) organic compound of the present invention can enhance the imidization reaction of the polymer compound having the polyimide precursor structure, and the imide ring-closing reaction can be performed at a low temperature, namely 200°C or lower.

IV. Preparation of Photosensitive Resin Composition

The polymer compound containing the polyimide precursor, obtained in Synthesis Example 3 to Synthesis Example 4, was used as a base resin, and a resin composition at 35 mass% in terms of the resin was prepared with the component (D) organic compound of the present invention prepared as above with composition and blending amounts shown in Table 2 to Table 5. Thereafter, stirring, mixing, and dissolution were performed, and then the solution was finely filtered with a 1.0-μm filter made of Teflon (R) to obtain a photosensitive resin composition. "GBL" of the solvent in Tables represents γ-butyrolactone.

[Table 2]

| | Example 19 | Example 20 | Example 21 | Example 22 | Example 23 | Example 24 | Example 25 | Example 26 | Example 27 |
|---|---|---|---|---|---|---|---|---|---|
| | Photosensitive resin composition 1 | Photosensitive resin composition 2 | Photosensitive resin composition 3 | Photosensitive resin composition 4 | Photosensitive resin composition 5 | Photosensitive resin composition 6 | Photosensitive resin composition 7 | Photosensitive resin composition 8 | Photosensitive resin composition 9 |
| Polymer compound | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight |
| (D) component organic compound | D-1-1 5 parts by weight | D-2-1 5 parts by weight | D-3-1 5 parts by weight | D-4-1 5 parts by weight | D-5-1 5 parts by weight | D-6-1 5 parts by weight | D-7-1 5 parts by weight | D-8-1 5 parts by weight | D-9-1 5 parts by weight |
| Photopolymerization initiator (C-1) | 4 parts by weight | 4 parts by weight | 4 parts by weight | 4 parts by weight | 4 parts by weight | 4 parts by weight | 4 parts by weight | 4 parts by weight | 4 parts by weight |
| Polymeriable compound (B-1) | 10 parts by weight | 10 parts by weight | 10 parts by weight | 10 parts by weight | 10 parts by weight | 10 parts by weight | 10 parts by weight | 10 parts by weight | 10 parts by weight |
| Thermal crosslinking agent | not added | not added | not added | not added | not added | not added | not added | not added | not added |
| Antioxidant (G-1) | 1 part by weight | 1 part by weight | 1 part by weight | 1 part by weight | 1 part by weight | 1 part by weight | 1 part by weight | 1 part by weight | 1 part by weight |
| silane compound (H-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight | 180 parts by weight | 180 parts by weight |
| Shape of hole pattern | Good | Good | Good | Good | Good | Good | Good | Good | Good |
| Minimum hole diameter | 5 um | 5 um | 5 um | 5 um | 5 um | 5 um | 5 um | 5 um | 5 um |
| Sensitivity | 380 mJ | 380 mJ | 380 mJ | 380 mJ | 380 mJ | 380 mJ | 380 mJ | 380 mJ | 380 mJ |
| storage stability | Excellent | Excellent | Excellent | Excellent | Excellent | Excellent | Excellent | Excellent | Excellent |
| Chemical resistance | Excellent | Excellent | Excellent | Excellent | Excellent | Excellent | Excellent | Excellent | Excellent |

[Table 3]

| | Example 28 | Example 29 | Example 30 | Example 31 | Example 32 | Example 33 | Example 34 | Example 35 | Example 36 |
|---|---|---|---|---|---|---|---|---|---|
| | Photosensitive resin composition 10 | Photosensitive resin composition 11 | Photosensitive resin composition 12 | Photosensitive resin composition 13 | Photosensitive resin composition 14 | Photosensitive resin composition 15 | Photosensitive resin composition 16 | Photosensitive resin composition 17 | Photosensitive resin composition 18 |
| Polymer compound | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight |
| (D) component organic compound | D-1-2 5 parts by weight | D-2-2 5 parts by weight | D-3-2 5 parts by weight | D-4-2 5 parts by weight | D-5-2 5 parts by weight | D-6-2 5 parts by weight | D-7-2 5 parts by weight | D-8-2 5 parts by weight | D-9-2 5 parts by weight |
| Photopolymerization initiator (C-1) | 4 parts by weight | 4 parts by weight | 4 parts by weight | 4 parts by weight | 4 parts by weight | 4 parts by weight | 4 parts by weight | 4 parts by weight | 4 parts by weight |
| Polymeriable compound (B-1) | 10 parts by weight | 10 parts by weight | 10 parts by weight | 10 parts by weight | 10 parts by weight | 10 parts by weight | 10 parts by weight | 10 parts by weight | 10 parts by weight |
| Thermal crosslinking agent | not added | not added | not added | not added | not added | not added | not added | not added | not added |
| Antioxidant (G-1) | 1 part by weight | 1 part by weight | 1 part by weight | 1 part by weight | 1 part by weight | 1 part by weight | 1 part by weight | 1 part by weight | 1 part by weight |
| silane compound (H-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight | 180 parts by weight | 180 parts by weight |
| Shape of hole pattern | Good | Good | Good | Good | Good | Good | Good | Good | Good |
| Minimum hole diameter | 5 um | 5 um | 5 um | 5 um | 5 um | 5 um | 5 um | 5 um | 5 um |
| Sensitivity | 400 mJ | 380 mJ | 400 mJ | 420 mJ | 400 mJ | 400 mJ | 420 mJ | 400 mJ | 400 mJ |
| storage stability | Excellent | Excellent | Excellent | Excellent | Excellent | Excellent | Excellent | Excellent | Excellent |
| Chemical resistance | Excellent | Excellent | Excellent | Excellent | Excellent | Excellent | Excellent | Excellent | Excellent |

[Table 4]

| | Example 37 | Example 38 | Example 39 |
|---|---|---|---|
| | Photosensitive resin composition 21 | Photosensitive resin composition 22 | Photosensitive resin composition 23 |
| Polymer compound | A-1 100 parts by weight | A-1 100 parts by weight | A-2 100 parts by weight |
| (D) component organic compound | D-1-1 5 parts by weight | D-2-1 5 parts by weight | D-1-1 5 parts by weight |
| Photopolymerization initiator (C-1) | 4 parts by weight | 4 parts by weight | 4 parts by weight |
| Polymeriable compound (B-1) | 10 parts by weight | 10 parts by weight | 10 parts by weight |
| Thermal crosslinking agent | F-1 5 parts by weight | F-2 10 parts by weight | not added |
| Antioxidant (G-1) | 1 part by weight | 1 part by weight | 1 part by weight |
| Silane compound (H-1) | 0.5 parts by weight | 0.5 parts by weight | 0.5 parts by weight |
| Polymerization inhibitor (I-1) | 0.5 parts by weight | 0.5 parts by weight | 0.5 parts by weight |
| Solvent GBL | 180 parts by weight | 180 parts by weight | 180 parts by weight |
| Shape of hole pattern | Good | Good | Good |
| Minimum hole diameter | 5 um | 5 um | 5 um |
| Sensitivity | 380 mJ | 380 mJ | 380 mJ |
| Storage stability | Excellent | Excellent | Excellent |
| Chemical resistance | Excellent | Excellent | Excellent |

[Table 5]

| | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 | Comparative Example 11 |
|---|---|---|---|---|---|---|---|---|---|---|
| | Photosensitive resin composition 24 | Photosensitive resin composition 25 | Photosensitive resin composition 26 | Photosensitive resin composition 27 | Photosensitive resin composition 28 | Photosensitive resin composition 29 | Photosensitive resin composition 30 | Photosensitive resin composition 31 | Photosensitive resin composition 32 | Photosensitive resin composition 33 |
| Polymer compound | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight | A-1 100 parts by weight |
| (D) component organic compound | D-1 5 parts by weight | D-2 5 parts by weight | D-3 5 parts by weight | D-4 5 parts by weight | D-5 5 parts by weight | D-6 5 parts by weight | D-7 5 parts by weight | D-8 5 parts by weight | D-9 5 parts by weight | not added |
| Photopolymerization initiator (C-1) | 4 parts by weight | 4 parts by weight | 4 parts by weight | 4 parts by weight | 4 parts by weight | 4 parts by weight | 4 parts by weight | 4 parts by weight | 4 parts by weight | 4 parts by weight |
| Polymeriable compound (B-1) | 10 parts by weight | 10 parts by weight | 10 parts by weight | 10 parts by weight | 10 parts by weight | 10 parts by weight | 10 parts by weight | 10 parts by weight | 10 parts by weight | 10 parts by weight |
| Thermal crosslinking agent | not added | not added | not added | not added | not added | not added | not added | not added | not added | not added |
| Antioxidant (G-1) | 1 part by weight | 1 part by weight | 1 part by weight | 1 part by weight | 1 part by weight | 1 part by weight | 1 part by weight | 1 part by weight | 1 part by weight | 1 part by weight |
| Silane compound (H-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Polymerization inhibitor (I-1) | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight | 0.5 parts by weight |
| Solvent GBL | 180 parts by weight | 180 parts by weight | 180 parts by weight | 180 parts by weight | 180 parts by weight | 180 parts by weight | 180 parts by weight | 180 parts by weight | 180 parts by weight | 180 parts by weight |
| Shape of hole pattern | Good | Good | Good | Good | Good | Good | Good | Good | Good | Good |
| Minimum hole diameter | 5 um | 5 um | 5 um | 5 um | 5 um | 5 um | 5 um | 5 um | 5 um | 6 um |
| Sensitivity | 400 mJ | 400 mJ | 400 mJ | 400 mJ | 400 mJ | 400 mJ | 400 mJ | 400 mJ | 400 mJ | 400 mJ |
| | Unmeasurable | Poor | Poor | Poor | Poor | Unmeasurable | Unmeasurable | Poor | Poor | Good |
| Chemical resistance | Excellent | Excellent | Excellent | Excellent | Excellent | Excellent | Excellent | Excellent | Excellent | Poor |

The photosensitive resin compositions 1 to 18 and 21 to 23 (Example 19 to Example 39) shown in Table 2 to Table 4 relate to the aforementioned negative-type photosensitive resin composition of the present invention.

The comparative photosensitive resin compositions 24 to 32 (Comparative Example 2 to Comparative Example 10) shown in Table 5 differ from the organic compound in which the hydroxy compound being activated esterifying agent is protected with a tert-butoxycarbonyl group (an N-Boc group), such as the organic compound used for the aforementioned negative-type photosensitive resin composition of the present invention, or differ from the organic compound protected with a benzyloxycarbonyl protective group (a Z group), and relate to a negative-type sensitive resin composition in which an unprotected organic compound was added.

In Table 5, the compounds in which the hydroxy compound being the activated esterifying agent of the comparative photosensitive resin compositions 24 to 32 (Comparative Example 2 to Comparative Example 10) was not protected were (D-2) to (D-9) used in the Synthesis Examples 5 to 19, and (D-1) was N-hydroxysuccinimide.

The comparative photosensitive resin composition 33 (Comparative Example 11) had composition in which the organic compound used in the aforementioned negative-type photosensitive resin composition of the present invention was not added.

In Table 2 to Table 5, detail of the polymerizable compound (B-1) having two or more ethylenically unsaturated groups, the photopolymerization initiator (C-1), the thermal crosslinking agents (F-1) and (F-2), the antioxidant (G-1), the silane compound (H-1), and the polymerization inhibitor (I-1) was as follows. The term "parts by weight" has the same means as "parts by mass".

Photopolymerization initiator (C-1): N-1919, available from ADEKA CORPORATION

Polymerizable compound (B-1) having two or more ethylenically unsaturated groups: Tetraethylene glycol dimethacrylate

Thermal crosslinking agent (F-1):

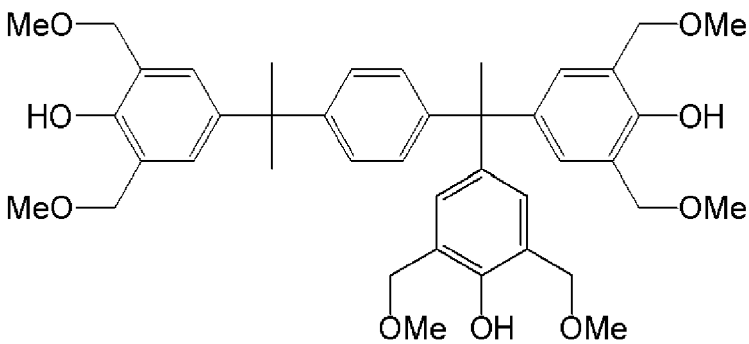

Thermal crosslinking agent (F-2):

Epoxy resin: EP4000L, available from ADEKA CORPORATION

Antioxidant (G-1):

Hindered-phenol-type antioxidant: SUMILIZER GA-80, available from Sumitomo Chemical Co., Ltd.

Silane compound (H-1):

Aminosilane coupling agent: KBM-573, available from Shin-Etsu Chemical Co., Ltd.
Polymerization inhibitor (I-1): 2-Nitoroso-1-naphthol (reagent: Tokyo Chemical Industry Co., Ltd.)

V. Patterning

On a silicon substrate, 5 mL of the above photosensitive resin compositions 1 to 18 and 21 to 23 and comparative

photosensitive resin compositions 24 to 33 were dispensed, and then applied by rotating the substrate, namely by a spin-coating method so that a film thickness after the heating of post-curing, which was to be performed after patterning, was 5 μm. That is, reduction in the film thickness after the post-curing step was investigated in advance to adjust the number of rotation in the applying.

Then, prebaking on a hotplate at 100°C for 3 minutes was performed. Thereafter, exposure to i-line and patterning were performed by using an i-line stepper NSR-2205i11, available from NIKON CORPORATION. In the patterning, a mask for a positive-type pattern or a negative-type pattern was appropriately used according to the used photosensitive resin composition. This mask had a pattern that could form holes with 20 μm in 1:1 length-width arrangement, and could form hole patterns in 10 μm increments within 50 μm to 20 μm, in 5 μm increments within 20 μm to 10 μm, and in 1 μm increments within 10 μm to 1 μm.

In a developing step, cyclopentanone was used as a developer. As organic solvent development, spray development with each organic solvent for 1 minute was performed once, and rinsing was performed with isopropyl alcohol.

Then, the obtained pattern on the substrate was subjected to the post-curing at 200°C for 2 hours by using an oven while nitrogen purging.

Then, each of the substrates was cut so that the shape of the obtained hole pattern could be observed, and the hole pattern shape was observed by using a scanning electron microscope (SEM). A diameter of the minimum opening hole with the film thickness of 5 μm after the post-curing was determined to evaluate the pattern shape. In addition to the above results, Table 2 to Table 5 also show sensitivity with which the minimum pattern could be formed.

The pattern shape of the holes was evaluated on the following criteria. The evaluation results are also shown in Table 2 to Table 5.

Good: A case where the hole having a rectangular or a forward taper shape (a shape having a size of a hole upper part larger than a size of a bottom part) was observed.

Poor: A case where a reverse taper shape (a shape having a size of a hole upper part smaller than a size of a bottom part), an over-hung shape (a shape of a projected hole upper part), a case where considerable reduction in the film was observed, or a case where a residue was observed on a hole bottom part.

VI. Storage Stability

In the aforementioned patterning, 5 mL of the aforementioned photosensitive resin composition was dispensed on a silicon substrate, and then similarly applied by rotating the substrate, and then prebaking was performed on a hotplate at 100°C for 3 minutes. The film thickness after the prebaking was recorded, and the solution of the photosensitive resin composition was stored at room temperature for three weeks.

After three weeks, film formation was performed under the same condition with the same number of rotation, and the film thickness was measured. The film thickness before the storage and the film thickness after the storage were compared, and the storage stability was evaluated as follows.

A changing rate of the film thickness was calculated by the following formula.

Changing rate of film thickness (%) = {(Film thickness before aging - Film thickness after aging) / Film thickness before aging} × 100

The calculated changing rate of the film thickness was evaluated according to the following evaluation criteria.

Excellent: Composition with which the change in the film thickness before and after the storage was less than 10%.

Good: Composition with which the change in the film thickness before and after the storage was 10% or more and less than 15%.

Poor: Composition with which the change in the film thickness before and after the storage was 15% or more.

Unmeasurable: Composition with which the composition solution after three weeks gelled to fail to form a film.

The evaluation results are also shown in Table 2 to Table 5. It can be said that the smaller the changing rate of the film thickness, the more excellent the storage stability of the curable resin composition. The composition solution is preferably stable and causes no change.

VII. Chemical Resistance

In the aforementioned patterning, 5 mL of the aforementioned photosensitive resin composition was dispensed on a silicon substrate, and then similarly applied by rotating the substrate, and then prebaking was performed on a hotplate at 100°C for 3 minutes. Then, the entire surface, without patterning, of the composition film was exposed to i-line by using

an i-line stepper NSR-2205i11, available from NIKON CORPORATION, at an exposure dose of 600 mJ.

Thereafter, the obtained film on the substrate was subjected to the post-curing at 200°C for 2 hours by using an oven while nitrogen purging.

The obtained cured film was immersed in the following chemical reagent under the following condition, and a dissolution rate was calculated.

Chemical Reagent: A mixture of dimethyl sulfoxide (DMSO) and a 25-mass% aqueous solution of tetramethylammonium hydroxide (TMAH) at 90:10 (mass ratio)

Evaluation Condition: The resin layer was immersed in the chemical reagent at 75°C for 15 minutes, and the film thicknesses before and after the immersion were compared to measure a change in the cured film. The evaluation was performed according to the following evaluation criteria, and the evaluation results are also described in Table 2 to Table 5. It can be said that composition with a smaller change in the film thickness indicates the obtained cured film (the resin layer) having more excellent chemical resistance.

Excellent: The change in the film thickness was less than 3.0 μm.
Good: The change in the film thickness was 3.0 μm or more and less than 5.0 μm.
Poor: The change in the film thickness was 5.0 μm or more.

As shown in the results in Table 2 to Table 5, it is understood that the negative-type sensitive resin composition containing the organic compound of the present invention has excellent resolution performance. It is also understood that the negative-type sensitive resin composition has also excellent storage stability and chemical resistance.

Meanwhile, it is found that use of the negative-type photosensitive resin composition containing the compound other the organic compound of the present invention causes poor storage stability. That is, as shown in the results of the storage stability of the comparative photosensitive resin compositions 24 to 32 (Comparative Example 2 to Comparative Example 10), it has been found that, differing from the organic compound in which the hydroxy compound being the activated esterifying agent is protected with a tert-butoxycarbonyl group (an N-Boc group) or differing from the organic compound protected with a benzyloxycarbonyl protective group (a Z group), as the organic compound of the present invention, the negative-type sensitive resin composition in which the unprotected organic compound is added causes poor storage stability.

The comparative photosensitive resin composition 33 (Comparative Example 11) had composition in which the organic compound used in the aforementioned negative-type photosensitive resin composition of the present invention was not added. The cured film with this composition resulted in poor chemical resistance compared with the composition containing the nitrogen-containing organic compound of the present invention. This is presumably due to the imide ring-closing temperature of the composition not containing the nitrogen-containing compound of the present invention being as high as 230°C as noted above, leading to fail to reach the complete imidization under the condition by using the oven at 200°C for 2 hours in this evaluation, and fail to exhibit the chemical resistance, which is the advantage of the polyimide.

The present description includes the following embodiments.

[1]: A negative-type photosensitive resin composition, comprising:

(A) a polymer compound comprising a polyimide precursor structure;
(C) a photopolymerization initiator;
(D) an organic compound represented by the following general formula (1); and
(E) a solvent,

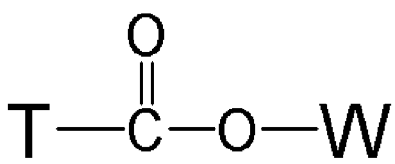

(1)

wherein T represents any one structure of the following general formulae (2) to (4), and W represents an alkyl group or an aryl group that are optionally substituted with an alkoxy group having 4 to 15 carbon atoms,

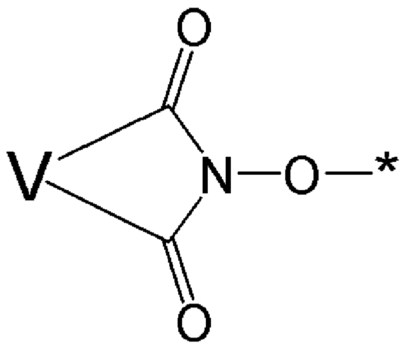

(2)

wherein V represents a divalent organic group, and "*" represents a bond,

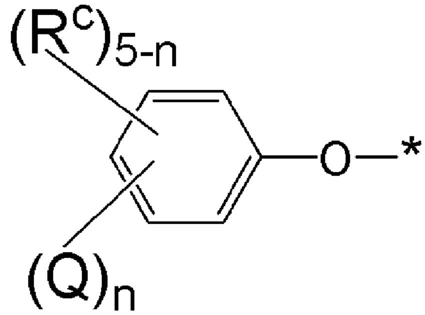

(3)

wherein Q represents a halogen atom or a nitro group, $R^C$ represents a hydrogen atom, a linear, branched, or cyclic alkyl group having 1 to 15 carbon atoms, or an aryl group having 6 to 15 carbon atoms, "n" represents an integer of 3 to 5 when Q represents the halogen atom or represents 1 when Q represents the nitro group, and "*" represents a bond,

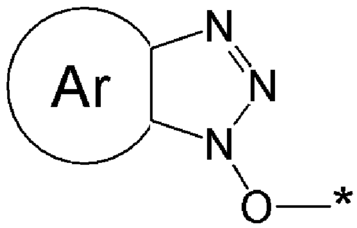

(4)

wherein Ar represents a substituted or unsubstituted aromatic cyclic structure or a heterocyclic structure having a heteroatom, and "*" represents a bond.

[2]: The negative-type photosensitive resin composition according to [1], wherein the component (A) is a polymer compound comprising a polyimide precursor structure represented by the following general formula (5),

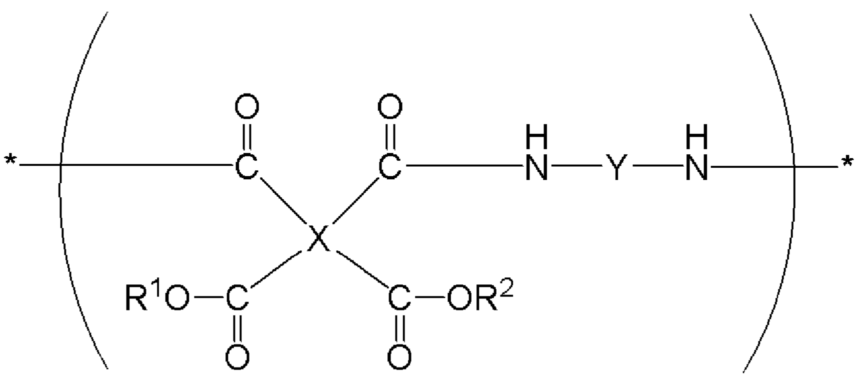

(5)

wherein X represents a tetravalent organic group, Y represents a divalent organic group, $R^1$ and $R^2$ each independently represent a hydrogen atom or a monovalent organic group, and at least one of $R^1$ and $R^2$ represents a group represented by the following general formula (6),

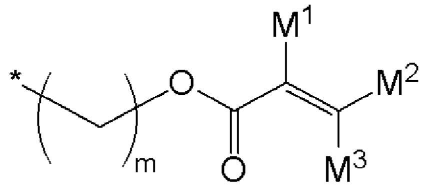

(6)

wherein $M^1$, $M^2$, and $M^3$ each independently represents a hydrogen atom or an organic group having 1 to 3 carbon atoms, "m" represents an integer of 2 to 10, and "*" represents a bond.

[3]: The negative-type photosensitive resin composition according to [1] or [2], wherein the composition comprises (B) a polymerizable compound having two or more ethylenically unsaturated groups.

[4]: The negative-type photosensitive resin composition according to any one of [1] to [3], wherein W in the general formula (1) of the component (D) represents a tert-butyl group.

[5]: The negative-type photosensitive resin composition according to any one of [1] to [3], wherein W in the general formula (1) of the component (D) represents a benzyl group.

[6]: The negative-type photosensitive resin composition according to any one of [1] to [5], wherein the general formula (2) represents a structure represented by the following general formula (2-1),

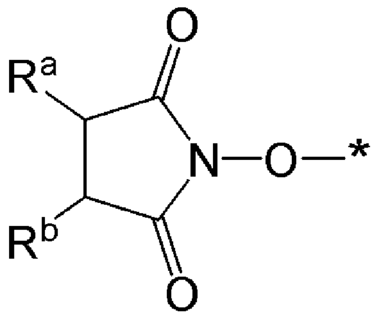

(2-1)

wherein $R^a$ and $R^b$ represent a hydrogen atom, a linear, branched, or cyclic alkyl group having 1 to 15 carbon atoms, or an aryl group having 6 to 15 carbon atoms, $R^a$ and $R^b$ are optionally bonded to each other to form a ring together with a carbon atom to which $R^a$ and $R^b$ are bonded, and "*" represents a bond.

[7]: The negative-type photosensitive resin composition according to any one of [1] to [5], wherein the general formula (3) represents a structure represented by the following formula (3-1) or (3-2),

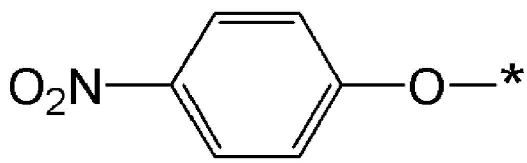

(3-1)

wherein "*" represents a bond,

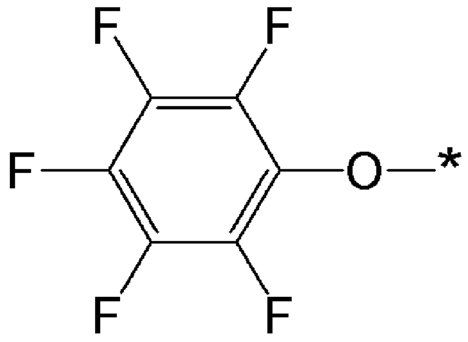

(3 − 2)

wherein "*" represents a bond.

[8] The negative-type photosensitive resin composition according to any one of [1] to [5], wherein the general formula (4) represents a structure represented by the following general formula (4-1),

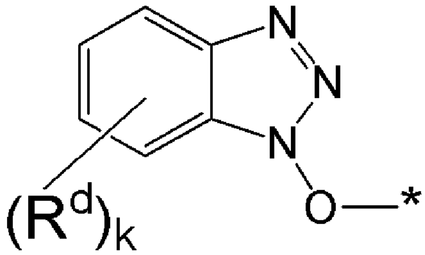

(4 − 1)

wherein $R^d$ represents a linear, branched, or cyclic alkyl group having 1 to 15 carbon atoms and optionally having a halogen atom, or an aryl group having 6 to 15 carbon atoms, "k" represents an integer of 0 to 4, and "*" represents a bond.

[9]: The negative-type photosensitive resin composition according to any one of [1] to [8], wherein the composition comprises the component (D) at 1 to 10 parts by mass relative to 100 parts by mass of the component (A).

[10]: The negative-type photosensitive resin composition according to any one of [1] to [9], further comprising, as (F) a thermal crosslinking agent, one or two or more crosslinking agents selected from: an amino condensate modified with formaldehyde or with formaldehyde and an alcohol; a phenol compound having two or more methylol groups or alkoxymethylol groups in average in one molecule; a compound in which hydrogen atoms of hydroxy groups in a polyhydric phenol are substituted with glycidyl groups; a compound in which hydrogen atoms of hydroxy groups in a polyhydric phenol or of hydroxy groups in a polyhydric alcohol are substituted with a substituent represented by the following formula (F-1); and a compound having two or more nitrogen atoms having a glycidyl group, represented by the following formula (F-2),

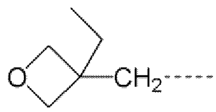

(F-1)

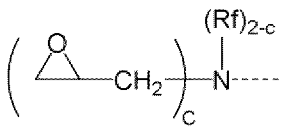

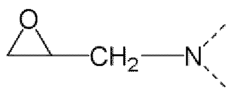

(F-2)

wherein a broken line represents an attachment point, Rf represents a linear, branched, or cyclic alkyl group having 1 to 6 carbon atoms, and "c" represents 1 or 2.

[11]: The negative-type photosensitive resin composition according to any one of [1] to [10], further comprising (G) an antioxidant.

[12]: The negative-type photosensitive resin composition according to any one of [1] to [11], further comprising (H) a silane compound.

[13]: The negative-type photosensitive resin composition according to any one of [1] to [12], further comprising (I) a polymerization inhibitor.

[14]: A patterning process, comprising:

(1) a step of applying the photosensitive resin composition according to any one of claims 1 to 13 on a substrate to form a photosensitive material coating; then
(2) after a heating treatment, a step of exposing the photosensitive material coating with high-energy ray having a wavelength of 190 to 500 nm or electron beam though a photomask; and
(3) after the irradiation, a step of performing development by using a developer of an organic solvent.

[15]: A method for forming a cured coating, the method comprising a step of heating and post-curing the patterned coating obtained by the patterning process according to [14] at a temperature of 100 to 300°C.
[16]: A n interlayer insulating film, comprising a cured coating formed by curing the negative-type photosensitive resin composition according to any one of [1] to [13].
[17]: A surface protecting film, comprising a cured coating formed by curing the negative-type photosensitive resin composition according to any one of [1] to [13].
[18]: An electronic component, comprising the interlayer insulating film according to [16].
[19]: An electronic component, comprising the surface protecting film according to [17].

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A negative-type photosensitive resin composition, comprising:

(A) a polymer compound comprising a polyimide precursor structure;
(C) a photopolymerization initiator;
(D) an organic compound represented by the following general formula (1); and
(E) a solvent,

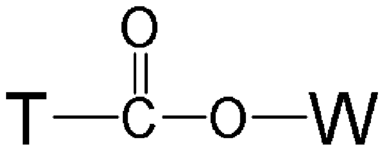

(1)

wherein T represents any one structure of the following general formulae (2) to (4), and W represents an alkyl group or an aryl group that are optionally substituted with an alkoxy group having 4 to 15 carbon atoms, preferably containing a tert-butyl group or a benzyl group,

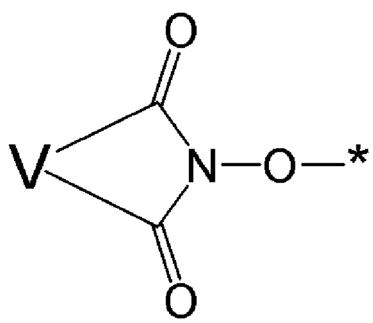

(2)

wherein V represents a divalent organic group, and "*" represents a bond,

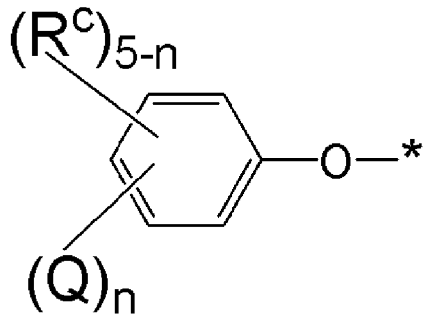

(3)

wherein Q represents a halogen atom or a nitro group, $R^C$ represents a hydrogen atom, a linear, branched, or cyclic alkyl group having 1 to 15 carbon atoms, or an aryl group having 6 to 15 carbon atoms, "n" represents an integer of 3 to 5 when Q represents the halogen atom or represents 1 when Q represents the nitro group, and "*" represents a bond,

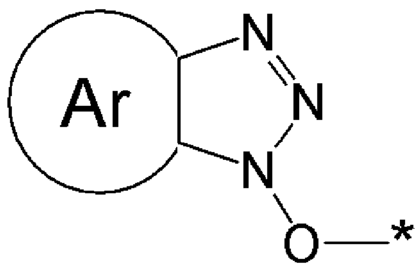

(4)

wherein Ar represents a substituted or unsubstituted aromatic cyclic structure or a heterocyclic structure having a heteroatom, and "*" represents a bond.

**2.** The negative-type photosensitive resin composition according to claim 1, wherein the component (A) is a polymer compound comprising a polyimide precursor structure represented by the following general formula (5),

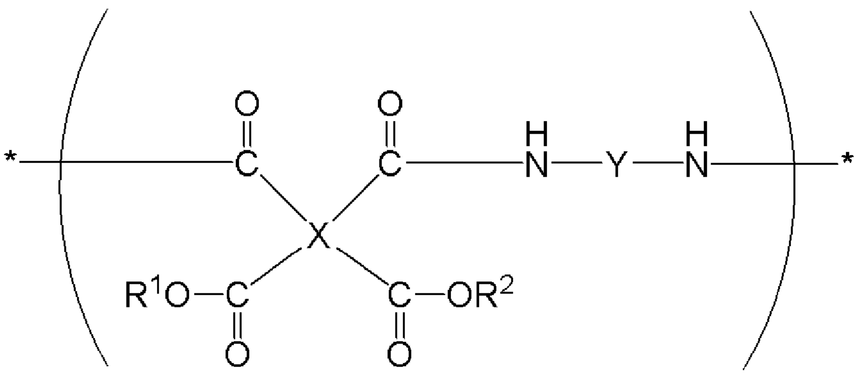

(5)

wherein X represents a tetravalent organic group, Y represents a divalent organic group, $R^1$ and $R^2$ each independently represent a hydrogen atom or a monovalent organic group, and at least one of $R^1$ and $R^2$ represents a group represented by the following general formula (6),

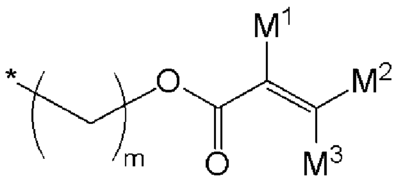

(6)

wherein $M^1$, $M^2$, and $M^3$ each independently represents a hydrogen atom or an organic group having 1 to 3 carbon

atoms, "m" represents an integer of 2 to 10, and "*" represents a bond.

**3.** The negative-type photosensitive resin composition according to claim 1 or 2, wherein the composition comprises (B) a polymerizable compound having two or more ethylenically unsaturated groups.

**4.** The negative-type photosensitive resin composition according to any one of claims 1 to 3, wherein the general formula (2) represents a structure represented by the following general formula (2-1),

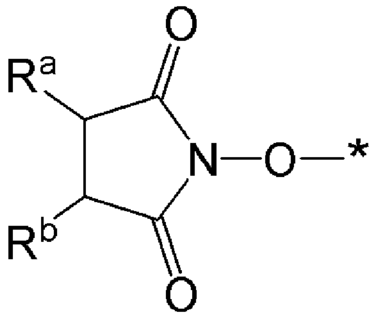

(2－1)

wherein $R^a$ and $R^b$ represent a hydrogen atom, a linear, branched, or cyclic alkyl group having 1 to 15 carbon atoms, or an aryl group having 6 to 15 carbon atoms, $R^a$ and $R^b$ are optionally bonded to each other to form a ring together with a carbon atom to which $R^a$ and $R^b$ are bonded, and "*" represents a bond.

**5.** The negative-type photosensitive resin composition according to any one of claims 1 to 3, wherein the general formula (3) represents a structure represented by the following formula (3-1) or (3-2),

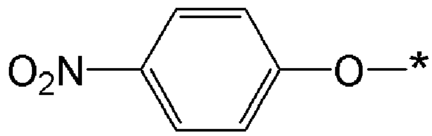

(3－1)

wherein "*" represents a bond,

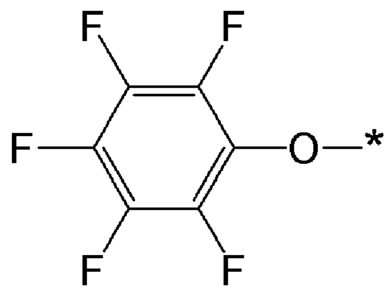

(3－2)

wherein "*" represents a bond.

**6.** The negative-type photosensitive resin composition according to any one of claims 1 to 3, wherein the general formula (4) represents a structure represented by the following general formula (4-1),

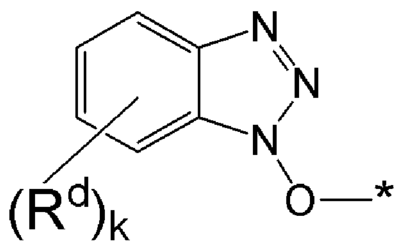

(4－1)

wherein $R^d$ represents a linear, branched, or cyclic alkyl group having 1 to 15 carbon atoms and optionally having a halogen atom, or an aryl group having 6 to 15 carbon atoms, "k" represents an integer of 0 to 4, and "*" represents a bond.

**7.** The negative-type photosensitive resin composition according to any one of claims 1 to 6, wherein the composition comprises the component (D) at 1 to 10 parts by mass relative to 100 parts by mass of the component (A).

**8.** The negative-type photosensitive resin composition according to any one of claims 1 to 7, further comprising, as (F) a thermal crosslinking agent, one or two or more crosslinking agents selected from: an amino condensate modified with formaldehyde or with formaldehyde and an alcohol; a phenol compound having two or more methylol groups or alkoxymethylol groups in average in one molecule; a compound in which hydrogen atoms of hydroxy groups in a polyhydric phenol are substituted with glycidyl groups; a compound in which hydrogen atoms of hydroxy groups in a polyhydric phenol or of hydroxy groups in a polyhydric alcohol are substituted with a substituent represented by the following formula (F-1); and a compound having two or more nitrogen atoms having a glycidyl group, represented by the following formula (F-2),

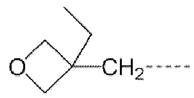

(F-1)

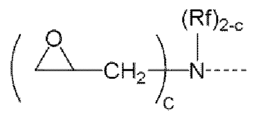

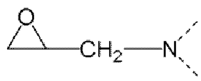

(F-2)

wherein a broken line represents an attachment point, Rf represents a linear, branched, or cyclic alkyl group having 1 to 6 carbon atoms, and "c" represents 1 or 2.

**9.** The negative-type photosensitive resin composition according to any one of claims 1 to 8, further comprising at least one or more components selected from the group of (G) an antioxidant, (H) a silane compound, and (I) a polymerization inhibitor.

**10.** A patterning process, comprising:

(1) a step of applying the photosensitive resin composition according to any one of claims 1 to 9 on a substrate to form a photosensitive material coating; then
(2) after a heating treatment, a step of exposing the photosensitive material coating with high-energy ray having a wavelength of 190 to 500 nm or electron beam though a photomask; and
(3) after the irradiation, a step of performing development by using a developer of an organic solvent.

**11.** A method for forming a cured coating, the method comprising a step of heating and post-curing the patterned coating obtained by the patterning process according to claim 10 at a temperature of 100 to 300°C.

**12.** An interlayer insulating film, comprising a cured coating formed by curing the negative-type photosensitive resin composition according to any one of claims 1 to 9.

**13.** A surface protecting film, comprising a cured coating formed by curing the negative-type photosensitive resin composition according to any one of claims 1 to 9.

**14.** An electronic component, comprising the interlayer insulating film according to claim 12, or
an electronic component, comprising the surface protecting film according to claim 13.

Europäisches Patentamt
European Patent Office
Office européen des brevets

# EUROPEAN SEARCH REPORT

Application Number
EP 25 17 4637

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | JP 2024 019341 A (ASAHI KASEI CORP) 8 February 2024 (2024-02-08) * claims 1, 2 * * paragraph [0036] * * paragraph [0039] * ----- | 1-14 | INV. G03F7/037 G03F7/038 |
| A,D | JP 7 252020 B2 (ASAHI KASEI CORP) 4 April 2023 (2023-04-04) * claim 1 * * paragraph [0052] * * paragraph [0055] * ----- | 1-14 | |
| A | Sigma-Aldrich: "Safety Data Sheet, Product Boc-OSu, Product number 20430", , 13 October 2022 (2022-10-13), pages 1-9, XP093283846, Sigma-Aldrich Website Retrieved from the Internet: URL:https://www.sigmaaldrich.com/DE/de/product/aldrich/20430 [retrieved on 2025-06-04] * section 9.1 d); page 5 * ----- | 1 | TECHNICAL FIELDS SEARCHED (IPC) G03F |
| A | JP 3 477077 B2 (TOSHIBA CORP) 10 December 2003 (2003-12-10) * paragraph [0298] - paragraph [0302]; examples IV-10 to IV-12; table 27 * * paragraph [0014] * * paragraph [0215] * * paragraph [0237] * ----- | 1-14 | |
| A | JP 2022 159241 A (ASAHI KASEI CORP) 17 October 2022 (2022-10-17) * claim 22 * * paragraph [0001] * * paragraph [0035] * ----- | 1-14 | |

The present search report has been drawn up for all claims

1

| Place of search | Date of completion of the search | Examiner |
|---|---|---|
| Munich | 18 June 2025 | Hönes, Roland |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 25 17 4637

This annex lists the patent family members relating to the patent documents cited in the above-mentioned European search report. The members are as contained in the European Patent Office EDP file on
The European Patent Office is in no way liable for these particulars which are merely given for the purpose of information.

18-06-2025

| Patent document cited in search report | Publication date | Patent family member(s) | Publication date |
|---|---|---|---|
| JP 2024019341 A | 08-02-2024 | JP 7407518 B2 | 04-01-2024 |
| | | JP 7674451 B2 | 09-05-2025 |
| | | JP 2020091464 A | 11-06-2020 |
| | | JP 2023171788 A | 05-12-2023 |
| | | JP 2024019341 A | 08-02-2024 |
| | | TW 201945439 A | 01-12-2019 |
| | | TW 202334283 A | 01-09-2023 |
| JP 7252020 B2 | 04-04-2023 | JP 7252020 B2 | 04-04-2023 |
| | | JP 7542102 B2 | 29-08-2024 |
| | | JP 2019185031 A | 24-10-2019 |
| | | JP 2023068131 A | 16-05-2023 |
| | | KR 20190120710 A | 24-10-2019 |
| | | TW 201944175 A | 16-11-2019 |
| | | TW 202117446 A | 01-05-2021 |
| JP 3477077 B2 | 10-12-2003 | JP 3477077 B2 | 10-12-2003 |
| | | JP H1172918 A | 16-03-1999 |
| | | US 6183934 B1 | 06-02-2001 |
| JP 2022159241 A | 17-10-2022 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 49115541 A
- JP 55045746 A
- JP 2007056196 A
- JP 7436606 B
- JP 2022159241 A
- JP 2024019341 A
- JP 7252020 B
- WO 2017188153 A1
- WO 2015199219 A1
- JP 2014191002 A
- WO 2011080992 A1
- JP 2014191252 A
- JP 2014041264 A
- WO 2014097594 A1
- JP 2011128358 A
- JP 6414060 B
- WO 2016140024 A1
- JP 5987984 B
- JP 2017044964 A
- JP 2013001571 A
- JP 2009283711 A
- JP 2011059656 A
- JP 2012194520 A